# EUROPEAN PATENT APPLICATION

(11) **EP 4 836 629 A1**
(43) Date of publication of application: **04.11.2026**
(21) Application number: 24912618.6
(22) Date of filing: 19.12.2024
(51) Int. Cl.: H10D 30/66, H10D 12/00, H10D 62/10

(54) **SEMICONDUCTOR DEVICE**

(30) Priority: 28.12.2023 JP 2023223601
(71) Applicant: Rohm Co., Ltd., Kyoto-shi, Kyoto 615-8585 (JP)
(72) Inventor: TANIMOTO, Yuta, Kyoto-shi, Kyoto 615-8585 (JP); NAKANO, Yuki, Kyoto-shi, Kyoto 615-8585 (JP); MORI, Seigo, Kyoto-shi, Kyoto 615-8585 (JP)
(74) Representative: Witte, Weller & Partner Patentanwälte mbB
(86) International application number: PCT/JP2024/044988
(87) International publication number: WO 2025/142729

(57) **Abstract**

A semiconductor device includes a chip, a plurality of first conductive structures formed of a first conductive material, an insulating layer formed on the first principal surface such as to cover the first conductive structure, a pad formed on the insulating layer, a second conductive structure having a first portion extending in a first direction along the first conductive structure toward a first end surface of the chip and a second portion extending from the first portion in a second direction along the first end surface and having a terminal portion at a corner portion of the chip, and constituted of a metal wiring, and a peripheral wiring structure formed on the first principal surface such as to be covered with the insulating layer, extending from the terminal portion of the second portion of the second conductive structure along a second end surface intersecting the first end surface, and electrically connected to the first conductive structure.

## Description

### Related Application

This application corresponds to Japanese Patent Application No. 2023-223601 filed on December 28, 2023 with the Japan Patent Office, the entire disclosure of which is incorporated herein by reference.

### Technical Field

The present disclosure relates to a semiconductor device.

### Background Art

Patent Literature 1 discloses a semiconductor device including a semiconductor substrate, a plurality of trench structures, and a gate pad portion. The plurality of trench structures are formed on the surface of the semiconductor substrate. The gate pad portion is disposed on the semiconductor substrate such as to cover the plurality of trench structures.

### Citation List

### Patent Literature

Patent Literature 1: United States Patent Application Publication No. 2017/0040423

### [Summary]

A preferred embodiment of the present disclosure provides a semiconductor device capable of reducing loss by effectively utilizing an element region.

A preferred embodiment of the present disclosure provides a semiconductor device including a chip of a quadrangular shape in plan view and having a first principal surface in which an element region is formed, a plurality of first conductive structures extending in a stripe shape in a first direction in the element region and formed of a first conductive material, an insulating layer formed on the first principal surface such as to cover the first conductive structures, a pad formed on the insulating layer, a second conductive structure formed on the insulating layer such as to be electrically connected to the pad, having a first portion extending in the first direction along the first conductive structures toward a first end surface of the chip and a second portion extending from the first portion along the first end surface in a second direction intersecting the first direction and having a terminal portion at a corner portion of the chip, and constituted of a metal wiring, and a peripheral wiring structure formed on the first principal surface such as to be covered with the insulating layer, extending from the terminal portion of the second portion of the second conductive structure along a second end surface intersecting the first end surface, and electrically connected to the first conductive structures.

### Brief Description of Drawings

[FIG. 1] FIG. 1 is a plan view showing a semiconductor device according to a preferred embodiment of the present disclosure.
[FIG. 2] FIG. 2 is a sectional view taken along line II-II shown in FIG. 1.
[FIG. 3] FIG. 3 is a plan view showing a layout of a gate pad, a gate wiring, a source pad, and a source wiring.
[FIG. 4] FIG. 4 is a plan view showing a layout of a polysilicon wiring layer.
[FIG. 5] FIG. 5 is a plan view showing a layout of a chip.
[FIG. 6] FIG. 6 is an enlarged view of a portion surrounded by an alternate long and short dashed line VI of FIG. 5.
[FIG. 7] FIG. 7 is a sectional view taken along line VII-VII shown in FIG. 6.
[FIG. 8] FIG. 8 is a sectional view taken along line VIII-VIII shown in FIG. 6.
[FIG. 9] FIG. 9 is an enlarged view of a portion surrounded by an alternate long and short dashed line IX of FIG. 7.
[FIG. 10] FIG. 10 is an enlarged view of a portion surrounded by an alternate long and short dashed line X of FIG. 8.
[FIG. 11] FIG. 11 is an enlarged view of a portion surrounded by an alternate long and short dashed line XI of FIG. 5.
[FIG. 12] FIG. 12 is an enlarged view of a portion surrounded by an alternate long and short dashed line XII of FIG. 11.
[FIG. 13A] FIG. 13A is an enlarged view of a portion surrounded by an alternate long and short dashed line XIIIA of FIG. 12.
[FIG. 13B] FIG. 13B is a plan view for describing a first dummy structure according to a second configuration example, and is a view corresponding to FIG. 13A.
[FIG. 13C] FIG. 13C is a plan view for describing the first dummy structure according to a third configuration example and is a view corresponding to FIG. 13B.
[FIG. 13D] FIG. 13D is a plan view for describing the first dummy structure according to a fourth configuration example and is a view corresponding to FIG. 13B.
[FIG. 14] FIG. 14 is a sectional view taken along line XIV-XIV shown in FIG. 13A.
[FIG. 15] FIG. 15 is a sectional view taken along line XV-XV shown in FIG. 13A.
[FIG. 16A] FIG. 16A is a sectional view taken along line XVIA-XVIA shown in FIG. 13A.
[FIG. 16B] FIG. 16B is a sectional view taken along line XVIB-XVIB shown in FIG. 13A.
[FIG. 17] FIG. 17 is a sectional view taken along line XVII-XVII shown in FIG. 13A.
[FIG. 18] FIG. 18 is a sectional view taken along line XVIII-XVIII shown in FIG. 13A.
[FIG. 19] FIG. 19 is a sectional view taken along line XIX-XIX shown in FIG. 13A.
[FIG. 20] FIG. 20 is an enlarged view of a portion surrounded by an alternate long and short dashed line XX of FIG. 15.
[FIG. 21] FIG. 21 is an enlarged view of a portion surrounded by an alternate long and short dashed line XXI of FIG. 18.
[FIG. 22A] FIG. 22A is a view for describing a part of a manufacturing process of the semiconductor device, and shows a cross section corresponding to a portion surrounded by an alternate long and short dashed line XXII of FIG. 20.
[FIG. 22B] FIG. 22B is a view showing a step subsequent to FIG. 22A.
[FIG. 22C] FIG. 22C is a view showing a step subsequent to FIG. 22B.
[FIG. 23] FIG. 23 is a sectional view taken along line XXIII-XXIII shown in FIG. 11.
[FIG. 24] FIG. 24 is an enlarged view of a portion surrounded by an alternate long and short dashed line XXIV of FIG. 23.
[FIG. 25] FIG. 25 is a sectional view taken along line XXV-XXV shown in FIG. 12.
[FIG. 26] FIG. 26 is an enlarged view of a portion surrounded by an alternate long and short dashed line XXVI of FIG. 23.
[FIG. 27] FIG. 27 is an enlarged view of a portion surrounded by an alternate long and short dashed line XXVII of FIG. 4.
[FIG. 28] FIG. 28 is an enlarged view of a portion surrounded by an alternate long and short dashed line XXVIII of FIG. 27.
[FIG. 29] FIG. 29 is a sectional view taken along line XXIX-XXIX shown in FIG. 28.
[FIG. 30] FIG. 30 is a sectional view taken along line XXX-XXX shown in FIG. 28.
[FIG. 31] FIG. 31 is an enlarged view of a portion surrounded by an alternate long and short dashed line XXXI of FIG. 27.
[FIG. 32] FIG. 32 is an enlarged view of a portion surrounded by an alternate long and short dashed line XXXII of FIG. 5.
[FIG. 33] FIG. 33 is an enlarged view of a portion surrounded by an alternate long and short dashed line XXXIII-XXXIII of FIG. 32.
[FIG. 34] FIG. 34 is an enlarged view of a portion surrounded by an alternate long and short dashed line XXXIV of FIG. 4.
[FIG. 35] FIG. 35 is an enlarged view of a portion surrounded by an alternate long and short dashed line XXXV of FIG. 34.
[FIG. 36] FIG. 36 is a sectional view taken along line XXXVI-XXXVI shown in FIG. 35.
[FIG. 37] FIG. 37 is a sectional view taken along line XXXVII-XXXVII shown in FIG. 35.
[FIG. 38] FIG. 38 is a sectional view taken along line XXXVIII-XXXVIII shown in FIG. 35.
[FIG. 39A] FIG. 39A is a plan view of a second configuration example of a connection structure portion, and is a view corresponding to FIG. 35.
[FIG. 39B] FIG. 39B is a plan view of a third configuration example of the connection structure portion and is a view corresponding to FIG. 35.
[FIG. 40] FIG. 40 is an enlarged view of a portion surrounded by an alternate long and short dashed line XL of FIG. 4.
[FIG. 41] FIG. 41 is an enlarged view of a portion surrounded by an alternate long and short dashed line XLI of FIG. 4.
[FIG. 42] FIG. 42 is an enlarged view of a portion surrounded by an alternate long and short dashed line XLII of FIG. 4.
[FIG. 43] FIG. 43 is a plan view for describing a disposition example of a plurality of connection wiring structures according to the second configuration example, and is a view corresponding to FIG. 40.
[FIG. 44] FIG. 44 is a plan view for describing a disposition example of a plurality of connection wiring structures according to the second configuration example, and is a view corresponding to FIG. 42.
[FIG. 45] FIG. 45 is a plan view for describing a disposition example of a plurality of connection wiring structures according to the third configuration example, and is a view corresponding to FIG. 40.
[FIG. 46] FIG. 46 is a plan view for describing a disposition example of a plurality of connection wiring structures according to the third configuration example, and is a view corresponding to FIG. 42.
[FIG. 47] FIG. 47 is a diagram for describing a first modification example of a semiconductor device.
[FIG. 48] FIG. 48 is a diagram for describing a second modification example of the semiconductor device.
[FIG. 49] FIG. 49 is a diagram for describing a third modification example of the semiconductor device.
[FIG. 50] FIG. 50 is a plan view showing another preferred embodiment of the semiconductor device and corresponding to FIG. 12.
[FIG. 51] FIG. 51 is a sectional view showing another preferred embodiment of the semiconductor device and corresponding to FIG. 2.
[FIG. 52] FIG. 52 is a sectional view showing another preferred embodiment of the semiconductor device and corresponding to FIG. 7.
[FIG. 53] FIG. 53 is a sectional view showing another preferred embodiment of the semiconductor device and corresponding to FIG. 2.
[FIG. 54] FIG. 54 is a plan view showing another preferred embodiment of the semiconductor device and corresponding to a portion surrounded by an alternate long and short dashed line LIV of FIG. 12.
[FIG. 55] FIG. 55 is a sectional view showing another preferred embodiment of the semiconductor device and taken along line LV-LV of FIG. 54.

### [Detailed Description]

Next, preferred embodiments of the present disclosure shall be described in detail with reference to the attached drawings.

The attached drawings are all schematic views and are not strictly illustrated, and scales, proportions, angles and the like thereof do not always match. Identical reference signs are given to corresponding structures among the attached drawings, and duplicate descriptions thereof shall be omitted or simplified. For the structures whose description have been omitted or simplified, the description given before the omission or simplification shall apply.

When the wording "substantially equal" is used in this description, the wording includes a numerical value (shape) substantially equal to a numerical value (shape) of a comparison target and also includes numerical errors (shape errors) in a range of ±10% on a basis of the numerical value (shape) of the comparison target. Although the wordings "first," "second," "third," etc., are used in the following description, these are symbols attached to names of respective structures in order to clarify the order of description and are not attached with an intention of restricting the names of the respective structures.

In the following description, a conductivity type of a semiconductor (an impurity) is indicated using "p-type" or "n-type" and the "n-type" may be referred to as a "first conductivity type" and the "p-type" may be referred to as a "second conductivity type." As a matter of course, the "p-type" may be referred to as the "first conductivity type" and the "n-type" may be referred to as the "second conductivity type" instead. The "n-type" is a conductivity type due to a pentavalent element, and the "p-type" is a conductivity type due to a trivalent element. Unless noted in particular otherwise, the trivalent element is at least one type among boron, aluminum, gallium, and indium. Unless noted in particular otherwise, the pentavalent element is at least one type among nitrogen, phosphorus, arsenic, antimony, and bismuth.

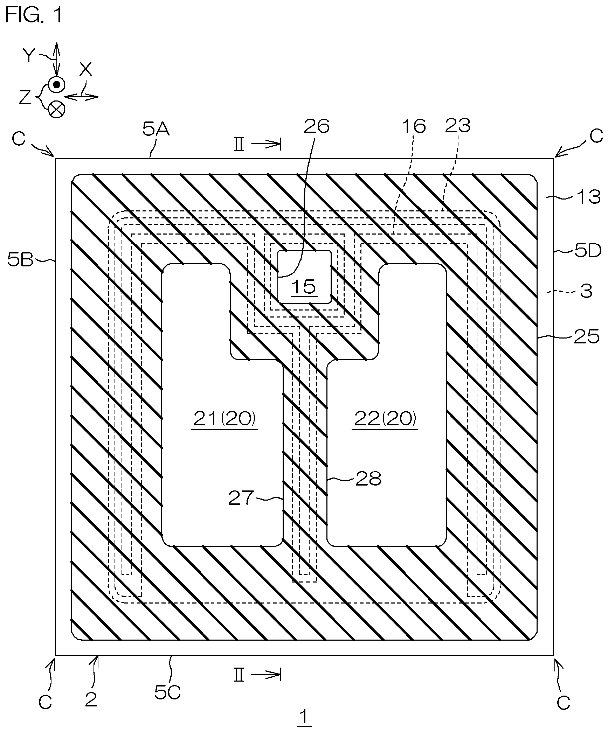

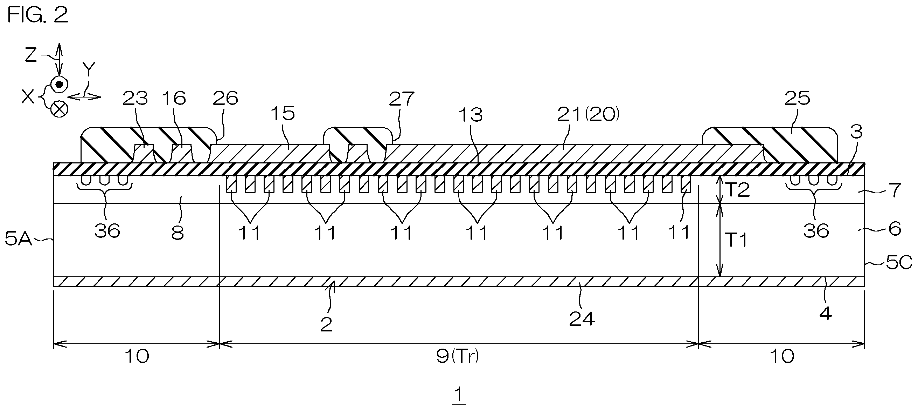

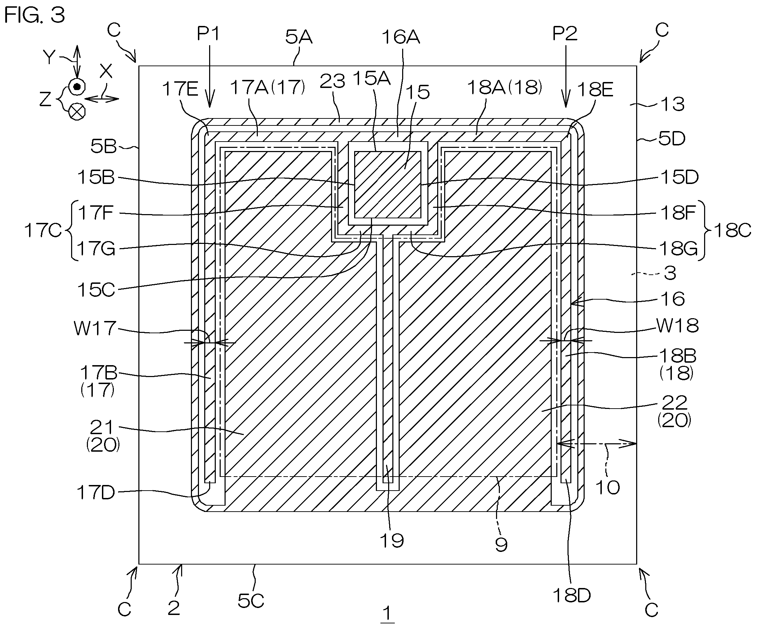

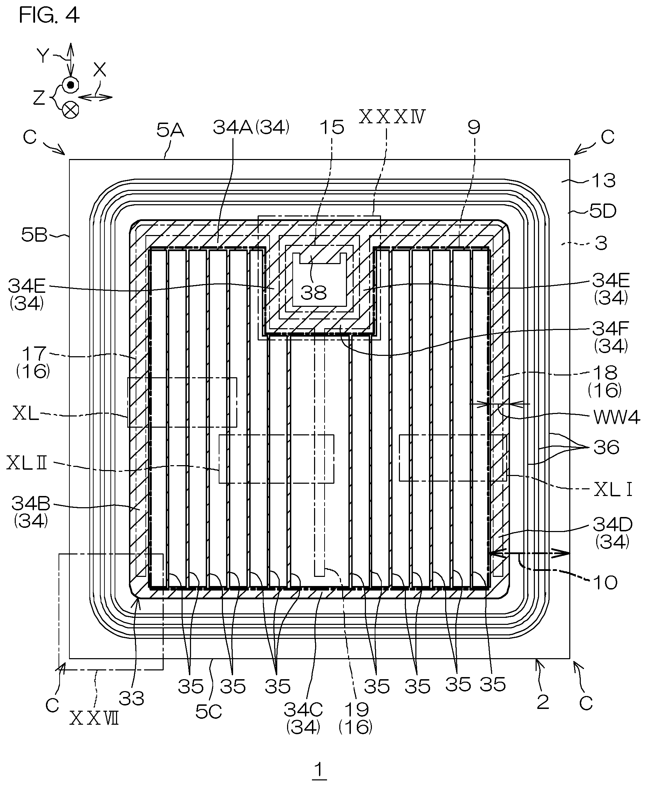

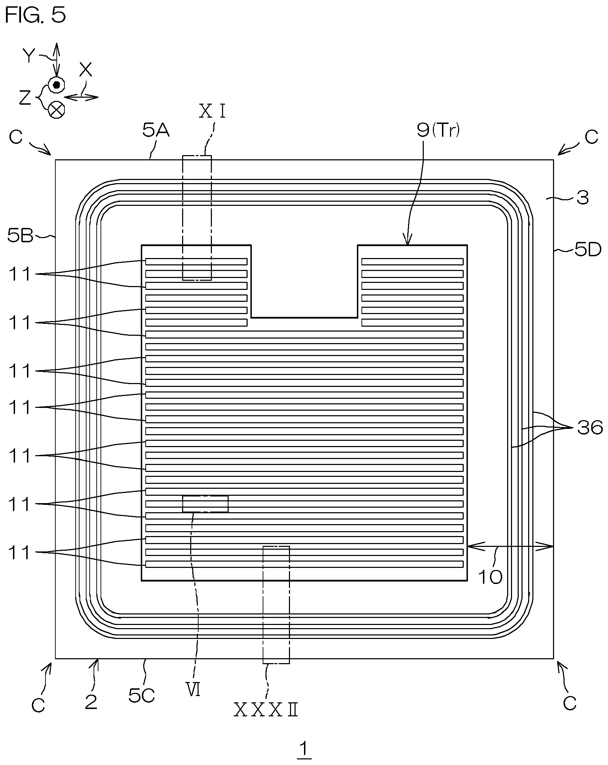

FIG. 1 is a plan view showing a semiconductor device 1 according to a preferred embodiment of the present disclosure. FIG. 2 is a sectional view taken along line II-II shown in FIG. 1. FIG. 3 is a plan view showing a layout of a gate pad 15, a gate wiring 16, a source pad 20, and a source wiring 23. FIG. 4 is a plan view showing a layout of a polysilicon wiring layer 33. FIG. 5 is a plan view showing a layout of a chip 2. The semiconductor device 1 is a semiconductor switching device having a transistor structure Tr of an insulated gate type as an example of a device structure.

Referring to FIG. 1 to FIG. 5, the semiconductor device 1 includes the chip 2 including an SiC monocrystal. The chip 2 may be referred to as an "SiC chip" or a "semiconductor chip." In this embodiment, the chip 2 is constituted of the SiC monocrystal, which is a hexagonal crystal, and is formed in a rectangular parallelepiped shape. The SiC monocrystal that is a hexagonal crystal has multiple polytypes including a 2H (hexagonal)-SiC monocrystal, a 4H-SiC monocrystal, a 6H-SiC monocrystal, etc. In this embodiment, an example in which the chip 2 is constituted of the 4H-SiC monocrystal is to be given, but the chip 2 may be constituted of another polytype instead.

The chip 2 has a first principal surface 3 at one side, a second principal surface 4 at another side, and first to fourth side surfaces 5A to 5D that connect the first principal surface 3 and the second principal surface 4. In a plan view as viewed from a vertical direction Z (hereinafter referred to simply as "plan view"), the first principal surface 3 and the second principal surface 4 are formed in quadrangle shapes. The vertical direction Z is also a thickness direction of the chip 2 and a normal direction to the first principal surface 3 (the second principal surface 4). The first principal surface 3 and the second principal surface 4 may be formed in a square shape or a rectangular shape in plan view.

The first principal surface 3 and the second principal surface 4 are preferably formed by c-planes of the SiC monocrystal. In this case, preferably, the first principal surface 3 is formed by a silicon plane (a (0001) plane) of the SiC monocrystal and the second principal surface 4 is formed by a carbon plane (a (000-1) plane) of the SiC monocrystal. The first principal surface 3 and the second principal surface 4 may have an off angle inclined at a predetermined angle in a predetermined off direction with respect to the c-plane. The off direction is preferably the a-axis direction (the [11-20] direction) of the SiC monocrystal. The off angle may exceed 0° but be not more than 10°. The off angle is preferably not more than 5°.

In a circumferential direction (counterclockwise in FIG. 1) of the chip 2 with the first side surface 5A as a starting point, the second side surface (end surface, first end surface) 5B is connected to the first side surface 5A, the third side surface (second end surface) 5C is connected to the second side surface 5B, and the fourth side surface (end surface, first end surface) 5D is connected to the first side surface 5A and the third side surface 5C. The first side surface 5A and the third side surface 5C extend in a first direction X oriented along the first principal surface 3 and are opposed in a second direction Y intersecting (specifically, orthogonal to) the first direction X. The second side surface 5B and the fourth side surface 5D extend in the second direction Y and are opposed in the first direction X.

In this embodiment, the first direction X is an a-axis direction (a [11-20] direction) of the SiC monocrystal and the second direction Y is an m-axis direction (a [1-100] direction) of the SiC monocrystal. As a matter of course, the first direction X may be the m-axis direction of the SiC monocrystal and the second direction Y may be the a-axis direction of the SiC monocrystal instead.

An XY plane that includes the first direction X and the second direction Y forms a horizontal plane that is orthogonal to the vertical direction Z. In the following, the first direction X and the second direction Y is expressed at times as "horizontal directions." Horizontal directions are also directions that extend along the first principal surface 3.

The first to fourth side surfaces 5A to 5D may each have a length of not less than 0.5 mm and not more than 20 mm in plan view. Lengths of the first to fourth side surfaces 5A to 5D may have a value belonging to any one range among not less than 0.5 mm and not more than 1 mm, not less than 1. mm and not more than 2 mm, not less than 2 mm and not more than 5 mm, not less than 5 mm and not more than 10 mm, not less than 10 mm and not more than 15 mm, and not less than 15 mm and not more than 20 mm. The lengths of the first to fourth side surfaces 5A to 5D may be not less than 5 mm.

Referring to FIG. 2, the chip 2 includes a base layer 6 of an n-type constituted of the SiC monocrystal. The base layer 6 may be referred to as a "drain region," a "base SiC layer," a "base region," etc. The base layer 6 extends in a layered shape in the horizontal directions and forms the second principal surface 4 and portions of the first to fourth side surfaces 5A to 5D. In this embodiment, the base layer 6 is constituted of a substrate made of the SiC monocrystal (in other words, an SiC substrate). The base layer 6 has the off direction and the off angle described above.

The base layer 6 may have an n-type impurity concentration of not less than 1×10¹⁸ cm⁻³ and not more than 1×10²¹ cm⁻³ as a peak value. The base layer 6 preferably has a substantially constant n-type impurity concentration in the thickness direction. The n-type impurity concentration of the base layer 6 is preferably adjusted by a single type of pentavalent element. The n-type impurity concentration of the base layer 6 is particularly preferably adjusted by a pentavalent element other than phosphorus. The n-type impurity concentration of the base layer 6 is adjusted by nitrogen in this embodiment.

The base layer 6 has a thickness T1. The thickness T1 may be not less than 5 µm and not more than 300 µm. The thickness T1 is preferably not less than 50 µm and not more than 250 µm.

Referring to FIG. 2, the chip 2 includes a semiconductor layer 7 made of the SiC monocrystal laminated on the base layer 6. The semiconductor layer 7 as an example of a first impurity region may be referred to as a "drift region," an "SiC layer," a "semiconductor region," etc. The semiconductor layer 7 extends in a layer shape in the horizontal direction and forms portions of the first principal surface 3 and the first to fourth side surfaces 5A to 5D. The semiconductor layer 7 is constituted of an epitaxial layer (that is, an SiC epitaxial layer) crystalgrown with the base layer 6 as a starting point.

The semiconductor layer 7 has a lower end and an upper end. The lower end of the semiconductor layer 7 is a crystal growth starting point and the upper end of the semiconductor layer 7 is a crystal growth end point. The lower end of the semiconductor layer 7 is also a bottom portion of the semiconductor layer 7. Since the semiconductor layer 7 is continuously crystalgrown from the base layer 6, the lower end of the semiconductor layer 7 coincides with the upper end of the base layer 6.

A boundary portion between the base layer 6 and the semiconductor layer 7 is not necessarily visually recognizable, and can be indirectly evaluated and/or determined from other components and elements. The semiconductor layer 7 has an off direction and an off angle that substantially coincide with the off direction and the off angle of the base layer 6.

The semiconductor layer 7 includes a drift region 8 of the n-type. In this embodiment, the drift region 8 is formed by a portion (n-type portion) of the semiconductor layer 7.

The semiconductor layer 7 has a thickness T2 less than the thickness T1. The thickness T2 may be not less than 1 µm and not more than 10 µm. The thickness T2 is preferably not less than 2 µm and not more than 8 µm.

Referring to FIG. 5, the semiconductor device 1 includes an active region 9 set in the chip 2. The active region 9 is a region (element region) that includes a device structure (that is, the transistor structure Tr) and in which an output current (drain current) is generated. The active region 9 is set in an inner portion of the chip 2 at an interval from the peripheral edge (the first to fourth side surfaces 5A to 5D) of the chip 2 in plan view. The active region 9 is formed in a polygonal shape having sides parallel to the peripheral edge of the chip 2 in plan view.

In this embodiment, the active region 9 is formed in a polygonal shape having a recess portion recessed along the gate pad 15 which will be described later in plan view. The active region 9 may be formed in a quadrangular shape in plan view in the source pad 20. A planar area of the active region 9 is preferably not less than 50% and not more than 90% of a planar area of the first principal surface 3.

Referring to FIG. 5, the semiconductor device 1 includes an outer peripheral region 10 set outside the active region 9 in the chip 2. The outer peripheral region 10 is provided in a region between the peripheral edge of the chip 2 and the active region 9 in plan view. The outer peripheral region 10 extends in a band shape along the active region 9 in plan view, and is set in a polygonal annular shape (in this embodiment, a substantially quadrilateral annular shape) surrounding the active region 9.

Referring to FIG. 2, in the outer peripheral region 10, the first principal surface 3 has a flat surface extending in the first direction X and the second direction Y. The first principal surface 3 of the outer peripheral region 10 is formed substantially parallel to the first principal surface 3 of the active region 9. The first principal surface 3 of the outer peripheral region 10 is continuous to the first to fourth side surfaces 5A to 5D.

Referring to FIG. 5, the semiconductor device 1 includes a plurality of trench gate structures 11 of a trench electrode type as an example of a first conductive structure and a first trench structure. The trench gate structure 11 is formed in the first principal surface 3 in the active region 9. The trench gate structure 11 may be referred to as a "gate structure," a "trench structure," etc. A gate potential from the gate pad 15 which will be described later is to be applied to the plurality of trench gate structures 11 as a control potential.

The plurality of trench gate structures 11 are disposed at intervals inward from the periphery of the active region 9. In this embodiment, the plurality of trench gate structures 11 are arrayed at intervals in the second direction Y (m-axis direction) and formed in a band shape extending in the first direction X (a-axis direction). That is, in this embodiment, the plurality of trench gate structures 11 are arrayed in a stripe shape extending in the a-axis direction (the first direction X). The extension direction of the plurality of trench gate structures 11 coincides with the off-direction of the semiconductor layer 7. Referring to FIG. 2, the plurality of trench gate structures 11 are formed at intervals toward the first principal surface 3 side from the lower end (the base layer 6) of the semiconductor layer 7, and face the base layer 6 with a portion of the semiconductor layer 7 interposed therebetween.

Referring to FIG. 2, the semiconductor device 1 includes an insulating layer 13 covering the first principal surface 3. The insulating layer 13 collectively covers the active region 9 and the outer peripheral region 10. The insulating layer 13 covers the trench gate structures 11 in the active region 9. The insulating layer 13 may be referred to as an "interlayer insulating film," an "insulating film," an "interlayer film," an "intermediate insulating film," etc. The insulating layer 13 may include at least one among a silicon oxide film, a silicon nitride film, and a silicon oxynitride film. In this embodiment, the insulating layer 13 includes a silicon oxide film.

Referring to FIG. 2 and FIG. 3, the semiconductor device 1 includes the gate pad 15 as an example of a pad disposed on the insulating layer 13. The gate pad 15 is an electrode to which the gate potential is to be applied from the exterior. The gate pad 15 may be referred to as a "pad," a "gate pad electrode," a "first pad electrode," etc.

In this embodiment, the gate pad 15 is disposed on the outer peripheral region 10. Specifically, the gate pad 15 is disposed in a region adjacent to a central portion of one side (in this embodiment, the first side surface 5A) of the first principal surface 3 in plan view.

As a matter of course, the gate pad 15 may be disposed in a region along any of the central portions of the first to fourth side surfaces 5A to 5D. The gate pad 15 may be disposed at an arbitrary corner of the first principal surface 3 in plan view. The gate pad 15 may be disposed at a central portion of the first principal surface 3 in plan view. The gate pad 15 may be disposed on the active region 9.

Referring to FIG. 3, in this embodiment, the gate pad 15 is formed in a quadrangular shape in plan view. The gate pad 15 includes a first peripheral edge 15A on the first side surface 5A side, a second peripheral edge 15B on the second side surface 5B side, a third peripheral edge 15C on the third side surface 5C side, and a fourth peripheral edge 15D on the fourth side surface 5D side. The first peripheral edge 15A and the third peripheral edge 15C extend in the first direction X and are opposed in the second direction Y. The second peripheral edge 15B and the fourth peripheral edge 15D extend in the second direction Y and are opposed in the first direction X.

The gate pad 15 may be referred to as a "gate metal." The gate pad 15 may be referred to as a "wiring," a "wiring electrode," a "gate finger," a "gate finger electrode," etc. The gate pad 15 is a metal pad, and in this embodiment, the gate pad 15 is formed of a metal material containing Al (aluminum).

Specifically, the gate pad 15 may include at least one among a pure Al film (Al film having a purity of not less than 99%), an AlCu alloy film, an AlSi alloy film, and an AlSiCu alloy film. The gate pad 15 may be a metal film other than the Al-based metal film. Specifically, the gate pad 15 may include at least one type among a Ti film, a TiN film, a W film, a Cu film, a Cu alloy film, and a conductive polysilicon film.

Referring to FIG. 3, the semiconductor device 1 includes at least one (in this embodiment, a plurality) of the gate wirings 16 electrically connected to the gate pad 15. The gate wiring 16 is an example of a second conductive structure and a metal wiring. The gate wiring 16 is selectively routed in the outer peripheral region 10 such as to transmit the gate potential applied to the gate pad 15 to the plurality of trench gate structures 11. In this embodiment, the plurality of gate wirings 16 include a first gate wiring 17, a second gate wiring 18, a third gate wiring 19, and a connection wiring 16A.

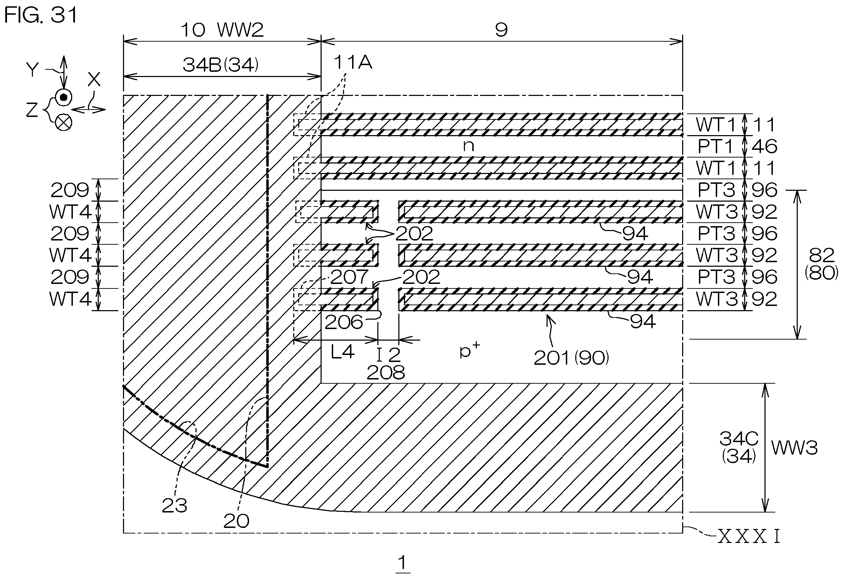

Referring to FIG. 3, in this embodiment, the first gate wiring 17 is disposed on the second side surface 5B side with respect to the gate pad 15, and extends in a line shape along the peripheral edge of the first principal surface 3 such as to intersect (specifically, orthogonal to) a portion (specifically, a terminal portion 11A (FIG. 31, etc.)) of the plurality of trench gate structures 11 (FIG. 5).

Specifically, the first gate wiring 17 includes a first portion 17A, a second portion 17B, and a connection portion 17C. The first portion 17A extends from the gate pad 15 along the first side surface 5A toward the second side surface 5B.

Referring to FIG. 3, in the outer peripheral region 10, the first portion 17A is electrically connected to the gate pad 15 via a connection wiring 16A and a resistive wiring structure 38 (FIG. 4) which will be described later. The first portion 17A of the first gate wiring 17 may have a configuration of being led out from the gate pad 15 toward the second side surface 5B, not a configuration of being electrically connected to the gate pad 15 via the resistive wiring structure 38 (FIG. 4).

Referring to FIG. 3, the second portion 17B extends from an end portion 17E at a first outer edge position (first position) P1 in the first portion 17A toward the third side surface 5C along the second side surface 5B. The second portion 17B of the first gate wiring 17 is electrically connected to the plurality of trench gate structures 11 via a second structure 34B (FIG. 4) of a peripheral wiring structure 34 (FIG. 4) which will be described later.

The second portion 17B has a terminal portion 17D at a corner portion C of the chip 2 on the third side surface 5C side. Therefore, in this embodiment, the first gate wiring 17 does not have a portion extending along the third side surface 5C. In other words, in this embodiment, the first gate wiring 17 is not disposed in a region between the active region 9 and the third side surface 5C.

Referring to FIG. 3, the connection portion 17C extends from the base end portion of the first portion 17A along the peripheral edge of the gate pad 15, and connects the first portion 17A and the third gate wiring 19. The connection portion 17C includes a band-shaped portion 17F and a second band-shaped portion 17G. The band-shaped portion 17F extends along the second peripheral edge 15B of the gate pad 15 from the base end portion of the first portion 17A toward the third side surface 5C. The second band-shaped portion 17G extends along the third peripheral edge 15C of the gate pad 15 from a terminal portion of the band-shaped portion 17F toward the fourth side surface 5D, and connects the band-shaped portion 17F and the third gate wiring 19.

In this embodiment, the first portion 17A, the second portion 17B, and the connection portion 17C have the width equivalent to each other. As a matter of course, the first portion 17A may have a different width from at least one of either of the second portion 17B and the connection portion 17C. The second portion 17B may have a width different from that of the connection portion 17C.

In this embodiment, the second portion 17B is longer than the first portion 17A. The second portion 17B may be shorter than the first portion 17A or may have a length equivalent to the first portion 17A.

In this embodiment, the connection portion 17C is shorter than the first portion 17A. The connection portion 17C may be shorter than the first portion 17A or may have a length equivalent to the first portion 17A.

Referring to FIG. 3, in this embodiment, the second gate wiring 18 is disposed on the fourth side surface 5D side with respect to the gate pad 15, and extends in a line shape along the peripheral edge of the first principal surface 3 such as to intersect (specifically, orthogonal to) a portion (specifically, the terminal portion 11A) of the plurality of trench gate structures 11 (FIG. 5).

Specifically, the second gate wiring 18 includes a first portion 18A, a second portion 18B, and a connection portion 18C. The first portion 18A extends from the gate pad 15 along the first side surface 5A toward the fourth side surface 5D.

Referring to FIG. 3, in the outer peripheral region 10, the first portion 18A is electrically connected to the gate pad 15 via the connection wiring 16A and the resistive wiring structure 38 (FIG. 4) which will be described later. The first portion 18A of the second gate wiring 18 may have a configuration of being led out from the gate pad 15 toward the fourth side surface 5D, not a configuration of being electrically connected to the gate pad 15 via the resistive wiring structure 38 (FIG. 4), but may be configured to be.

Referring to FIG. 3, the second portion 18B extends from a terminal portion 18E at a second outer edge position (first position) P2 of the first portion 18A toward the third side surface 5C along the fourth side surface 5D. The second portion 18B of the second gate wiring 18 is electrically connected to the plurality of trench gate structures 11 via a fourth structure 34D (FIG. 4) of the peripheral wiring structure 34 (FIG. 4) which will be described later.

The second portion 18B has a terminal portion 18D at a corner portion C of the chip 2 on the third side surface 5C side. Therefore, in this embodiment, the second gate wiring 18 does not have a portion extending along the third side surface 5C. In other words, in this embodiment, the second gate wiring 18 is not disposed in the region between the active region 9 and the third side surface 5C.

Referring to FIG. 3, the connection portion 18C extends from the base end portion of the first portion 18A along the peripheral edge of the gate pad 15, and connects the first portion 18A and the third gate wiring 19. The connection portion 18C includes a band-shaped portion 18F and a band-shaped portion 18G. The band-shaped portion 18F extends along the fourth peripheral edge 15D of the gate pad 15 from the base end portion of the first portion 18A toward the third side surface 5C. The band-shaped portion 18G extends along the third peripheral edge 15C of the gate pad 15 from a terminal portion of the band-shaped portion 18F toward the fourth side surface 5D side, and connects the band-shaped portion 18F and the third gate wiring 19.

In this embodiment, the first portion 18A, the second portion 18B, and the connection portion 18C have the width equivalent to each other. As a matter of course, the first portion 18A may have a different width from at least one of either of the second portion 18B and the connection portion 18C. The second portion 18B may have a width different from that of the connection portion 18C.

In this embodiment, the second portion 18B is longer than the first portion 18A. The second portion 18B may be shorter than the first portion 18A or may have a length equivalent to the first portion 18A.

In this embodiment, the connection portion 18C is shorter than the first portion 18A. The connection portion 18C may be shorter than the first portion 18A or may have a length equivalent to the first portion 18A.

Referring to FIG. 3, the connection wiring 16A connects the first portion 17A of the first gate wiring 17 and the first portion 18A of the second gate wiring 18. The connection wiring 16A is disposed in a region between the gate pad 15 and the first side surface 5A, and the connection wiring 16A is of a band shape extending along the first side surface 5A.

In this embodiment, a peripheral edge at an inner side of the connection wiring 16A coincides with an extension line of a peripheral edge at an inner side of the first portion 17A of the first gate wiring 17. The peripheral edge at the inner side of the connection wiring 16A coincides with extension line of a peripheral edge at an inner side of the first portion 18A of the second gate wiring 18. A peripheral edge at an outer side of the connection wiring 16A coincides with an extension line of a peripheral edge at an outer side of the first portion 17A of the first gate wiring 17. The peripheral edge at the outer side of the connection wiring 16A coincides with an extension line of a peripheral edge at an outer side of the first portion 18A of the second gate wiring 18.

A wiring width of the connection wiring 16A is the same as a wiring width of the first portion 17A. As a matter of course, the wiring width of the connection wiring 16A may be wider than the wiring width of the first portion 17A, or may be narrower than the wiring width of the first portion 17A. The wiring width of the connection wiring 16A is the same as a wiring width of the first portion 18A. As a matter of course, the wiring width of the connection wiring 16A may be wider than or may be narrower than the wiring width of the first portion 18A.

Referring to FIG. 3, in this embodiment, the third gate wiring (third portion) 19 is disposed on the third side surface 5C side with respect to the gate pad 15, and extends in a line shape toward the fourth side surface 5C in the second direction Y in a region between the gate pad 15 and the third side surface 5C. The third gate wiring 19 is connected to the first gate wiring 17 and the second gate wiring 18 in the outer peripheral region 10.

The third gate wiring 19 is electrically connected to the plurality of trench gate structures 11 in the active region 9. The third gate wiring 19 may have a configuration of being led out from the gate pad 15 toward the third side surface 5C, not a configuration of being connected to one of either of the first gate wiring 17 and the second gate wiring 18. The plurality of gate wirings 16 (first gate wiring 17, second gate wiring 18, and third gate wiring 19) may be referred to as "wirings," "wiring electrodes," "gate fingers," "gate finger electrodes," etc. The gate wiring 16 is constituted of a metal wiring, and in this embodiment, the gate wiring 16 is formed of a metal material (second conductive material) containing aluminum (Al). Specifically, the gate wiring 16 may include at least one among a pure Al film (Al film having a purity of not less than 99%), an AlCu alloy film, an AlSi alloy film, and an AlSiCu alloy film.

The gate wiring 16 may be a metal film other than the Al-based metal films. Specifically, the gate wiring 16 may include at least one type among a Ti film, a TiN film, a W film, a Cu film, a Cu alloy film, and a conductive polysilicon film.

Referring to FIG. 3, the semiconductor device 1 includes the source pad 20 disposed on the first principal surface 3 at intervals from the gate pad 15 and the gate wiring 16. The source pad 20 is an electrode to which a source potential is to be applied from the exterior. The source pad 20 may be referred to as a "first principal surface electrode," a "pad," a "source pad electrode," a "source metal," a "second pad electrode," etc.

The source pad 20 is a metal pad, and in this embodiment, the source pad 20 is formed of a metal material containing Al (aluminum). That is, the source pad 20 includes an Al-based metal film. Specifically, the source pad 20 may include at least one among a pure Al film (Al film having a purity of not less than 99%), an AlCu alloy film, an AlSi alloy film, and an AlSiCu alloy film. The source pad 20 may be a metal film other than the Al-based metal films. Specifically, the source pad 20 may include at least one type among a Ti film, a TiN film, a W film, a Cu film, a Cu alloy film, and a conductive polysilicon film.

In this embodiment, the source pad 20 is disposed on the active region 9 in plan view. Specifically, the source pad 20 is formed in a polygonal shape having a recess portion recessed along the gate pad 15 in plan view. As a matter of course, the source pad 20 may be formed in a quadrangular shape in plan view.

In this embodiment, the source pad 20 includes a first source pad 21 disposed in a region further to the second side surface 5B side than a central position in the first direction X of the active region 9 (the first principal surface 3) and a second source pad 22 disposed in a region further to the fourth side surface 5D side than the central position.

Referring to FIG. 3, the first source pad 21 is disposed in a region between the gate pad 15 and the third gate wiring 19, and the first gate wiring 17 on a portion of the insulating layer 13 covering the active region 9. The first source pad 21 faces the plurality of trench gate structures 11 with the insulating layer 13 interposed therebetween. The first source pad 21 preferably has a planar area larger than the planar area of the gate pad 15. A source potential is to be applied to the first source pad 21 from the exterior.

Referring to FIG. 3, the second source pad 22 is disposed in a region between the gate pad 15 and the third gate wiring 19, and the second gate wiring 18 on a portion of the insulating layer 13 covering the active region 9. The second source pad 22 faces the plurality of trench gate structures 11 with the insulating layer 13 interposed therebetween. The second source pad 22 preferably has a planar area larger than the planar area of the gate pad 15. The source potential is to be applied to the second source pad 22 from the exterior.

The first source pad 21 and the second source pad 22 are connected to each other at the end portion on the third side surface 5C side. In this embodiment, the source pad 20 is demarcated by the third gate wiring 19 into a shape where the source pad 20 is divided into the first source pad 21 and the second source pad 22.

Referring to FIG. 3, the semiconductor device 1 includes the at least one (one in this embodiment) source wiring 23 led out from the source pad 20. The source wiring 23 may be referred to as a "wiring," a "wiring electrode," etc. The source wiring 23 transmits the source potential applied to the source pad 20 to another region. The source wiring 23 is routed from a portion of the source pad 20 (the first source pad 21 and the second source pad 22) on the third side surface 5C side onto a portion of the insulating layer 13 covering the outer peripheral region 10.

The source wiring 23 may be referred to as a "wiring," a "wiring electrode," a "source finger," a "source finger electrode," etc. The source wiring 23 is constituted of a metal wiring, and in this embodiment, the source wiring 23 is formed of a metal material containing Al (aluminum). That is, the source wiring 23 includes an Al-based metal film. Specifically, the source wiring 23 may include at least one among a pure Al film (Al film having a purity of not less than 99%), an AlCu alloy film, an AlSi alloy film, and an AlSiCu alloy film. The source wiring 23 may be a metal film other than the Al-based metal films. Specifically, the source wiring 23 may include at least one type among a Ti film, a TiN film, a W film, a Cu film, a Cu alloy film, and a conductive polysilicon film.

Referring to FIG. 2, the semiconductor device 1 includes a drain pad 24 covering the second principal surface 4. The drain pad 24 is an electrode to which a drain potential is to be applied from the exterior. The drain pad 24 may be referred to as a "drain pad electrode," a "third pad electrode," etc. The drain pad 24 forms an ohmic contact with the base layer 6 exposed from the second principal surface 4.

The drain pad 24 may cover an entire area of the second principal surface 4 such as to be continuous to the peripheral edge (the first to fourth side surfaces 5A to 5D) of the chip 2. The drain pad 24 may cover the second principal surface 4 at an interval inward from the peripheral edge of the chip 2 such as to expose a peripheral edge portion of the chip 2.

A breakdown voltage that can be applied between the source pad 20 and the drain pad 24 (between the first principal surface 3 and the second principal surface 4) may be not less than 500 V and not more than 3000 V. The breakdown voltage may have a value belonging to any one range among not less than 500 V and not more than 1000 V, not less than 1000 V and not more than 1500 V, not less than 1500 V and not more than 2000 V, not less than 2000 V and not more than 2500 V, and not less than 2500 V and not more than 3000 V.

Referring to FIG. 1 and FIG. 2, the semiconductor device 1 includes an upper insulating film 25 that selectively covers the gate pad 15, the gate wiring 16, the source pad 20, the source wiring 23, and the insulating layer 13 on the first principal surface 3. The upper insulating film 25 includes a gate pad opening 26 that exposes an inner portion of the gate pad 15. The upper insulating film 25 covers a peripheral edge portion of the gate pad 15 and an entire area of the gate wiring 16. The gate pad opening 26 is formed in a quadrangular shape in plan view.

Referring to FIG. 1, the upper insulating film 25 includes a first source pad opening 27 that exposes an inner portion of the first source pad 21 and a second source pad opening 28 that exposes an inner portion of the second source pad 22. The upper insulating film 25 covers a peripheral edge portion of the first source pad 21, a peripheral edge portion of the second source pad 22, and an entire area of the source wiring 23.

The first source pad opening 27 is formed in a polygonal shape along the peripheral edge portion of the first source pad 21 in plan view. The planar area of the first source pad opening 27 is preferably larger than the planar area of the gate pad opening 26. The second source pad opening 28 is formed in a polygonal shape along the peripheral edge portion of the second source pad 22 in plan view. The planar area of the second source pad opening 28 is preferably larger than the planar area of the gate pad opening 26.

The upper insulating film 25 has an outer peripheral edge at a position at an interval from the first to fourth side surfaces 5A to 5D. The insulating layer 13 is exposed between a peripheral edge at an outer side of the upper insulating film 25 and the first to fourth side surfaces 5A to 5D. The exposed portion of the insulating layer 13 is annular (specifically, a quadrilateral annular shape).

Referring to FIG. 2, the upper insulating film 25 preferably has a thickness exceeding a thickness of the gate pad 15, a thickness of the gate wiring 16, a thickness of the source pad 20, and a thickness of the source wiring 23. A thickness of the upper insulating film 25 is preferably less than a thickness of the chip 2. The thickness of the upper insulating film 25 may be not less than 3 µm and not more than 35 µm. The thickness of the upper insulating film 25 is preferably not more than 25 µm.

The upper insulating film 25 may have a laminated structure including an inorganic insulating film and an organic insulating film laminated in that order from the chip 2 side. The upper insulating film 25 suffices to include at least one among an inorganic insulating film and an organic insulating film, and does not necessarily need to include the inorganic insulating film and the organic insulating film at the same time. The inorganic insulating film may include at least one among a silicon oxide film, a silicon nitride film, and a silicon oxynitride film. The inorganic insulating film preferably contains an insulating material different from the insulating layer 13. The organic insulating film is preferably constituted of a polyimide film, a polyamide film, or a polybenzoxazole film. In this embodiment, the organic insulating film includes a polybenzoxazole film.

Referring to FIG. 4, the semiconductor device 1 includes the peripheral wiring structure 34. In FIG. 4, a formation region of the peripheral wiring structure 34 is indicated by hatching for clarity. The peripheral wiring structure 34 has an annular shape (specifically, a substantially quadrilateral annular shape) along the peripheral edge of the chip 2. In this embodiment, the peripheral wiring structure 34 is disposed in the outer peripheral region 10. The peripheral wiring structure 34 surrounds the active region 9 in plan view. The peripheral wiring structure 34 includes a first structure 34A, the second structure 34B, a third structure 34C, the fourth structure 34D, a fifth structure 34E, and a sixth structure 34F.

Referring to FIG. 4, the first structure 34A and the third structure 34C are opposed in the second direction Y with the active region 9 interposed therebetween. The second structure 34B and the fourth structure 34D are opposed in the first direction X with the active region 9 interposed therebetween. The fifth structure 34E and the sixth structure 34F are disposed in a region in a periphery of the gate pad 15 in the outer peripheral region 10 in plan view.

The peripheral wiring structure 34 is formed of polysilicon as a first conductive material. That is, in this embodiment, the peripheral wiring structure 34 is formed of the same material as the trench gate structures 11. The polysilicon may contain either or both of p-type conductive polysilicon and n-type conductive polysilicon. The polysilicon is a material having a higher resistance than a metal material used for the gate pad 15, the gate wiring 16, the source pad 20, the source wiring 23, etc.

Referring to FIG. 4, the semiconductor device 1 includes a plurality of connection wiring structures 35. The plurality of connection wiring structures 35 extend in a stripe shape in the second direction Y in the active region 9. In the plurality of connection wiring structures 35, regions between the second portion 17B (FIG. 3) of the first gate wiring 17 and second portion 18B (FIG. 3) of the second gate wiring 18 are arrayed at intervals in the first direction X. The plurality of connection wiring structures 35 electrically connects the trench gate structures 11 (FIG. 5) and the first portion 17A (FIG. 3) of the first gate wiring 17 and the first portion 18A (FIG. 3) of the second gate wiring 18.

The number of connection wiring structures 35 included in the semiconductor device 1 may be not less than 5 and not more than 50. The number of connection wiring structures 35 included in the semiconductor device 1 is preferably not less than 15 and not more than 30. The number of connection wiring structures 35 included in the semiconductor device 1 is more preferably not less than 18 and not more than 25.

Referring to FIG. 4, the plurality of connection wiring structures 35 are connected across a portion opposed in the second direction Y of the annular peripheral wiring structure 34. Specifically, the connection wiring structure 35 connects the first structure 34A and the third structure 34C. Both terminal portions of the connection wiring structures 35 in the second direction Y are connected to the first structure 34A and the third structure 34C, respectively.

Also, the connection wiring structure 35 connects the sixth structure 34F and the third structure 34C. The both terminal portions of the connection wiring structures 35 in the second direction Y are connected to the sixth structure 34F and the third structure 34C, respectively. The third structure 34C is connected to the first structure 34A and the sixth structure 34F by the connection wiring structures 35. Thereby, the connection wiring structures 35, the third structure 34C is electrically connected not only to the first structure 34A and the sixth structure 34F but also to other structures (the second structure 34B, the fourth structure 34D, and the fifth structure 34E) of the peripheral wiring structure 34.

The connection wiring structures 35 are formed of polysilicon as a first conductive material and a third conductive material. The polysilicon may contain either or both of p-type conductive polysilicon and n-type conductive polysilicon. In this embodiment, the connection wiring structures 35 are formed of the same material as the trench gate structures 11. The connection wiring structures 35 are formed of the same material as the peripheral wiring structure 34.

Referring to FIG. 4, the semiconductor device 1 includes the resistive wiring structure 38 disposed in the middle of the first structure 34A of the peripheral wiring structure 34. The resistive wiring structure 38 is of a band shape along the first peripheral edge 15A (FIG. 3) of the gate pad 15 in plan view. In this embodiment, the resistive wiring structure 38 is disposed in the outer peripheral region 10. The resistive wiring structure 38 is formed of polysilicon as a first conductive material.

The polysilicon may contain either or both of p-type conductive polysilicon and n-type conductive polysilicon. In this embodiment, the resistive wiring structure 38 is formed of the same material as the trench gate structures 11. The resistive wiring structure 38 is formed of the same material as the peripheral wiring structure 34. The resistive wiring structure 38 is formed of the same material as the connection wiring structures 35.

In this embodiment, the peripheral wiring structure 34, the connection wiring structures 35, and the resistive wiring structure 38 are integrally formed. The peripheral wiring structure 34, the connection wiring structures 35, and the resistive wiring structure 38 include a wiring layer disposed on the first principal surface 3. That is, the polysilicon wiring layer 33 is formed by the peripheral wiring structure 34, the connection wiring structures 35, and the resistive wiring structure 38. The peripheral wiring structure 34, the connection wiring structures 35, and the resistive wiring structure 38 may be collectively referred to as an "base wiring layer."

Referring to FIG. 4 and FIG. 5, the semiconductor device 1 includes at least one (preferably, not less than two and not more than twenty) field region 36 of a p-type formed in the outer peripheral region 10. The number of a plurality of the field regions 36 is typically not less than 3 and not more than 8. The plurality of field regions 36 are formed in an electrically floating state, and relax the electric field in the chip 2 at a peripheral edge portion of the first principal surface 3. The number, width, depth, p-type impurity concentration, etc., of the field regions 36 are arbitrary, and can take various values in accordance with the electric field to be relaxed. In this embodiment, the plurality of field regions 36 are arrayed at intervals from the peripheral edge (the first to fourth side surfaces 5A to 5D) of the first principal surface 3. In this embodiment, the plurality of field regions 36 are formed in an annular shape (specifically, a quadrilateral annular shape) surrounding the active region 9 in plan view.

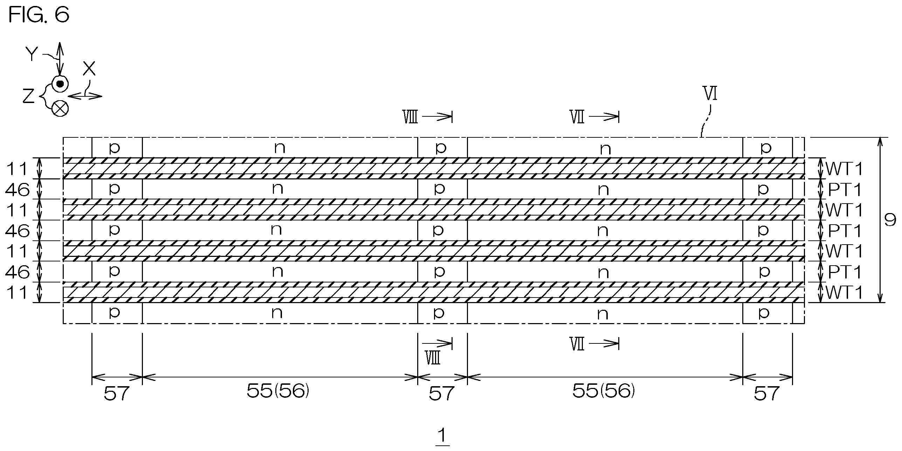

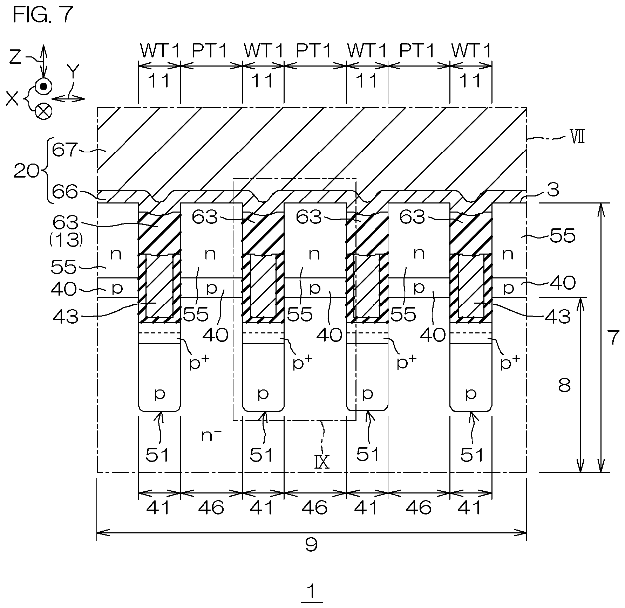

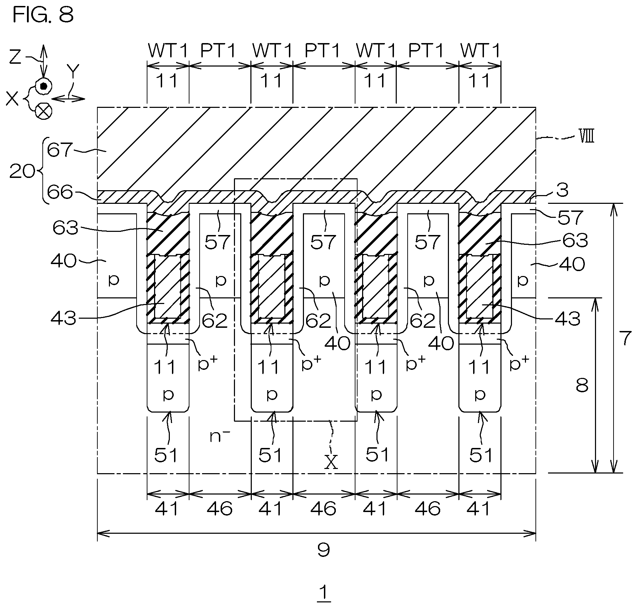

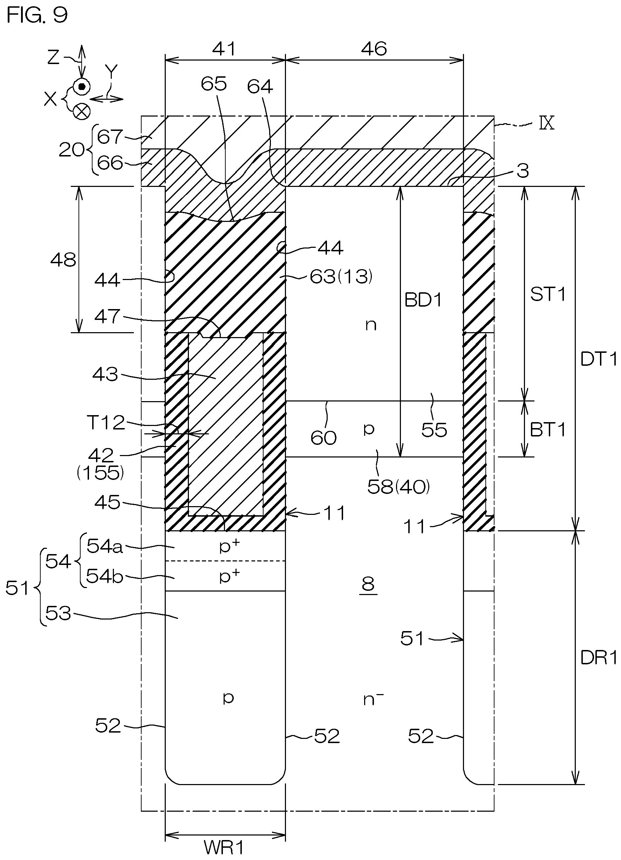

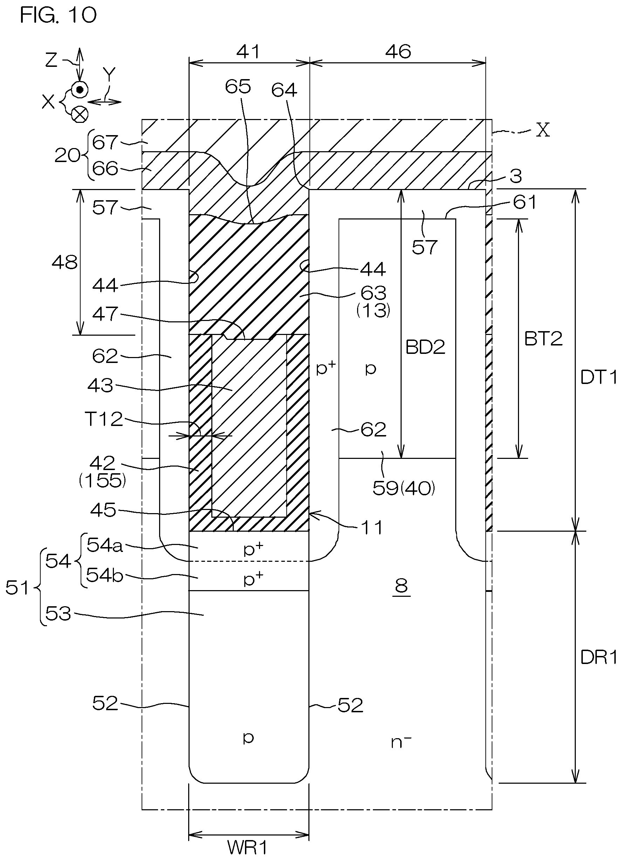

FIG. 6 is an enlarged view of a portion surrounded by an alternate long and short dashed line VI of FIG. 5. FIG. 7 is a sectional view taken along line VII-VII shown in FIG. 6. FIG. 8 is a sectional view taken along line VIII-VIII shown in FIG. 6. FIG. 9 is an enlarged view of a portion surrounded by an alternate long and short dashed line IX of FIG. 7. FIG. 10 is an enlarged view of a portion surrounded by an alternate long and short dashed line X of FIG. 8.

The semiconductor device 1 includes a body region 40 of the p-type as an example of a second impurity region formed in a surface layer portion of the drift region 8. Referring to FIG. 7, FIG. 8, etc., the body region 40 is formed in a layer shape extending along the first principal surface 3 in this embodiment. The body region 40 is formed over an entire area of active region 9. The body region 40 is formed at an interval toward the first principal surface 3 side from the lower end of the semiconductor layer 7.

The body region 40 may have a p-type impurity concentration of not less than 1×10¹⁵ cm⁻³ and not more than 1×10¹⁸ cm⁻³ as a peak value. The p-type impurity concentration of the body region 40 is preferably adjusted by at least one type of trivalent element. The trivalent element of the body region 40 may be at least one type among boron, aluminum, gallium, and indium.

As described above, the semiconductor device 1 includes the plurality of trench gate structures 11. Referring to FIG. 6 to FIG. 8, each trench gate structure 11 has a trench width WT1 in the array direction. The trench width WT1 is preferably less than the thickness T2 (FIG. 2) of the semiconductor layer 7. The trench width WT1 may be not less than 0.1 µm and not more than 5 µm.

The trench width WT1 may have a value belonging to any one range among not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

Referring to FIG. 6 to FIG. 8, the plurality of trench gate structures 11 are arrayed at intervals of a trench pitch PT1 in the second direction Y. The trench pitch PT1 is preferably less than the thickness T2 (FIG. 2) of the semiconductor layer 7. The trench pitch PT1 is preferably less than a trench depth DT1 (FIG. 9 and FIG. 10) described below. The trench pitch PT1 may be 0.1 µm and not more than 5 µm.

The trench pitch PT1 may have a value belonging to any one range among not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm. The trench pitch PT1 is preferably not less than 0.5 µm and not more than 3 µm.

Referring to FIG. 9 and FIG. 10, the trench gate structure 11 has the trench depth DT1 in the vertical direction Z. The trench depth DT1 is preferably less than the thickness T2 (FIG. 2) of the semiconductor layer 7. The trench depth DT1 may be not less than 0.1 µm and not more than 5 µm. The trench depth DT1 may have a value belonging to any one range among not less than 0.1 µm and not more than 0.25 µm, not less than 0.25 µm and not more than 0.5 µm, not less than 0.5 µm and not more than 1 µm, not less than 1 µm and not more than 1.5 µm, not less than 1.5 µm and not more than 2 µm, not less than 2 µm and not more than 3 µm, not less than 3 µm and not more than 4 µm, and not less than 4 µm and not more than 5 µm. The trench depth DT1 is preferably not less than 0.1 µm and not more than 1.5 µm, and more preferably not less than 0.5 µm and not more than 1.5 µm.

The trench depth DT1 is preferably greater than the trench width WT1. That is, each of the plurality of trench gate structures 11 preferably has an aspect ratio DT1/WT1 extending in a vertically long columnar shape. The aspect ratio DT1/WT1 is a ratio of the trench width WT1 to the trench depth DT1. The aspect ratio DT1/WT1 may be, for example, not less than 1 and not more than 5, and is preferably not less than 1 and not more than 3.

Referring to FIG. 9 and FIG. 10, each trench gate structure 11 includes a trench 41 as a first trench, a trench insulating film 42 as a base insulating film, and an embedded body 43. The trench 41 may be referred to as an "element trench," a "gate trench," etc. The trench insulating film 42 may be referred to as an "element insulating film," a "gate insulating film," etc. The embedded body 43 may be referred to as a "connection electrode," a "gate electrode," etc.

The trench 41 is formed in the first principal surface 3 and demarcates an inner surface (side surfaces 44 and a bottom surface 45 shown in FIG. 9 and FIG. 10) of the trench gate structure 11. The bottom surface 45 of the trench 41 preferably has a portion that extends flatly. A mesa portion 46 as an example of a cell portion formed by a portion of the semiconductor layer 7 is formed between the adjacent trenches 41. The mesa portion 46 may be referred to as an "element mesa portion." The width of the mesa portion 46 in the second direction Y is defined by the trench pitch PT1.

Referring to FIG. 7 and FIG. 8, a plurality of the trenches 41 and a plurality of the mesa portions 46 have a band shape extending in the first direction X, and are alternately arrayed in the second direction Y. The plurality of trenches 41 are arrayed in a stripe shape. The plurality of mesa portions 46 are arrayed in a stripe shape.

Referring to FIG. 9 and FIG. 10, it is particularly preferable that a flat portion of the bottom surface 45 of the trench 41 extends substantially parallel to the first principal surface 3. As a matter of course, the bottom surface 45 of the trench 41 may be curved in an arc shape toward the lower end side of the semiconductor layer 7.

The trench insulating film 42 covers the inner surface of the trench 41. The trench insulating film 42 may include at least one among a silicon oxide film, a silicon nitride film, and a silicon oxynitride film. In this embodiment, the trench insulating film 42 has a single layer structure constituted of a silicon oxide film. The trench insulating film 42 particularly preferably includes a silicon oxide film constituted of an oxide of the chip 2.

Referring to FIG. 9 and FIG. 10, the embedded body 43 is embedded in the trench 41 and faces a channel with the trench insulating film 42 interposed therebetween. In this embodiment, the embedded body 43 faces the body region 40 with the trench insulating film 42 interposed therebetween. The embedded body 43 is formed of polysilicon. The polysilicon may be p-type or n-type conductive polysilicon.

The embedded body 43 is embedded up to an intermediate portion in the depth direction of the trench 41. The embedded body 43 has an upper surface 47 positioned on the second principal surface 4 side with respect to the first principal surface 3. A level difference that is low on the second principal surface 4 side is formed between the upper surface 47 of the embedded body 43 and the first principal surface 3. Due to this level difference, a recess 48 demarcated by the upper surface 47 of the embedded body 43 and the side surface 44 of the trench 41 is demarcated in an upper portion of the trench 41.

Referring to FIG. 9 and FIG. 10, the recess 48 is a space sandwiched between the both side surfaces 44 of the trench 41 and the upper surface 47 of the embedded body 43. The recess 48 is formed in a band shape continuous in the depth direction (the first direction X) of the trench 41. The trench insulating film 42 is selectively formed in a region sandwiched between the inner surface of the trench 41 and the embedded body 43, and a side surface of the recess 48 (a portion of the side surface 44 of the trench 41) is exposed from the trench insulating film 42.

The semiconductor device 1 includes a first electric field relaxation layer 51 formed at a bottom portion of the trench gate structure 11. In more detail, the first electric field relaxation layer 51 is formed at the bottom portion of the trench 41. The first electric field relaxation layer 51 is formed at a bottom portion of the trench 41 over an entirety of the depth direction of the trench 41, and is formed in a band shape extending in the depth direction of the trench 41.

Referring to FIG. 9 and FIG. 10, the first electric field relaxation layer 51 is exposed from the bottom surface 45 of the trench 41 and is in contact with the trench insulating film 42. Therefore, an upper end portion of the first electric field relaxation layer 51 is exposed on the bottom surface 45 of the trench gate structure 11 (the trench 41). The first electric field relaxation layer 51 faces the embedded body 43 via the trench insulating film 42 in the depth direction of the trench 41. At the bottom portion of the trench 41, the trench insulating film 42 is sandwiched between the embedded body 43 and the first electric field relaxation layer 51.

The first electric field relaxation layer 51 is formed across one end portion and the other end portion of the trench 41 in the width direction of the trench 41. Referring to FIG. 9 and FIG. 10, in this embodiment, the first electric field relaxation layer 51 has, in the depth direction of the trench 41 of the trench 41, one side surface 52 formed on substantially the same plane as the one side surface 44 in the width direction of the trench 41 and the other side surface 52 formed on substantially the same plane as the other side surface 44 in the width direction of the trench 41.

The side surface 52 of the first electric field relaxation layer 51 extends in the depth direction of the trench gate structure 11 and forms a boundary surface with the semiconductor layer 7 (the drift region 8). The first electric field relaxation layer 51 is physically separated from the body region 40 in the depth direction of the trench gate structure 11 and forms an entirety of the bottom surface 45 of the trench gate structure 11.

Referring to FIG. 9 and FIG. 10, the first electric field relaxation layer 51 has a laminated structure of a first layer 53 and a second layer 54 in this embodiment. The first layer 53 is a layer formed away from the bottom portion (in this embodiment, the bottom surface 45) of the trench 41 toward the second principal surface 4. The second layer 54 is a layer formed between the first layer 53 and the bottom portion (in this embodiment, the bottom surface 45) of the trench 41. The second layer 54 is exposed from the bottom surface 45 of the trench 41 and is in contact with the trench insulating film 42. The second layer 54 is sandwiched between the first layer 53 and the bottom portion of the trench 41.

In this embodiment, the second layer 54 has a laminated structure of an upper layer 54a and a lower layer 54b. The upper layer 54a is exposed from the bottom portion (in this embodiment, the bottom surface 45) of the trench 41 and is in contact with the trench insulating film 42. The lower layer 54b is in contact with the first layer 53 of the first electric field relaxation layer 51.

With respect to the impurity concentration of the first electric field relaxation layer 51, the first layer 53 has a first impurity concentration. The upper layer 54a of the second layer 54 has a second impurity concentration. The lower layer 54b of the second layer 54 has a third impurity concentration. In this embodiment, the second impurity concentration of the upper layer 54a and the third impurity concentration of the lower layer 54b are higher than the first impurity concentration of the first layer 53. The second impurity concentration of the upper layer 54a is higher than the third impurity concentration of the lower layer 54b. Also, the first impurity concentration of the first layer 53 may be equivalent to the impurity concentration of body region 40. The second impurity concentration of the upper layer 54a and the third impurity concentration of the lower layer 54b of the second layer 54 may be higher than the impurity concentration of the body region 40.

For example, the first impurity concentration of the first layer 53 may have a p-type impurity concentration of not less than 1×10¹⁵ cm⁻³ and not more than 1×10¹⁶ cm⁻³ as a peak value. The second impurity concentration of the upper layer 54a of the second layer 54 may have a p-type impurity concentration of not less than 1×10¹⁹ cm⁻³ and not more than 1×10²⁰ cm⁻³ as a peak value. The second impurity concentration of the lower layer 54b of the second layer 54 may have a p-type impurity concentration of not less than 1×10¹⁶ cm⁻³ and not more than 1×10¹⁷ cm⁻³ as a peak value.

The second impurity concentration of the upper layer 54a of the second layer 54 and the third impurity concentration of the lower layer 54b of the second layer 54 may be the same. That is, the second layer 54 may be an impurity region having a single p-type impurity concentration as a peak value.

The p-type impurity concentrations of the first layer 53 and the second layer 54 are preferably adjusted by at least one type of trivalent element. The trivalent element of the first layer 53 and the second layer 54 may be at least one type among boron, aluminum, gallium, and indium.

The laminated structure of the first layer 53 and the second layer 54 is continuous in the depth direction of the trench 41. In this embodiment, the first electric field relaxation layer 51 is formed in a band shape extending in the depth direction of the trench 41 such that the laminated structure of the first layer 53 and the second layer 54 is continuous over the entirety of the trench 41 in the depth direction. For example, a plurality of the first electric field relaxation layers 51 are arrayed at intervals in the m-axis direction and extend in the a-axis direction of the SiC monocrystal. The plurality of first electric field relaxation layers 51 are formed in a stripe shape extending in the a-axis direction (the first direction X), and the extension direction of the plurality of first electric field relaxation layers 51 coincides with the off-direction of the semiconductor layer 7.

The plurality of first electric field relaxation layers 51 overlap the plurality of trench gate structures 11 in the depth direction of the trench 41. Specifically, the plurality of first electric field relaxation layers 51 overlap the plurality of trench gate structures 11 in the vertical direction Z in a one-to-one correspondence relationship. In this embodiment, the plurality of first electric field relaxation layers 51 are connected to the bottom surfaces 45 of the corresponding trench gate structures 11, respectively.

Referring to FIG. 9 and FIG. 10, the first electric field relaxation layer 51 has a first relaxation depth DR1 in the vertical direction Z. The first relaxation depth DR1 may be not less than 0.25 µm and not more than 5 µm. The first relaxation depth DR1 may have a value belonging to any one range among exceeding 0.25 µm and not more than 0.5 µm, not less than 0.5 µm and not more than 1 µm, not less than 1 µm and not more than 1.5 µm, not less than 1.5 µm and not more than 2 µm, not less than 2 µm and not more than 3 µm, not less than 3 µm and not more than 4 µm, not less than 4 µm and not more than 5 µm. The first relaxation depth DR1 is preferably not less than 1.5 µm and not more than 2.5 µm.

Each of the plurality of first electric field relaxation layers 51 has a first relaxation width WR1 in the array direction. The first relaxation width WR1 may be not less than 0.25 µm and not more than 5 µm. The first relaxation width WR1 may have a value belonging to any one range among not less than 0.25 µm and not more than 0.5 µm, not less than 0.5 µm and not more than 0.75 µm, not less than 0.75 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

Referring to FIG. 7 and FIG. 9, the semiconductor device 1 includes a source region 55 as an example of a third impurity region formed in a surface layer portion of the first principal surface 3. The source region 55 is formed in a region between the plurality of trench gate structures 11. The source region 55 is formed in a surface layer portion of the body region 40. In other words, the trench 41 reaches the semiconductor layer 7 from the first principal surface 3 through the source region 55 and the body region 40.

In this embodiment, a plurality of the source regions 55 are formed across the mesa portion 46 in the width direction such as to reach the other side surface 44 from the one side surface 44 (the one side surface 44 and the other side surface 44 of the trench 41) of the mesa portion 46.

The source region 55 has a higher n-type impurity concentration (peak value) than the semiconductor layer 7 (the drift region 8). The source region 55 may have an n-type impurity concentration of not less than 1×10¹⁸ cm⁻³ and not more than 1×10²¹ cm⁻³ as a peak value.

Referring to FIG. 9, the source region 55 has a source thickness ST1. The source thickness ST1 may be a thickness of the source region 55 in the vertical direction Z from the first principal surface 3. The source thickness ST1 may be, for example, not less than 0.2 µm and not more than 1.0 µm, and preferably not less than 0.4 µm and not more than 0.8 µm.

Referring to FIG. 8 and FIG. 10, the semiconductor device 1 includes a first contact region 57 formed in the surface layer portion of the first principal surface 3. The first contact region 57 is formed in a region between the plurality of trench gate structures 11. In this embodiment, a plurality of the first contact regions 57 are formed across the mesa portion 46 in the width direction such as to reach the other side surface 44 from the one side surface 44 of the mesa portion 46. The first contact region 57 is formed adjacent to the source region 55 in the surface layer portion of body region 40.

Referring to FIG. 6, in each mesa portion 46, the plurality of source regions 55 and the plurality of first contact regions 57 are alternately arrayed in the depth direction of the trench 41. In each mesa portion 46, lengths of the plurality of source regions 55 in the first direction X are the same. In each mesa portion 46, lengths of the plurality of first contact regions 57 in the first direction X are the same. The plurality of source regions 55 are arrayed at intervals in the depth direction of the trench 41 in each mesa portion 46. Thereby, in each mesa portion 46, a plurality of channel sections 56 are arrayed at intervals in the first direction X (depth direction of the trench 41). In the channel section 56, a channel is formed on each of the both side surfaces 44 of the trench 41 on both sides in the second direction Y of the mesa portion 46. In other words, a channel is formed in the body region 40.

Comparing FIG. 9 and FIG. 10 mainly, the body region 40 includes a first body portion 58 (FIG. 9) formed directly below source region 55 and a second body portion 59 (FIG. 10) formed directly below the first contact region 57. The first body portion 58 is a portion of the body region 40 sandwiched between the source region 55 and the drift region 8 in the depth direction of the trench 41. The second body portion 59 is a portion of the body region 40 sandwiched between the first contact region 57 and the drift region 8 in the depth direction of the trench 41.

Both the first body portion 58 and the second body portion 59 are portions of the body region 40. Therefore, the first body portion 58 and the second body portion 59 have the same p-type impurity concentration as a peak value. The p-type impurity concentrations of the first body portion 58 and the second body portion 59 may be different from each other.

Referring to FIG. 9 and FIG. 10, the first body portion 58 has a first body thickness BT1, and the second body portion 59 has a second body thickness BT2. The second body thickness BT2 is greater than the first body thickness BT1.

Referring to FIG. 9 and FIG. 10, the first body portion 58 has a first body depth BD1, and the second body portion 59 has a second body depth BD2. In this embodiment, the second body depth BD2 is the same as the first body depth BD1. The second body depth BD2 may be deeper than or may be shallower than the first body depth BD1.

Referring to FIG. 9, a first boundary surface 60 between the first body portion 58 and the source region 55 is positioned further to the second principal surface 4 side than the upper surface 47 of the embedded body 43. The first boundary surface 60 is formed at a position lower than the upper surface 47 of the embedded body 43. A portion (for example, a lower end portion) of the source region 55 faces the embedded body 43 via the trench insulating film 42. Thereby, the formation of a source-drain channel is ensured.

Referring to FIG. 10, a second boundary surface 61 between the second body portion 59 and the first contact region 57 is positioned further to the first principal surface 3 side than the upper surface 47 of the embedded body 43. A portion (for example, an upper end portion) of the second body portion 59 protrudes further to the first principal surface 3 (upper side) side than the embedded body 43. Since the first contact region 57 is not a region that directly contributes to the formation of the source-drain channel, unlike the source region 55, the first contact region 57 does not have to face the embedded body 43 via the trench insulating film 42.

Referring to FIG. 8 and FIG. 10, the semiconductor device 1 includes a second contact region 62 formed in the surface layer portion of the first principal surface 3. The second contact region 62 connects the first contact region 57 and the first electric field relaxation layer 51. The second contact region 62 is formed along the side surface 44 of the trench 41 from the first contact region 57 toward the second principal surface 4, and is connected to the first electric field relaxation layer 51. In this embodiment, the second contact region 62 is formed from the first contact region 57 exposed from the both side surfaces 44 of the mesa portion 46 along both the one side surface 44 and the other side surface 44 of the mesa portion 46.

The second contact region 62 penetrates through the body region 40 and extends between the body region 40 and the first electric field relaxation layer 51. The second contact region 62 forms a boundary with the body region 40, and is connected to the body region 40. Further, the second contact region 62 is also connected to the drift region 8 below the body region 40. That is, in the section between the body region 40 and the first electric field relaxation layer 51, a pn-junction portion is formed by the second contact region 62 and the drift region 8.

Referring to FIG. 10, the second contact region 62 is exposed from the side surface 44 of the trench 41 and is in contact with the trench insulating film 42 on the side surface 44 of the trench 41. A lower end portion of the second contact region 62 is in contact with the upper layer 54a of the second layer 54 of the first electric field relaxation layer 51.

In this embodiment, the first contact region 57 and the second contact region 62 have the same p-type impurity concentration as the upper layer 54a of the second layer 54. In this case, an integral impurity region of the p-type may be formed by the first contact region 57, the second contact region 62, and the upper layer 54a of the second layer 54.

As described above, the semiconductor device 1 includes the insulating layer 13. Referring to FIG. 7 to FIG. 10, etc., the insulating layer 13 includes a first interlayer insulating layer 63 embedded in the recess 48 of the semiconductor layer 7. The first interlayer insulating layer 63 may be referred to as an "interlayer insulating film," an "insulating film," an "interlayer film," an "intermediate insulating film," etc. In this embodiment, the first interlayer insulating layer 63 may include at least one among a silicon oxide film, a silicon nitride film, and a silicon oxynitride film.

The first interlayer insulating layer 63 may have a laminated structure. The first interlayer insulating layer 63 may have a single layer structure. The first interlayer insulating layer 63 is embedded in the recess 48 over the entirety of the depth direction of the trench 41, and is formed in a band shape extending in the depth direction of the trench 41.

Referring to FIG. 9 and FIG. 10, the first interlayer insulating layer 63 is embedded in the recess 48 such that an upper edge 64 of the trench 41 is exposed from the first principal surface 3. The upper edge 64 of the trench 41 may be a portion where the side surface 44 of the trench 41 and the first principal surface 3 intersect at a top portion of the trench 41. That is, the first interlayer insulating layer 63 does not cover the peripheral portion of the trench 41 on the first principal surface 3, and is accommodated in an inner region of the trench 41 in the width direction of the trench 41.

The first interlayer insulating layer 63 is in contact with the source region 55 and the first contact region 57 on a side surface of the recess 48 (the side surface 44 of the trench 41). In this embodiment, an upper surface 65 of the first interlayer insulating layer 63 is positioned further to the bottom portion side of the trench 41 than the first principal surface 3 in the depth direction of the trench 41. The upper surface 65 of the first interlayer insulating layer 63 is recessed downward at a central portion away from the side surface of the recess 48.

Referring to FIG. 7 to FIG. 10, the source pad 20 is formed on the first principal surface 3 such as to cover the first interlayer insulating layer 63. The source pad 20 has a laminated structure including a barrier layer 66 and a main body layer 67 laminated in that order from the first principal surface 3 side.

The barrier layer 66 is formed in a film shape along first principal surface 3 and an inner surface of the recess 48 (the side surface of the recess 48 and the upper surface 65 of the first interlayer insulating layer 63). The barrier layer 66 is in contact with the source region 55 and the first contact region 57. The barrier layer 66 may include at least one among a Ti layer, a Pd layer, a Cr layer, a V layer, a Mo layer, a W layer, a Pt layer, and a Ni layer. A thickness of the barrier layer 66 may be not less than 0.05 µm and not more than 0.3 µm. A thickness of the barrier layer 66 is preferably not less than 0.1 µm and not more than 0.2 µm.

The main body layer 67 is formed on the barrier layer 66. The main body layer 67 covers an entire area of the principal surface of the barrier layer 66. The main body layer 67 is electrically connected to the source region 55 and the first contact region 57 via the barrier layer 66. A thickness of the main body layer 67 exceeds the thickness of the barrier layer 66. The thickness of the main body layer 67 may be not less than 1 µm and not more than 10 µm. The thickness of the main body layer 67 is preferably not less than 3 µm and not more than 6 µm.

In this embodiment, the source pad 20 is connected to the source region 55 and the first contact region 57 on the side surface of the recess 48 and the first principal surface 3. Therefore, the first electric field relaxation layer 51 is fixed to the source potential via the first contact region 57.

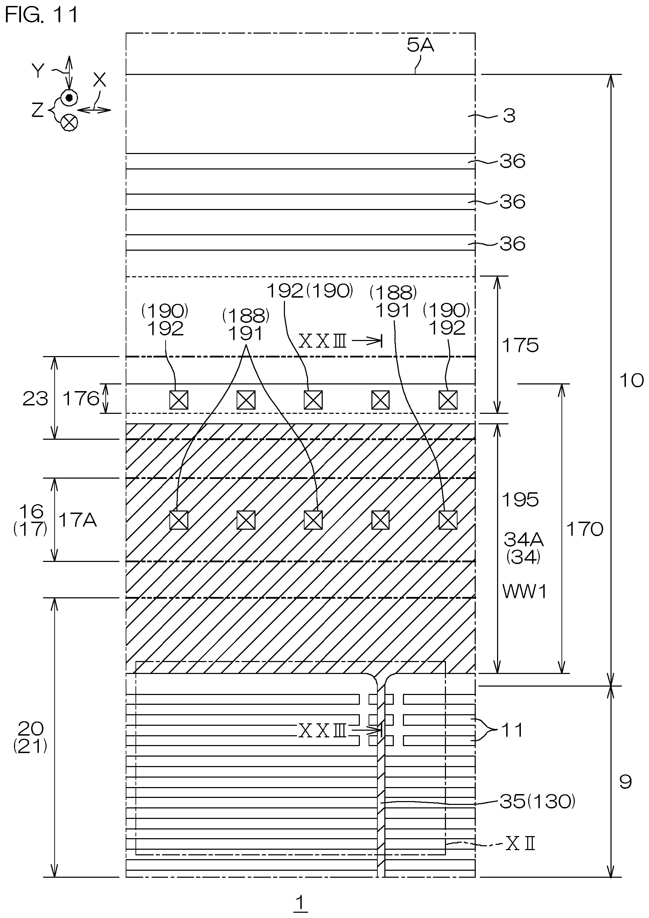

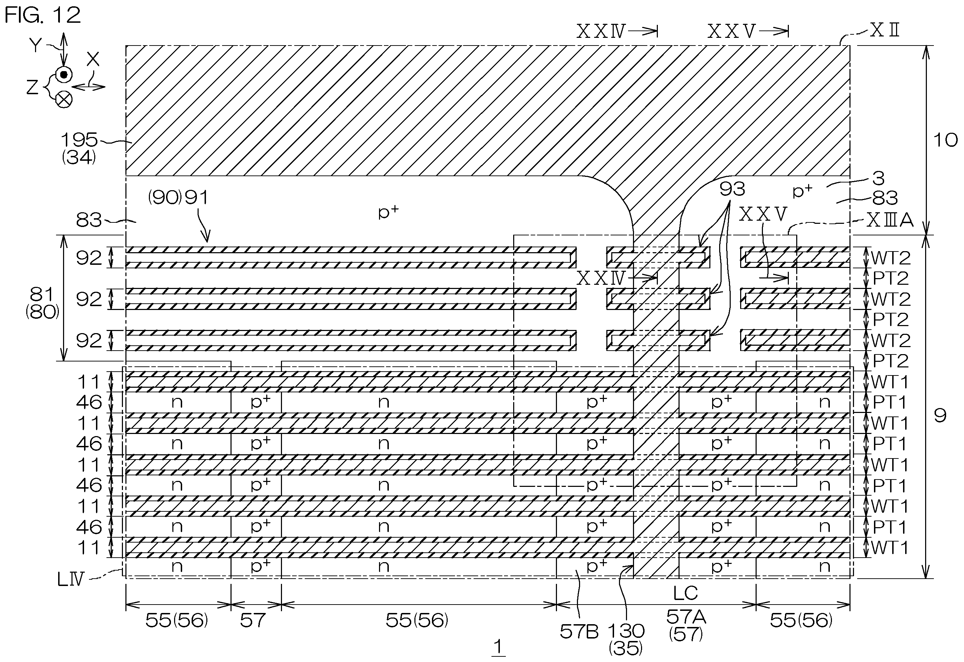

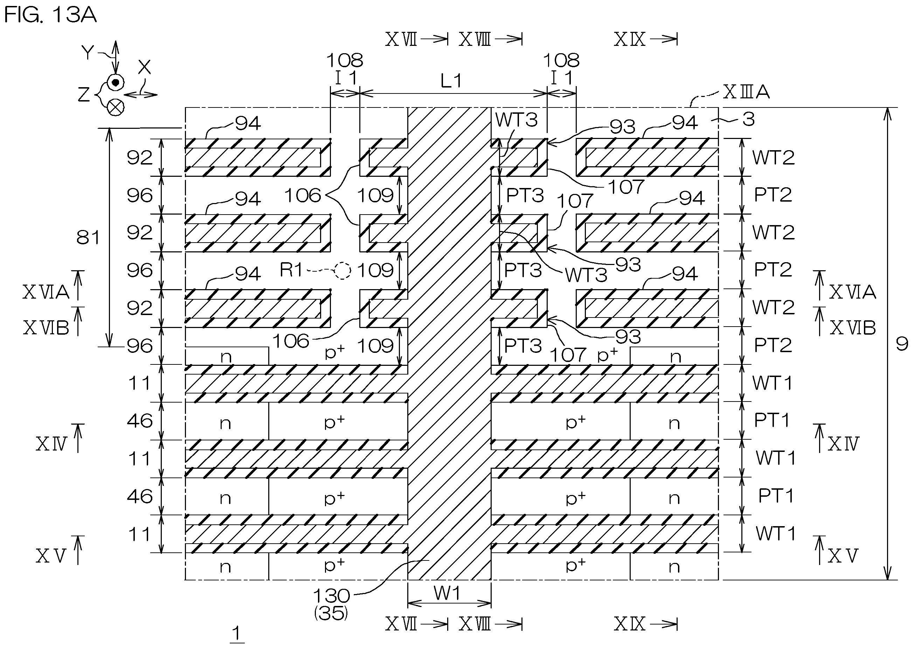

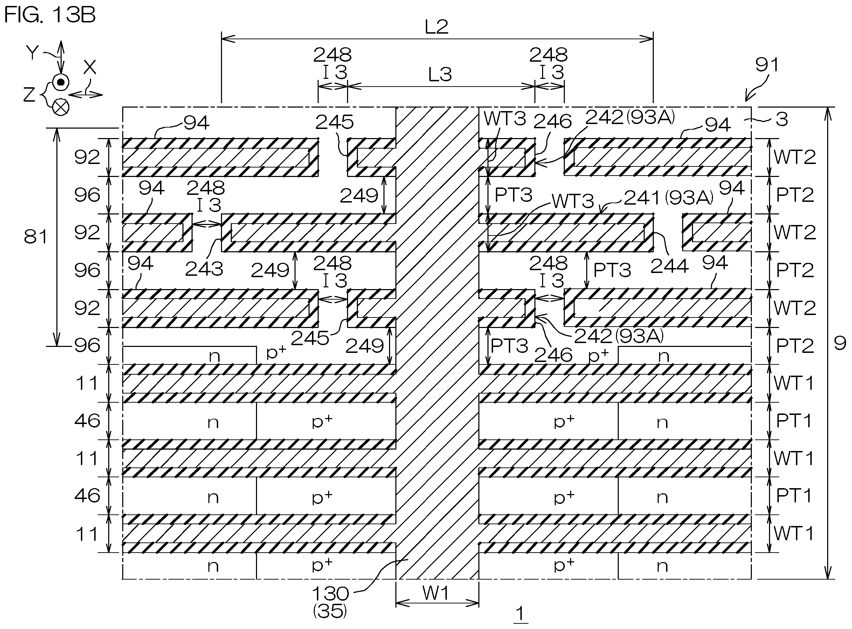

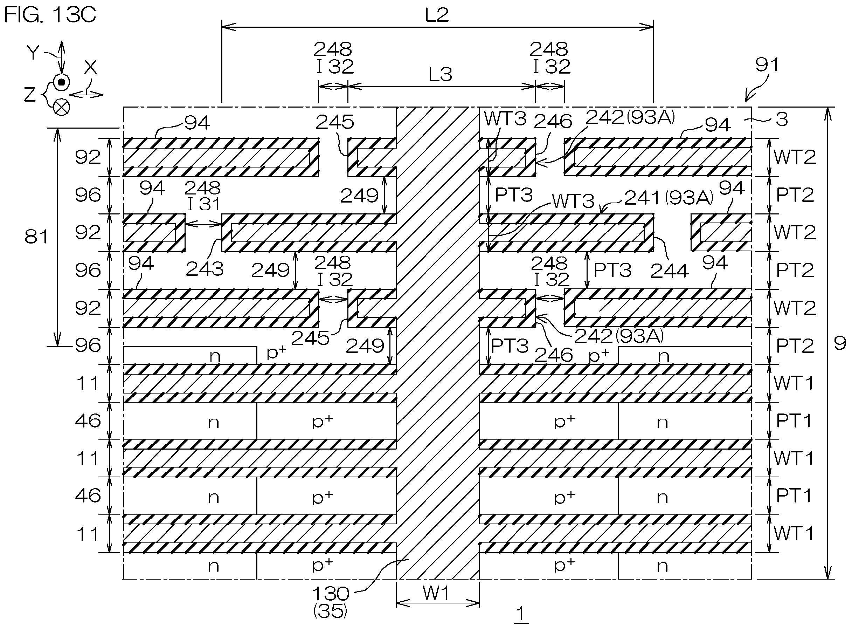

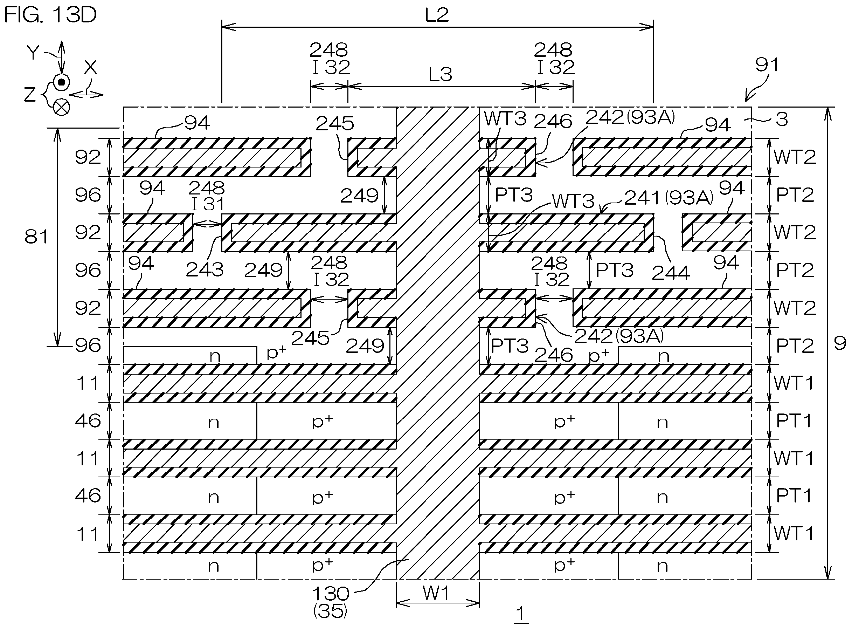

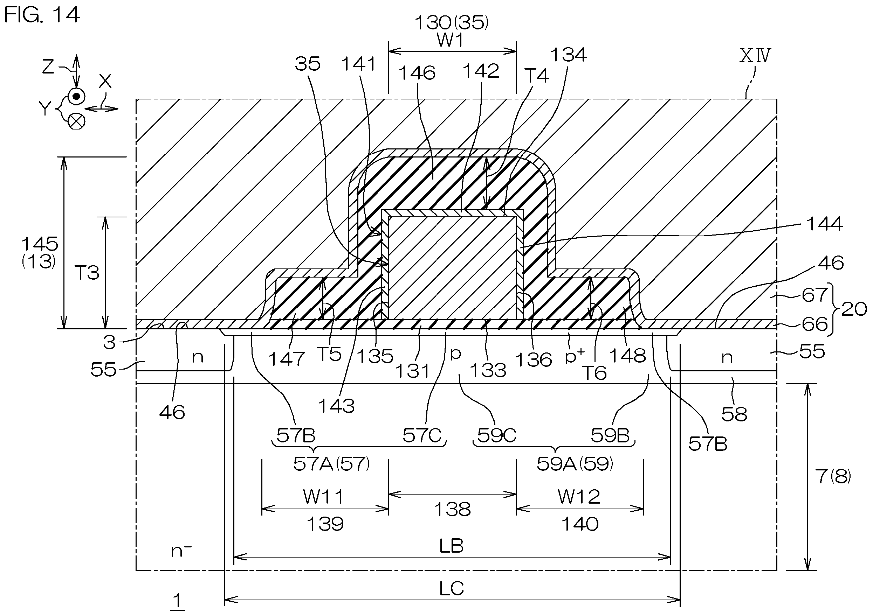

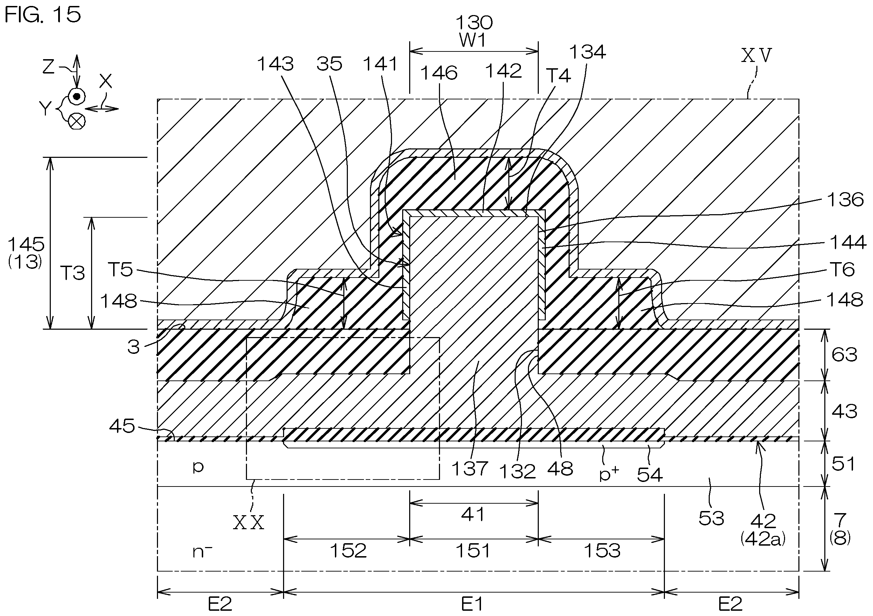

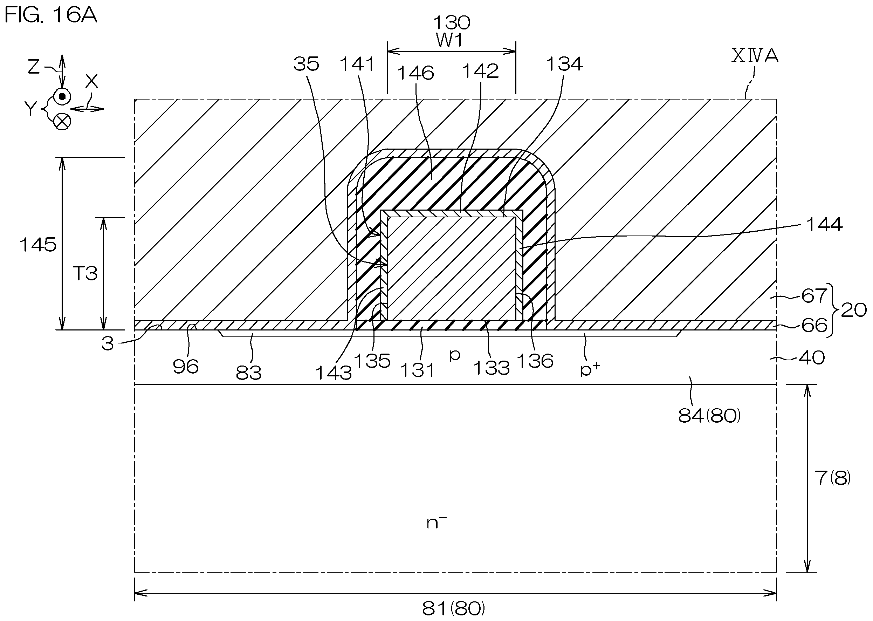

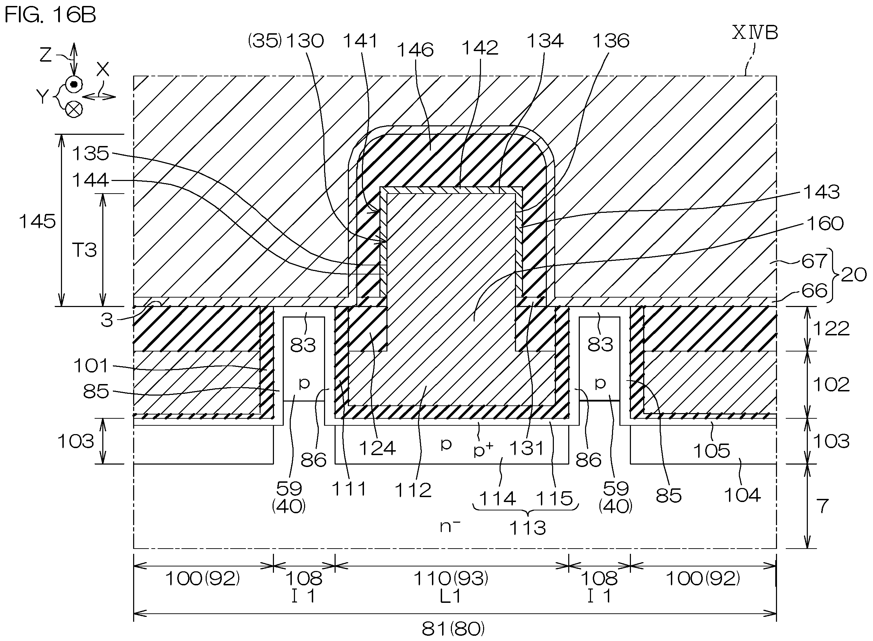

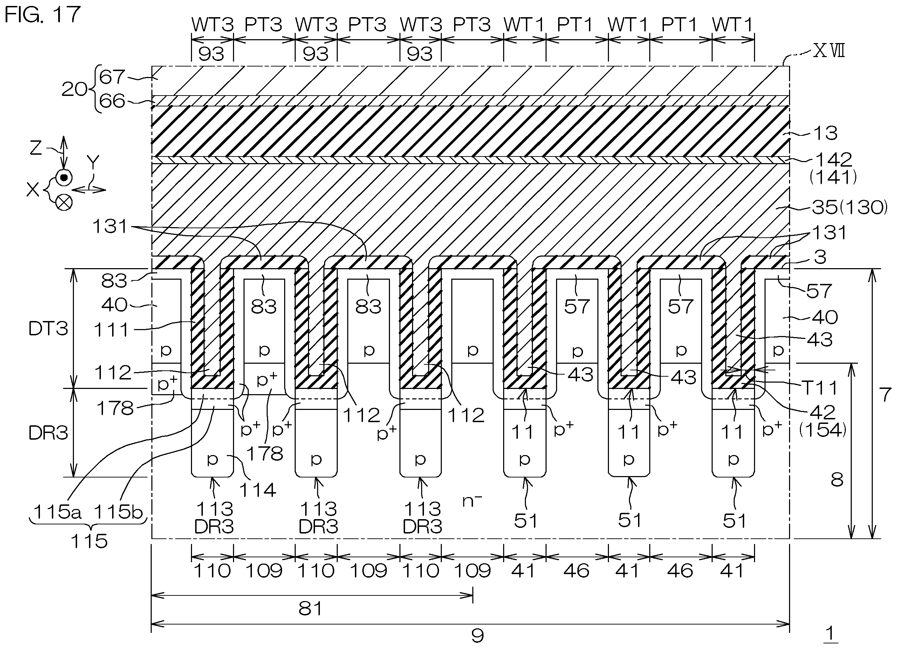

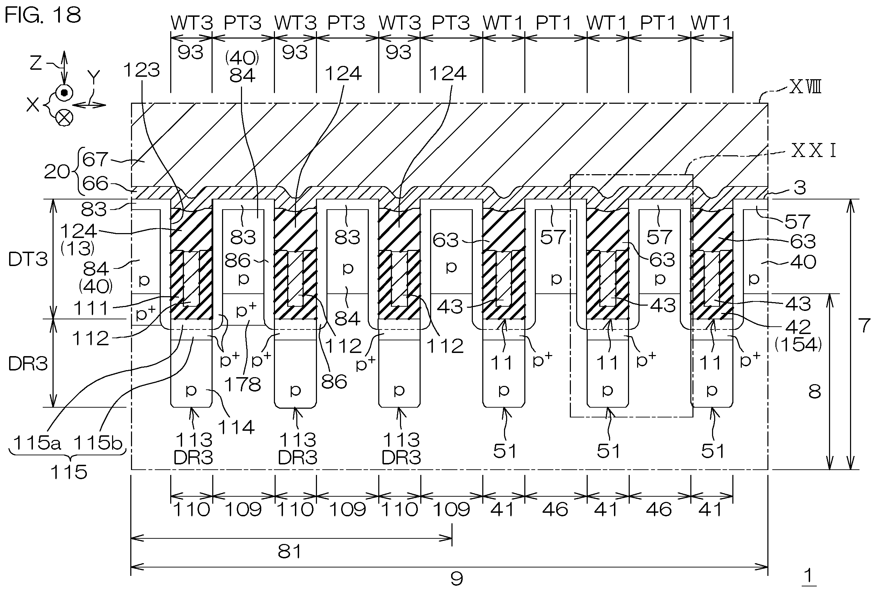

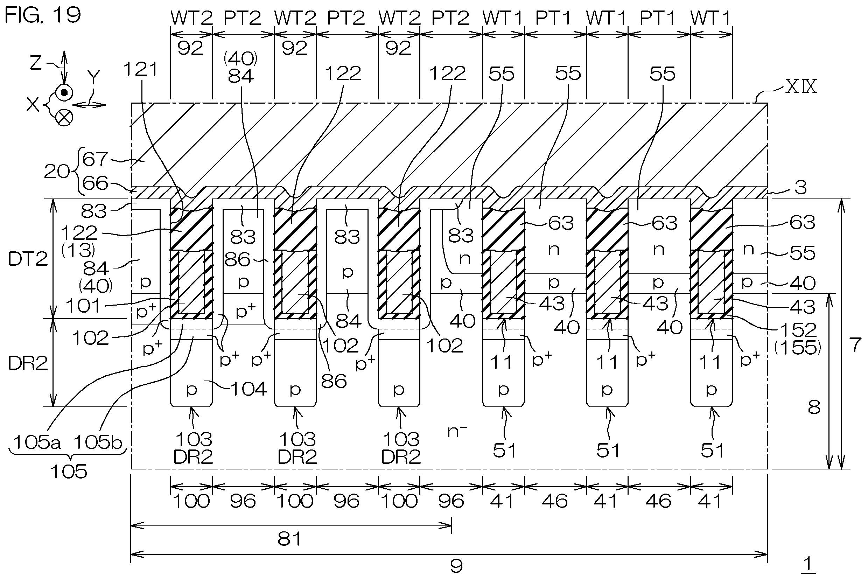

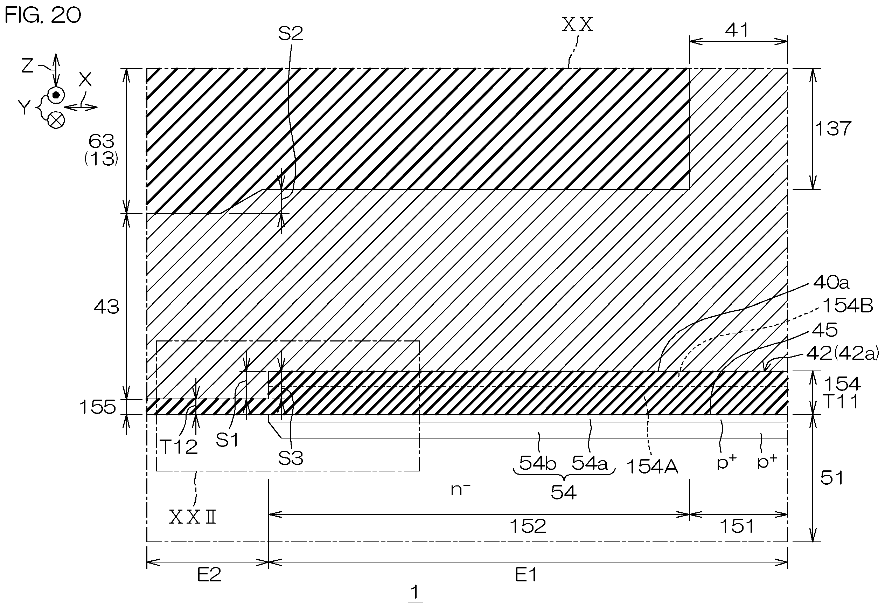

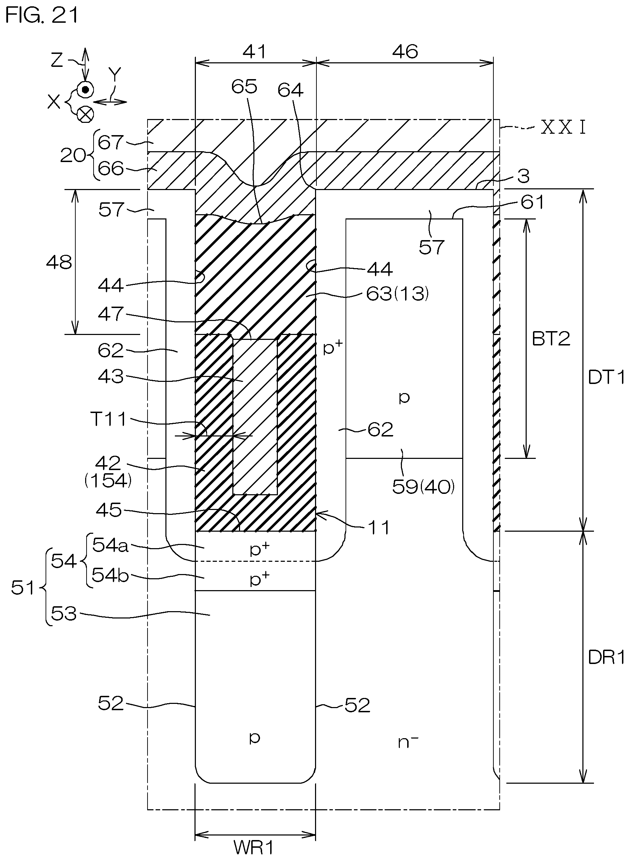

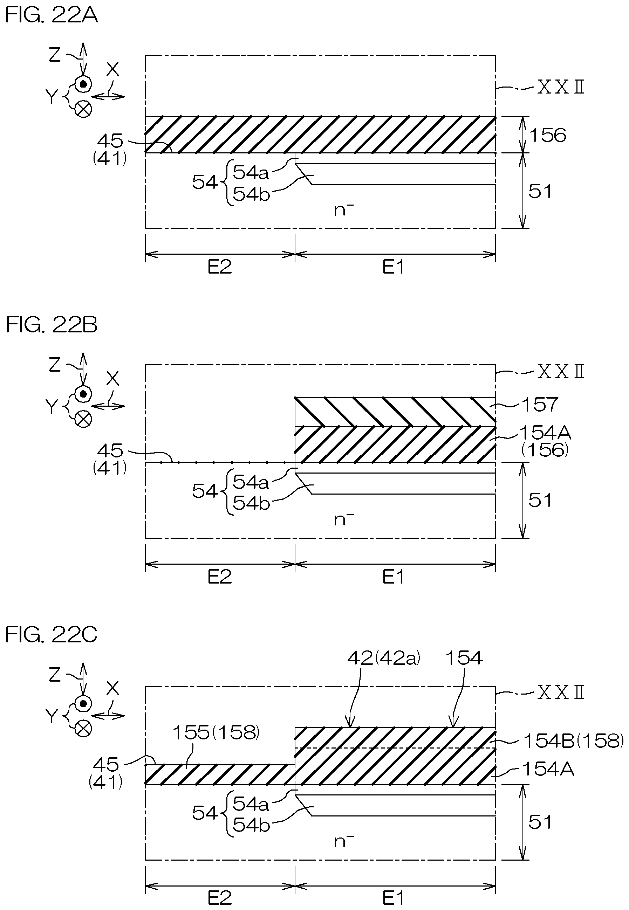

FIG. 11 is an enlarged view of a portion surrounded by an alternate long and short dashed line XI of FIG. 5. FIG. 12 is an enlarged view of a portion surrounded by an alternate long and short dashed line XII of FIG. 11. FIG. 13A is an enlarged view of a portion surrounded by an alternate long and short dashed line XIII of FIG. 12. FIG. 13B is a plan view for describing a first dummy structure 91 according to a second configuration example, and is a view corresponding to FIG. 13A. FIG. 13C is a plan view for describing the first dummy structure 91 according to a third configuration example, and is a view corresponding to FIG. 13B. FIG. 13D is a plan view for describing the first dummy structure 91 according to a fourth configuration example, and is a view corresponding to FIG. 13B. FIG. 14 is a sectional view taken along line XIV-XIV shown in FIG. 13A. FIG. 15 is a sectional view taken along line XV-XV shown in FIG. 13A. FIG. 16A is a sectional view taken along line XVIA-XVIA shown in FIG. 13A. FIG. 16B is a sectional view taken along line XVIB-XVIB shown in FIG. 13A. FIG. 17 is a sectional view taken along line XVII-XVII shown in FIG. 13A. FIG. 18 is a sectional view taken along line XVIII-XVIII shown in FIG. 13A. FIG. 19 is a sectional view taken along line XIX-XIX shown in FIG. 13A. FIG. 20 is an enlarged view of a portion surrounded by an alternate long and short dashed line XX of FIG. 15. FIG. 21 is an enlarged view of a portion surrounded by an alternate long and short dashed line XXI of FIG. 18. FIG. 22A to FIG. 22C are diagrams for describing a part of a manufacturing process of the semiconductor device 1, and show cross sections corresponding to a portion surrounded by an alternate long and short dashed line XXII of FIG. 20.

As described above, the semiconductor device 1 includes the plurality of connection wiring structures 35 extending in the stripe shape in the second direction Y in the active region 9. Referring to FIG. 12, in this embodiment, the connection wiring structures 35 include a connection wiring layer 130 disposed on the first principal surface 3 in the active region 9. The connection wiring layer 130 extends in the second direction Y such as to cross the plurality of trench gate structures 11 and the plurality of mesa portions 46 formed between the plurality of trench gate structures 11. The extension direction of the connection wiring layer 130 is a direction intersecting the off direction of the SiC monocrystal.

In this embodiment, the connection wiring layer 130 is a portion of the polysilicon wiring layer 33. When a polysilicon film covering the first principal surface 3 is formed by filling the trench 41 using a CVD method, a portion of the polysilicon film can be used to form the polysilicon wiring layer 33 (FIG. 4), and the connection wiring layer 130 can thereby be formed.

Thereby, the connection wiring structure 35 (the connection wiring layer 130) can be manufactured in the same step as that used to manufacture the trench gate structure 11. Therefore, steps of the manufacturing process can be reduced as compared with a case in which the connection wiring structure 35 is formed of a material different from the trench gate structures 11. Also, in a case in which the connection wiring structure 35 is formed of polysilicon, manufacturing efficiency can be enhanced as compared with a case in which the connection wiring structure 35 is formed of another material.

Also, in this embodiment, the connection wiring structure 35 includes the connection wiring layer 130 formed on the first principal surface 3, and does not adopt a trench structure. When the connection wiring structure 35 is realized by the connection wiring layer 130, it can be easily formed using deposition and patterning of a material film. Thereby, the connection wiring structure 35 can be efficiently defined as compared with a case in which the connection wiring structure 35 is realized by a trench structure.

Referring to FIG. 14, the connection wiring layer 130 has a lower surface 133, an upper surface 134, a first side surface (side surface) 135 on one side in the first direction X, and a second side surface (side surface) 136 on the other side in the first direction X. The lower surface 133 is substantially parallel to the first principal surface 3. In this embodiment, the first side surface 135 and the second side surface 136 extend perpendicularly to the lower surface 133. That is, the connection wiring layer 130 is formed in a quadrangular shape (flat rectangular shape) in a sectional view.

The connection wiring layer 130 may have a connection width W1 of not less than 1 µm and not more than 10 µm. The connection width W1 of the connection wiring layer 130 is a width in a direction orthogonal to the extension direction (that is, the first direction X). The connection width W1 of the connection wiring layer 130 may have a value belonging to at least one range among not less than 1 µm and not more than 2.5 µm, not less than 2.5 µm and not more than 5 µm, not less than 5 µm and not more than 7.5 µm, and not less than 7.5 µm and not more than 10 µm. The connection width W1 of the connection wiring layer 130 is preferably not less than 1 µm and not more than 5 µm.

The first side surface 135 and the second side surface 136 may be inclined toward the lower surface 133. That is, the connection wiring layer 130 may be formed in a tapered shape (preferably an isosceles trapezoidal shape) in a sectional view.

Referring to FIG. 14, the connection wiring layer 130 is disposed on a first insulating film 131 selectively covering the first principal surface 3. On the upper surface of the mesa portion 46, the connection wiring layer 130 is disposed on a portion of the first insulating film 131 covering the first contact region 57.

Referring to FIG. 12 and FIG. 14, in this embodiment, the connection wiring layer 130 faces the first contact region 57 (the second body portion 59) with the first insulating film 131 interposed therebetween. The connection wiring layer 130 is not disposed on a portion of the first insulating film 131 covering the source region 55. That is, the connection wiring layer 130 does not face the source region 55 (the first body portion 58).

Referring to FIG. 12 and FIG. 14, a region of the first contact region 57 facing the connection wiring structure 35 in the vertical direction Z is referred to as a facing contact region 57A. In other words, the facing contact region 57A is a region of the first contact region 57 that overlaps the connection wiring structure 35 in plan view.

In this embodiment, the facing contact region 57A has a length LC in the first direction X. The length LC is different from those of the other first contact regions 57 (for example, the first contact region 57 facing the facing contact region 57A in the first direction X with the source region 55 interposed therebetween in FIG. 12). The length LC of the facing contact region 57A is longer than the lengths of the other first contact regions 57 in the first direction X. The length LC is longer than a width X1 of the connection wiring layer 130.

Referring to FIG. 12 and FIG. 14, the facing contact region 57A includes a facing portion 57C (FIG. 14) that faces the connection wiring layer 130 in the vertical direction Z, and a non-facing portion 57B that does not face the connection wiring layer 130. The non-facing portion 57B is formed at both end portions of the facing contact region 57A in the first direction X.

The two non-facing portions 57B sandwich the facing portion 57C in the first direction X. The non-facing portion 57B is led out from the facing portion 57C (FIG. 14) facing the connection wiring layer 130 to both sides in the first direction X. The non-facing portion 57B extends from the facing portion 57C toward the source region 55 side, and a bottom portion is covered with the source region 55.

Referring to FIG. 14, a region of the second body portion 59 facing the connection wiring structure 35 in the vertical direction Z with the first insulating film 131 interposed therebetween is referred to as a facing body portion 59A. The facing body portion 59A is a fourth impurity region. The facing body portion 59A is a region below the facing contact region 57A. In other words, the facing body portion 59A is a region of the second body portion 59 overlapping connection wiring structure 35 in plan view.

In this embodiment, the facing body portion 59A has a length LB in the first direction X. The length LB is different from those of other second body portions 59 (for example, the second body portion 59 facing the facing body portion 59A in the first direction X with the source region 55 interposed therebetween in FIG. 12). The length LB of the facing body portion 59A is longer than a length of the other second body portion 59 in the first direction X. The length LB is longer than the width X1 of the connection wiring layer 130. The length LB is shorter than the length LC.

Referring to FIG. 14, two non-facing portions 59B sandwich a facing portion 59C in the first direction X. The non-facing portion 59B is led out from the facing portion 59C facing the connection wiring layer 130 to both sides in the first direction X.

Referring to FIG. 15, in a connection portion 151 between the trench gate structure 11 and the connection wiring layer 130, the connection wiring layer 130 is connected to the embedded body 43 of the trench gate structure 11 via a contact hole 132.

The contact hole 132 vertically penetrates through the first insulating film 131 and the first interlayer insulating layer 63 in a region facing the connection wiring layer 130 in the vertical direction Z. The connection wiring layer 130 is in contact with the embedded body 43 of the trench gate structure 11 from above via the contact hole 132. Thereby, the connection wiring layer 130 is electrically connected to the trench gate structure 11.

Referring to FIG. 14 and FIG. 15, the connection wiring layer 130 may have a connection thickness (thickness) T3 of not less than 0.1 µm and not more than 2 µm. The connection thickness T3 of the connection wiring layer 130 may have a value belonging to at least one range among not less than 0.1 µm and not more than 0.5 µm, not less than 0.5 µm and not more than 1 µm, not less than 1 µm and not more than 1.5 µm, and not less than 1.5 µm and not more than 2 µm. The connection thickness T3 of the connection wiring layer 130 is preferably not less than 0.2 µm and not more than 1 µm.

The connection wiring layer 130 includes a first contact 137 that enters into the recess 48 of the trench 41 from the lower surface 133 and contacts the embedded body 43 of the trench gate structure 11. In this embodiment, the first contact 137 is a portion of the connection wiring layer 130.

Referring to FIG. 14, a lower region 138 of a line shape is set below the connection wiring layer 130 on the upper surface of the mesa portion 46. A first lateral side region 139 and a second lateral side region 140 extending along the lower region 138 are set on the lateral side of the lower region 138. The first lateral side region 139 and the second lateral side region 140 sandwich the lower region 138 in the first direction X.

Referring to FIG. 14, the first lateral side region 139 is a region on the first side surface 135 side with respect to the connection wiring layer 130 as viewed from the center of the connection wiring layer 130 in the first direction X. The outer edge of the first lateral side region 139 is formed at a position at an interval W11 in the first direction X from the boundary with the lower region 138. The interval W11 may be not less than 0.2 times and not more than 2 times the connection width W1. The interval W11 is preferably not less than 0.5 times the connection width W1 and not more than the connection width W1.

Referring to FIG. 14, the second lateral side region 140 is a region on the second side surface 136 side with respect to the connection wiring layer 130 as viewed from the center of the connection wiring layer 130 in the first direction X. The outer edge of the second lateral side region 140 is formed at a position at an interval W12 in the first direction X from the boundary with the lower region 138. The interval W12 may be not less than 0.2 times and not more than 2 times the connection width W1. The interval W12 is preferably not less than 0.5 times the connection width W1 and not more than the connection width W1. The interval W12 may have the same size as the interval W11.

The first insulating film 131 is formed in the lower region 138, the first lateral side region 139, and the second lateral side region 140. The first insulating film 131 extends along the lower surface 133 of the connection wiring layer 130. The first insulating film 131 may include at least one among a silicon oxide film, a silicon nitride film, and a silicon oxynitride film. The first insulating film 131 may be referred to as a principal surface insulating film. The first insulating film 131 is not formed in a region between the connection wiring layer 130 and the trench gate structure 11. That is, the first insulating film 131 intermittently extends in the second direction Y.

The semiconductor device 1 includes a first silicide layer 141 formed on the surface of the connection wiring layer 130. The first silicide layer 141 covers the upper surface 134, the first side surface 135, and the second side surface 136 of the connection wiring layer 130. The first silicide layer 141 is a polysilicon portion obtained by silicidation of polysilicon of the connection wiring layer 130. The first silicide layer 141 may be referred to as a "first metal semiconductor compound layer," a "first silicide layer (polyside layer)," a "first silicide region (polyside region)," etc.

The first silicide layer 141 may contain at least one of Ti silicide, Ni silicide, Co silicide, Mo silicide, and W silicide. The first silicide layer 141 is preferably constituted of Ti silicide, Ni silicide, or Co silicide.

The first silicide layer 141 includes a first covering layer 142 covering the upper surface 134 of the connection wiring layer 130, a second covering layer 143 covering the first side surface 135 of the connection wiring layer 130, and a third covering layer 144 covering the second side surface 136 of the connection wiring layer 130. The first covering layer 142 is formed from a peripheral edge portion of the upper surface 134 on the first side surface 135 side to a peripheral edge portion on the second side surface 136 side.

The first covering layer 142 is of a flat shape along the upper surface 134. A thickness of the first covering layer 142 may be not less than 0.01 times and not more than 0.2 times the connection width W1 of the connection wiring layer 130. The first silicide layer 141 is formed in a band shape extending along the connection wiring layer 130 in plan view.

The second covering layer 143 is formed from an upper edge portion to a lower edge portion of the first side surface 135 and is exposed from the lower surface 133 and the upper surface 134. The second covering layer 143 is of a flat shape along the first side surface 135. A thickness of the second covering layer 143 is not less than 0.01 times and not more than 0.2 times the connection width W1. The second covering layer 143 is formed in a band shape extending along the connection wiring layer 130 in a sectional view. A thickness of the second covering layer 143 may be the same as a thickness of the first covering layer 142.

The third covering layer 144 is formed from an upper edge portion to a lower edge portion of the second side surface 136 and is exposed from the lower surface 133 and the upper surface 134. The third covering layer 144 is of a flat shape along the second side surface 136. A thickness of the third covering layer 144 is not less than 0.01 times and not more than 0.2 times the connection width W1. The third covering layer 144 is formed in a band shape extending along the connection wiring layer 130 in a sectional view. A thickness of the third covering layer 144 may be the same as the thickness of the first covering layer 142. The thickness of the third covering layer 144 may be the same as the thickness of the second covering layer 143.

As described above, the semiconductor device 1 includes the insulating layer 13. Referring to FIG. 14 and FIG. 15, the insulating layer 13 includes a second interlayer insulating layer 145 covering an upper side and a lateral side of the connection wiring layer 130. The second interlayer insulating layer 145 is formed on the lower region 138, the first lateral side region 139, and the second lateral side region 140. The second interlayer insulating layer 145 may include at least one among a silicon oxide film, a silicon nitride film, and a silicon oxynitride film. The second interlayer insulating layer 145 may have a laminated structure. The second interlayer insulating layer 145 may have a single layer structure.

The second interlayer insulating layer 145 includes a covering portion 146 covering the upper side and the lateral side of the connection wiring layer 130, a first protruding portion 147 protruding further outward than the covering portion 146 from the lateral side of the connection wiring layer 130 on the first side surface 135 side, and a second protruding portion 148 protruding further outward than the covering portion 146 from the lateral side of the connection wiring layer 130 on the second side surface 136 side. A thickness T4 of the covering portion 146 may be less than the connection thickness T3 of the connection wiring layer 130. The thickness T4 may be not more than 0.5 times the connection thickness T3 of the connection wiring layer 130.

The first protruding portion 147 faces the first lateral side region 139 with the first insulating film 131 interposed therebetween. In this embodiment, an outer edge of the first protruding portion 147 coincides with an outer edge of the first lateral side region 139. The thickness T5 of the first protruding portion 147 may be thinner than the connection thickness T3 of the connection wiring layer 130. The thickness T5 may be thicker than or may be thinner than the thickness T4 of the covering portion 146.

The second protruding portion 148 faces the second lateral side region 140 with the first insulating film 131 interposed therebetween. In this embodiment, an outer edge of the second protruding portion 148 coincides with an outer edge of the second lateral side region 140. A thickness T6 of the second protruding portion 148 may be less than the connection thickness T3 of the connection wiring layer 130. The thickness T6 may be thicker than or may be thinner than the thickness T4 of the covering portion 146.

Referring to FIG. 15, the trench insulating film 42 included in the trench gate structure 11 is selectively formed thick. In this embodiment, the trench insulating film 42 is formed thick in the connection portion 151 between the trench gate structure 11 and the connection wiring layer 130, and in a first connection lateral side region 152 and a second connection lateral side region 153 adjacent to the connection portion 151 in the first direction X. The first connection lateral side region 152 and second connection lateral side region 153 are examples of a lateral side region. Hereinafter, the connection portion 151, the first connection lateral side region 152, and the second connection lateral side region 153 may be collectively referred to as a "connection region E1."

A thickness of the trench insulating film 42 is different between the connection region E1 and another region E2 other than the connection region E1. The other region E2 other than the connection region E1 is hereinafter referred to as the "other region E2." The connection portion 151 is a region below the connection wiring layer 130. In this embodiment, the first connection lateral side region 152 overlaps the first lateral side region 139 in plan view. The second connection lateral side region 153 overlaps the second lateral side region 140 in plan view.

Referring to FIG. 9, FIG. 10, FIG. 17, FIG. 20, and FIG. 21, the trench insulating film 42 includes a thick film portion 154 and a thin film portion 155. The thick film portion 154 is selectively formed in the trench insulating film 42. The thin film portion 155 is formed in a region of the trench insulating film 42 where the thick film portion 154 is not formed. In this embodiment, the thick film portion 154 is formed in the connection region E1, and the thin film portion 155 is formed in the other region E2.

A thickness T11 (FIG. 17, FIG. 20, and FIG. 21) of the thick film portion 154 of the trench insulating film 42 is thicker than a thickness T12 (FIG. 9, FIG. 10, and FIG. 20) of the thin film portion 155 of the trench insulating film 42 (T11 > T12). The thickness T11 of the thick film portion 154 of the trench insulating film 42 is, for example, not less than 2 µm and not more than 10 µm. The thickness T12 of the thin film portion 155 of the trench insulating film 42 is, for example, not less than 1 µm and not more than 5 µm. The thickness T11 of the thick film portion 154 may be not more than 3 times the thickness T12 of the thin film portion 155. The thickness T11 of the thick film portion 154 is preferably not less than 1.5 times and not more than 2.5 times the thickness T12 of the thin film portion 155. The thickness T11 of the thick film portion 154 is more preferably not less than 1.7 times and not more than 2.3 times the thickness T12 of the thin film portion 155.

Referring to FIG. 20, in this embodiment, the thick film portion 154 has a laminated structure of a first film 154A and a second film 154B laminated in that order from the inner surface (the side surfaces and the bottom surface 45) side of the trench 41. In the thick film portion 154, a lamination interface between the first film 154A and the second film 154B does not necessarily appear. In FIG. 20, the laminated interface is indicated by a broken line for convenience.

The first film 154A is a deposited film. The first film 154A includes an oxide film. The first film 154A may include at least one among a silicon oxide film, a silicon nitride film, and a silicon oxynitride film. In this embodiment, the first film 154A has a single layer structure constituted of a silicon oxide film. The second film 154B may be a deposited film, may be a thermal oxide film. The second film 154B includes an oxide film. In this embodiment, the second film 154B has a single layer structure constituted of a silicon oxide film.

The trench insulating film 42 has a bottom portion insulating film 42a in contact with the bottom surface 45 of the trench 41. Referring to FIG. 15 and FIG. 20, the surface of the bottom portion insulating film 42a forms a convex toward the first principal surface 3 side in a sectional view in the first direction X.

Specifically, in the bottom portion insulating film 42a, an upper surface of the thick film portion 154 is further to the first principal surface 3 side than an upper surface of the thin film portion 155. That is, in the bottom portion insulating film 42a, a first level difference S1 that is high toward the first principal surface 3 side is formed between the upper surface of the thick film portion 154 and the upper surface of the thin film portion 155.

FIG. 22A to FIG. 22C are diagrams for describing a part of the manufacturing process of the semiconductor device 1 (formation of the trench insulating film 42). FIG. 22A to FIG. 22C show cross sections corresponding to a portion surrounded by an alternate long and short dashed line XXII of FIG. 20.

Referring to FIG. 22A, a first base insulating film 156 serving as a base of the thick film portion 154 is formed on the inner surface (the side surfaces and the bottom surface 45) of the trench 41. The first base insulating film 156 is formed by a CVD method. Forming by a CVD method makes it possible to control a thickness of the first base insulating film 156 with high accuracy.

Next, referring to FIG. 22B, a hard mask 157 is formed on the first base insulating film 156. The hard mask 157 may be formed by a CVD method. The hard mask 157 covers the connection region E1 and exposes the other region E2. Then, the first base insulating film 156 is selectively removed by an etching method via the hard mask 157. Thereby, the first base insulating film 156 is formed only in the connection region E1. The first base insulating film 156 forms the first film 154A.

Next, referring to FIG. 22C, a second base insulating film 158 serving as a base of the thick film portion 154 and the thin film portion 155 is formed on the inner surface (the side surfaces and the bottom surface 45) of the trench 41. The second base insulating film 158 may be formed by a CVD method or may be formed by an oxidation treatment method (for example, a thermal oxidation treatment method).

The second base insulating film 158 is formed on the other region E2 and the first film 154A. The thin film portion 155 is formed by the second base insulating film 158 covering the other region E2. The second film 154B is formed by the second base insulating film 158 laminated on the first film 154A. Thereby, the trench insulating film 42 selectively having the thick film portion 154 in the connection region E1 is formed.

According to this embodiment, the trench insulating film 42 (the bottom portion insulating film 42a) in the connection region E1 is selectively thick. That is, the thick film portion 154 is formed in the connection region E1. Therefore, the reliability of the trench gate structure 11 can be improved. In this embodiment, the thick film portion 154 is formed not only in the connecting portion 151 but also in the first connection lateral side region 152 and the second connection lateral side region 153. Therefore, the reliability of the trench gate structure 11 can be improved further.

Also, while the thick film portion 154 is formed in the connection region E1, the thin film portion 155 is formed in the other region E2. That is, the thin film portion 155 is to be applied to most of the trench insulating film 42 of the trench gate structure 11 (FIG. 9 and FIG. 10). Since the trench insulating film 42 is the thin film portion 155, the channel can be favorably formed. Therefore, it is possible to improve the reliability of the trench gate structure 11 while favorably forming the channel.

Referring to FIG. 20, an upper surface 43a of the embedded body 43 in the connection region E1 is further to the first principal surface 3 side than the upper surface 43a of the embedded body 43 in the other region E2. That is, in the upper surface 43a of the embedded body 43, a second level difference S2 (FIG. 20) that is high toward the first principal surface 3 side is formed between the connection region E1 and the other region E2.

A lower surface 43b of the embedded body 43 in the connection region E1 is further to the first principal surface 3 side than the lower surface 43b of the embedded body 43 in the other region E2. That is, in the lower surface 43b of the embedded body 43, a third level difference S3 (FIG. 20) that is high toward the first principal surface 3 side is formed between the connection region E1 and the other region E2. The third level difference S3 is the same as the first level difference S1.

The thin film portion 155 may be formed in the first connection lateral side region 152 and the second connection lateral side region 153 instead of the thick film portion 154. That is, the thick film portion 154 may be formed only in the connection portion 151 in the trench insulating film 42.

Referring to FIG. 11, the semiconductor device 1 includes a dummy structure 90 formed near an outer edge of the active region 9. In a case in which a plurality of trench gate structures are formed at a time, in a trench gate structure positioned near the outermost side among the plurality of (a large number of) trench gate structures, the shape of the trench may collapse or dimensional accuracy may decrease. That is, in the semiconductor device 1, when a plurality of trench gate structures extending in the first direction X are formed, a trench gate structure formed near the outer edge in the second direction Y may include an unstable trench (a trench in which at least one of either of the shape and the dimension of the trench is different from an expected trench).

Therefore, in this embodiment, among the plurality of trench gate structures, the trench gate structure positioned near the outermost side in the second direction Y is not used as the transistor structure Tr, but is deemed to be the dummy structure 90. Only the trench gate structure 11 that is formed further inward than the dummy structure 90 in the second direction Y is used as the transistor structure Tr. Thereby, the shapes of the plurality of trench gate structures 11 can be stabilized in the active region 9. That is, the dummy structure 90 (a first dummy trench structure 92) is disposed near the outer edge of the active region 9.

Referring to FIG. 12, the dummy structure 90 is formed in a dummy formation region 80. The dummy formation region 80 is set at the peripheral edge of the active region 9 in the second direction Y on the first principal surface 3. In this embodiment, the element region where the transistor structure Tr is formed is deemed to be the active region 9. Therefore, the dummy formation region 80 is a portion of the active region 9.

Since the dummy structure 90 is not used as the transistor structure Tr, a region obtained by excluding the dummy formation region 80 from the element region can be defined as the active region 9. In this case, a region obtained by adding the dummy formation region 80 to the active region 9 is an element region.

The dummy formation region 80 includes a first dummy formation region 81 (FIG. 12) disposed on one side (side of the first side surface 5A) in the second direction Y with respect to the plurality of trench gate structures 11. The first dummy formation region 81 is adjacent to the plurality of trench gate structures 11 and demarcates a boundary between the active region 9 and the outer peripheral region 10.

The dummy structure 90 includes a first dummy structure 91 and a second dummy structure 201 (FIG. 31). Hereinafter, the first dummy structure 91 will be described, and the second dummy structure 201 (FIG. 31) will be described later. The first dummy structure 91 includes at least one (in this embodiment, a plurality) of the first dummy trench structures 92, a second dummy trench structure 93 disposed in the middle of the first dummy trench structure 92, and a third dummy trench structure 202 (FIG. 31).

In this embodiment, the plurality of first dummy trench structures 92 extend in the active region 9 in the first direction X from a first outer edge position P1 (FIG. 3) as an example of a first position to a second outer edge position P2 (FIG. 3) as an example of a second position. In the middle of the first dummy trench structures 92, a plurality of the second dummy trench structures 93 are formed at intervals in the first direction X. The third dummy trench structure 202 (FIG. 31) is formed at both terminal ends of the first dummy trench structure 92.

As described above, in the active region 9, the plurality of connection wiring layers 130 extend in a stripe shape in the second direction Y. When the connection wiring layer 130 is connected to the first dummy trench structure 92, there is a possibility that the gate potential is to be applied to the first dummy trench structure 92. In this embodiment, the first dummy trench structure 92 is divided in the middle at a position overlapping the connection wiring layer 130 in plan view such that the first dummy structure 91 and the second dummy structure 201 do not contribute to the formation of the channel (such as not to malfunction).

In the first dummy trench structure 92, the second dummy trench structure 93 is disposed at the position overlapping the connection wiring layer 130 in plan view. The first dummy trench structure 92 is electrically separated (insulated) from the second dummy trench structure 93. Thereby, the first dummy trench structure 92 can be electrically separated (insulated) from the connection wiring structure 35.

In the first dummy trench structure 92, the third dummy trench structure 202 (FIG. 31) is disposed at a position overlapping the peripheral wiring structure 34 in plan view. The first dummy trench structure 92 is electrically separated (insulated) from the third dummy trench structure 202. In other words, the first dummy trench structure 92 is a floating trench structure to which a potential is not applied.

Hereinafter, the first dummy trench structure 92 and the second dummy trench structure 93 will be described. The third dummy trench structure 202 (FIG. 31) will be described later.

Referring to FIG. 12 and FIG. 13A, the plurality of the first dummy trench structures 92 are formed in the first dummy formation region 81. The plurality of (in this embodiment, three) first dummy trench structures 92 are formed in a band shape extending in the first direction X and arrayed at intervals in the second direction Y. That is, the plurality of first dummy trench structures 92 extend side by side with the plurality of trench gate structures 11. The first dummy trench structure 92 may be referred to as a main dummy trench.

Referring to FIG. 12, FIG. 13A, and FIG. 19, the first dummy trench structures 92 have a trench width WT2 in the second direction Y. The trench width WT2 is preferably less than the thickness T2 (FIG. 2) of the semiconductor layer 7. The trench width WT2 may be not less than 0.1 µm and not more than 5 µm. The trench width WT2 is preferably substantially equal to the trench width WT1 described above.

The plurality of first dummy trench structures 92 are arrayed at an interval of a trench pitch PT2 in the second direction Y. The trench pitch PT2 is preferably less than the thickness T2 (FIG. 2) of the semiconductor layer 7. The trench pitch PT2 may be not less than 0.1 µm and not more than 5 µm. The trench pitch PT2 is preferably substantially equal to the trench pitch PT1 described above.

Referring to FIG. 16A and FIG. 19, the first dummy trench structures 92 have a trench depth DT2 in the vertical direction Z. The trench depth DT2 is preferably less than the thickness T2 (FIG. 2) of the semiconductor layer 7. The trench depth DT2 is preferably substantially equal to the trench depth DT1 described above. The trench depth DT2 is preferably not less than the trench pitch PT2.

Referring to FIG. 19, the first dummy trench structures 92 include a first dummy trench 100, a first dummy insulating film 101, and a first dummy embedded body 102. The first dummy trench 100 is formed in the first principal surface 3 and demarcates an inner surface of the first dummy trench structure 92. A bottom surface of the first dummy trench 100 preferably has a portion that extends flatly. It is particularly preferable that a flat portion of the bottom surface of the first dummy trench 100 extends substantially parallel to the first principal surface 3.

A first mesa portion 96 formed by a portion of the semiconductor layer 7 is formed between the two adjacent first dummy trenches 100. Also, the first mesa portion 96 formed by a portion of the semiconductor layer 7 is also formed between the first dummy trench 100 and the trench 41 of the trench gate structure 11 adjacent to each other.

In the first mesa portion 96, the source region 55 is not formed. The source region 55 is partially formed in the first mesa portion 96 adjacent to the mesa portion 46 among a plurality of the first mesa portions 96. In the first mesa portion 96 adjacent to the mesa portion 46, the source region 55 is formed in a region on the mesa portion 46 side in regard to the second direction Y. The source region 55 is not formed in the region on the mesa portion 46 side in regard to the second direction Y. A third body portion 84 which will be described later is formed on the surface of the first mesa portion 96. A first high concentration p-region 83 which will be described later is formed in a surface layer portion of the third body portion 84.

Referring to FIG. 19, the first dummy insulating film 101 covers an inner surface of the first dummy trench 100. The first dummy insulating film 101 may include at least one among a silicon oxide film, a silicon nitride film, and a silicon oxynitride film. In this embodiment, the first dummy insulating film 101 has a single layer structure constituted of a silicon oxide film. The first dummy insulating film 101 particularly preferably includes the silicon oxide film constituted of the oxide of the chip 2.

Referring to FIG. 19, the first dummy embedded body 102 is embedded in the first dummy trench 100 and faces the body region 40 with the first dummy insulating film 101 interposed therebetween. The first dummy embedded body 102 is formed of polysilicon. The polysilicon may be p-type or n-type conductive polysilicon.

The first dummy embedded body 102 is embedded up to the intermediate portion of the first dummy trench 100 in the depth direction. The first dummy embedded body 102 has an upper surface positioned on the second principal surface 4 side with respect to the first principal surface 3. A first dummy recess 121 demarcated by the upper surface of the first dummy embedded body 102 and the side surface of the first dummy trench 100 is formed on an upper portion of the first dummy trench 100.

Referring to FIG. 19, the semiconductor device 1 includes a second electric field relaxation layer 103 formed at a bottom portion of the first dummy trench structure 92. In more detail, the second electric field relaxation layer 103 is formed at a bottom portion of the first dummy trench 100. The second electric field relaxation layer 103 is formed at the bottom portion of the first dummy trench 100 over an entirety of the first dummy trench 100 in the depth direction, and is formed in a band shape extending in the depth direction of the first dummy trench 100.

Referring to FIG. 19, the second electric field relaxation layer 103 is exposed from a bottom surface of the first dummy trench 100 and is in contact with the first dummy insulating film 101. The second electric field relaxation layer 103 faces the first dummy embedded body 102 via the first dummy insulating film 101 in the depth direction of the first dummy trench 100. At the bottom portion of the first dummy trench 100, the first dummy insulating film 101 is sandwiched between the first dummy embedded body 102 and the second electric field relaxation layer 103.

The second electric field relaxation layer 103 is formed across one end portion and the other end portion of the first dummy trench 100 in the width direction of the first dummy trench 100. In this embodiment, the second electric field relaxation layer 103 has one side surface formed on substantially the same plane as one side surface in the width direction of the first dummy trench 100 and the other side surface formed on substantially the same plane as the other side surface in the width direction of the first dummy trench 100 in the depth direction of the first dummy trench 100.

The side surface of the second electric field relaxation layer 103 extends in the depth direction of the first dummy trench structure 92 and forms the boundary surface with the semiconductor layer 7 (the drift region 8). The second electric field relaxation layer 103 is physically separated from the body region 40 in the depth direction of the first dummy trench structure 92, and forms an entirety of a bottom surface of the first dummy trench structure 92.

Referring to FIG. 19, the second electric field relaxation layer 103 has a laminated structure of a third layer 104 and a fourth layer 105 in this embodiment. The third layer 104 is a layer formed away from the bottom portion of the first dummy trench 100 toward the second principal surface 4. The fourth layer 105 is a layer formed between the third layer 104 and the bottom portion of the first dummy trench 100. The fourth layer 105 is exposed from the bottom surface of the first dummy trench 100 and is in contact with the first dummy insulating film 101. The fourth layer 105 is sandwiched between the third layer 104 and the bottom portion of the first dummy trench 100.

In this embodiment, the fourth layer 105 has a laminated structure of an upper layer 105a and an upper layer 105b. The upper layer 105a is exposed from the bottom portion of the first dummy trench 100 and is in contact with the first dummy insulating film 101. The upper layer 105b is in contact with the third layer 104 of the second electric field relaxation layer 103.

For example, the first impurity concentration of the fourth layer 105 may have a p-type impurity concentration of not less than 1×10¹⁵ cm⁻³ and not more than 1×10¹⁶ cm⁻³ as a peak value. The second impurity concentration of the upper layer 105a of the fourth layer 105 may have a p-type impurity concentration of not less than 1×10¹⁹ cm⁻³ and not more than 1×10²⁰ cm⁻³ as a peak value. The second impurity concentration of the upper layer 105b of the fourth layer 105 may have a p-type impurity concentration of not less than 1×10¹⁶ cm⁻³ and not more than 1×10¹⁷ cm⁻³ as a peak value.

The second impurity concentration of the upper layer 105a of the fourth layer 105 and the third impurity concentration of the upper layer 105b of the fourth layer 105 may be the same. That is, the fourth layer 105 may be an impurity region having a single p-type impurity concentration as a peak value.

The p-type impurity concentrations of the third layer 104 and the fourth layer 105 are preferably adjusted by at least one type of trivalent element. The trivalent element of the third layer 104 and the fourth layer 105 may be at least one type among boron, aluminum, gallium, and indium.

The laminated structure of the third layer 104 and the fourth layer 105 is continuous in the depth direction of the first dummy trench 100. In this embodiment, the second electric field relaxation layer 103 is formed in a band shape extending in the depth direction of the first dummy trench 100 such that the laminated structure of the third layer 104 and the fourth layer 105 is continuous over the entirety of the first dummy trench 100 in the depth direction.

A plurality of the second electric field relaxation layers 103 overlap the plurality of first dummy trench structures 92 in the depth direction of the first dummy trench 100. Specifically, the plurality of second electric field relaxation layers 103 overlap the plurality of first dummy trench structures 92 in a one-to-one correspondence in the thickness direction of the chip 2. In this embodiment, the plurality of second electric field relaxation layers 103 are connected to the bottom surfaces of the corresponding first dummy trench structures 92.

Referring to FIG. 19, the second electric field relaxation layers 103 have a second relaxation depth DR2 in the vertical direction Z. The second relaxation depth DR2 is preferably not less than 1.5 µm and not more than 2.5 µm. The second relaxation depth DR2 is preferably substantially equal to the first relaxation depth DR1 described above.

Each of the plurality of second electric field relaxation layers 103 has a second relaxation width WR2 in the array direction. The second relaxation width WR2 may be not less than 0.25 µm and not more than 5 µm. The second relaxation width WR2 is preferably substantially equal to the first relaxation width WR1 described above.

Referring to FIG. 19, the semiconductor device 1 includes the first high concentration p-region 83 in the surface layer portion of the first principal surface 3 in the first dummy formation region 81. The first high concentration p-region 83 is formed in a region between the plurality of first dummy trench structures 92. The first high concentration p-region 83 is formed adjacent to the source region 55 and the first contact region 57 in the second direction Y in the surface layer portion of the body region 40. The first high concentration p-region 83 is connected to the source region 55 and the first contact region 57.

The impurity concentration of the first high concentration p-region 83 may have a p-type impurity concentration of not less than 1×10¹⁹ cm⁻³ and not more than 1×10²⁰ cm⁻³ as a peak value. The first high concentration p-region 83 may have a p-type impurity concentration substantially equal to that of the first contact region 57. The first high concentration p-region 83 may have a depth substantially equal to a depth of the first contact region 57. In this embodiment, the connection wiring layer 130 faces the first high concentration p-region 83 with the first insulating film 131 interposed therebetween. In other words, the first high concentration p-region 83 overlaps the connection wiring layer 130 (the connection wiring structure 35) in plan view.

Referring to FIG. 19, the body region 40 includes the third body portion 84 formed directly below the first high concentration p-region 83. The third body portion 84 is a portion of the body region 40 sandwiched between the first high concentration p-region 83 and the drift region 8 in the depth direction of the first dummy trench 100. A thickness of the third body portion 84 may be the same as the second body thickness BT2 (FIG. 9 and FIG. 10).

In this embodiment, the third body portion 84 is a fourth impurity region. The connection wiring layer 130 faces the third body portion 84 with the first insulating film 131 interposed therebetween. In other words, the third body portion 84 overlaps the connection wiring layer 130 (the connection wiring structure 35) in plan view.

Referring to FIG. 19, the semiconductor device 1 includes a fourth contact region 86 formed in the surface layer portion of the first principal surface 3. The fourth contact region 86 connects the first high concentration p-region 83 and the second electric field relaxation layer 103. The fourth contact region 86 is formed along the side surface of the first dummy trench 100 from the first high concentration p-region 83 toward the second principal surface 4, and is connected to the second electric field relaxation layer 103. In this embodiment, the fourth contact region 86 is formed along both one side surface and the other side surface of the first mesa portion 96 from the first high concentration p-region 83 exposed from both side surfaces of the surface layer portion of the first principal surface 3.

The fourth contact region 86 penetrates through the body region 40 and extends between the body region 40 and the second electric field relaxation layer 103. The fourth contact region 86 forms a boundary with the body region 40, and is connected to the body region 40. Further, the fourth contact region 86 is further connected to the drift region 8 below the body region 40. That is, in the section between the body region 40 and the second electric field relaxation layer 103, a pn-junction portion is formed by the fourth contact region 86 and the drift region 8.

Referring to FIG. 19, the fourth contact region 86 is exposed from the side surface of the first dummy trench 100 and is in contact with the first dummy insulating film 101 on the side surface of the first dummy trench 100. A lower end portion of the fourth contact region 86 is in contact with the upper layer 105a of the fourth layer 105 of the second electric field relaxation layer 103.

In this embodiment, the fourth contact region 86 has the same p-type impurity concentration as the upper layer 105a of the fourth layer 105. In this case, an integral impurity region of the p-type may be formed by the first high concentration p-region 83, the fourth contact region 86, and the upper layer 105a of the fourth layer 105.

Referring to FIG. 19, the insulating layer 13 includes a first dummy interlayer insulating layer 122 embedded in the first dummy recess 121 of the semiconductor layer 7. The first dummy interlayer insulating layer 122 may include at least one among a silicon oxide film, a silicon nitride film, and a silicon oxynitride film. The first dummy interlayer insulating layer 122 is embedded in the first dummy recess 121 over the entirety of the first dummy trench 100 in the depth direction, and is formed in a band shape extending in the depth direction of the first dummy trench 100.

Referring to FIG. 19, the first dummy interlayer insulating layer 122 is embedded in the first dummy recess 121 such that an upper edge of the first dummy trench 100 is exposed from the first principal surface 3. The upper edge of the first dummy trench 100 may be a portion where the side surface of the first dummy trench 100 and the first principal surface 3 intersect at a top portion of the first dummy trench 100. That is, the first dummy interlayer insulating layer 122 does not cover the peripheral portion of the first dummy trench 100 on the first principal surface 3, and is accommodated in the inner region of the first dummy trench 100 in the width direction of the first dummy trench 100. In this embodiment, an upper surface of the first dummy interlayer insulating layer 122 is positioned further to the bottom portion of the first dummy trench 100 side than the first principal surface 3 in the depth direction of the first dummy trench 100. The first dummy interlayer insulating layer 122 is in contact with the first high concentration p-region 83 on the side surface of the first dummy recess 121 (the side surface of the first dummy trench 100).

As described above with reference to FIG. 12, FIG. 13A, etc., the plurality of second dummy trench structures 93 are formed in the middle of the first dummy trench structure 92 (only one is illustrated in FIG. 12, FIG. 13A, etc.). FIG. 12 and FIG. 13A show the second dummy trench structure 93 according to the first configuration example.

The first dummy trench structure 92 is divided in the first direction X by the second dummy trench structure 93 at a plurality of crossing positions crossing the plurality of connection wiring structures 35 in plan view. The first dummy trench structure 92 is divided in the first direction X to constitute a plurality of first dummy band-shaped structures 94 extending in the first direction X. The two first dummy band-shaped structures 94 adjacent to each other are opposed in the first direction X with one second dummy trench structure 93 interposed therebetween.

Referring to FIG. 13A, the second dummy trench structure 93 has a first terminal portion 106 and a second terminal portion 107. The plurality of (for example, three) second dummy trench structures 93 have a first trench length L1 in the first direction X. The first trench length L1 may be shorter than a length of the single first dummy band-shaped structure 94 in the first direction X. The first trench length L1 is wider than the connection width W1 of the connection wiring layer 130. The first terminal portion 106 is, with respect to the connection wiring layer 130, disposed at an interval from one side (the second side surface 5B side) in the first direction X in plan view. The second terminal portion 107 is, with respect to the connection wiring layer 130, disposed at an interval from the other side (the fourth side surface 5D side) in the first direction X in plan view. In this embodiment, the first trench length L1 is shorter than a length LC (FIG. 14) of the facing contact region 57A in the first direction X. A second trench length L2 is shorter than the length LB (FIG. 14) of the facing body portion 59A in the first direction X.

The plurality of (for example, three) second dummy trench structures 93 are opposed in the second direction Y. In the second dummy trench structures 93, the first terminal portions 106 of the plurality of second dummy trench structures 93 are aligned in the first direction X. The plurality of first terminal portions 106 are on the same straight line in the second direction Y. The second terminal portions 107 of the plurality of second dummy trench structures 93 are aligned in the first direction X. The plurality of second terminal portions 107 are on the same straight line in the second direction Y. Lengths of the plurality of second dummy trench structures 93 are the same.

Referring to FIG. 13A, the second dummy trench structure 93 is disposed between the two first dummy band-shaped structures 94 adjacent to each other in the first direction X at an interval I1 from these two first dummy band-shaped structures 94. The second dummy trench structure 93 is electrically separated (insulated) from the first dummy trench structure 92.

Referring to FIG. 13A and FIG. 19, the second dummy trench structure 93 has a trench width WT3 in the second direction Y. The trench width WT3 is preferably less than the thickness T2 (FIG. 2) of the semiconductor layer 7. The trench width WT3 may be not less than 0.1 µm and not more than 5 µm. The trench width WT3 is preferably substantially equal to the trench width WT2 described above. The trench width WT3 is preferably substantially equal to the trench width WT1 described above.

The plurality of second dummy trench structures 93 are arrayed at intervals of a trench pitch PT3 in the second direction Y. The trench pitch PT3 is preferably less than the thickness T2 (FIG. 2) of the semiconductor layer 7. The trench pitch PT3 is preferably less than the trench depth DT2 (FIG. 2). The trench pitch PT3 may be not less than 0.1 µm and not more than 5 µm. The trench pitch PT3 is preferably substantially equal to the trench pitch PT2 described above. The trench pitch PT3 is preferably substantially equal to the trench pitch PT1 described above.

The interval I1 between the second dummy trench structure 93 and the first dummy band-shaped structure 94 is narrower than the trench pitch PT3. The interval I1 is preferably not less than 0.5 times and less than 0.8 times the trench pitch PT3. The interval I1 is narrower than the trench pitch PT2. The interval I1 is preferably not less than 0.5 times and less than 0.8 times the trench pitch PT2. The interval I1 is narrower than the trench pitch PT1. The interval I1 is preferably not less than 0.5 times and less than 0.8 times the trench pitch PT1.

Referring to FIG. 17, the second dummy trench structure 93 has a trench depth DT3 in the vertical direction Z. The trench depth DT3 is preferably less than the thickness T2 (FIG. 2) of the semiconductor layer 7. The trench depth DT3 may be not less than 0.1 µm and not more than 5 µm. The trench depth DT3 is preferably substantially equal to the trench depth DT1 described above. The trench depth DT3 is preferably substantially equal to the trench depth DT2 described above.

Referring to FIG. 17, the second dummy trench structure 93 includes a second dummy trench 110, a second dummy insulating film 111, and a second dummy embedded body 112. The second dummy trench 110 is formed in the first principal surface 3 and demarcates an inner surface of the second dummy trench structure 93. A bottom surface of the second dummy trench 110 preferably has a portion that extends flatly. It is particularly preferable that a flat portion of the bottom surface of the second dummy trench 110 extends substantially parallel to the first principal surface 3.

Referring to FIG. 13A and FIG. 17, a second mesa portion 109 formed by a portion of the semiconductor layer 7 is formed between the two adjacent second dummy trench structures 93. Also, the second mesa portion 109 formed by a portion of the semiconductor layer 7 is also formed between the second dummy trench structure 93 and the trench gate structure 11 adjacent in the second direction Y. The width of the second mesa portion 109 in the second direction Y is defined by the trench pitch PT3.

Referring to FIG. 17, the second dummy insulating film 111 covers an inner surface of the second dummy trench 110. The second dummy insulating film 111 may include at least one among a silicon oxide film, a silicon nitride film, and a silicon oxynitride film. In this embodiment, the second dummy insulating film 111 has a single layer structure constituted of a silicon oxide film. The second dummy insulating film 111 particularly preferably includes the silicon oxide film constituted of the oxide of the chip 2.

Referring to FIG. 17, the second dummy embedded body 112 is embedded in the second dummy trench 110 and faces the body region 40 with the second dummy insulating film 111 interposed therebetween. The second dummy embedded body 112 is formed of polysilicon. The polysilicon may be p-type or n-type conductive polysilicon.

The second dummy embedded body 112 is embedded up to the intermediate portion of the second dummy trench 110 in the depth direction. The second dummy embedded body 112 has an upper surface positioned on the second principal surface 4 side with respect to the first principal surface 3.

Referring to FIG. 17, the semiconductor device 1 includes a third electric field relaxation layer 113 formed at a bottom portion of the second dummy trench structure 93. In more detail, the third electric field relaxation layer 113 is formed at a bottom portion of the second dummy trench 110. The third electric field relaxation layer 113 is formed at the bottom portion of the second dummy trench 110 over an entirety of the second dummy trench 110 in the depth direction, and is formed in a band shape extending in the depth direction of the second dummy trench 110.

Referring to FIG. 17, the third electric field relaxation layer 113 is exposed from the bottom surface of the second dummy trench 110 and is in contact with the second dummy insulating film 111. The third electric field relaxation layer 113 faces the second dummy embedded body 112 via the second dummy insulating film 111 in the depth direction of the second dummy trench 110. At the bottom portion of the second dummy trench 110, the second dummy insulating film 111 is sandwiched between the second dummy embedded body 112 and the third electric field relaxation layer 113.

The third electric field relaxation layer 113 is formed across one end portion and the other end portion of the second dummy trench 110 in the width direction of the second dummy trench 110. In this embodiment, the third electric field relaxation layer 113 has one side surface formed on substantially the same plane as one side surface in the width direction of the second dummy trench 110 and the other side surface formed on substantially the same plane as the other side surface in the width direction of the second dummy trench 110 in the depth direction of the second dummy trench 110.

The side surface of the third electric field relaxation layer 113 extends in the depth direction of the second dummy trench structure 93 and forms a boundary surface with the drift region 8. The third electric field relaxation layer 113 is physically separated from the body region 40 in the depth direction of the second dummy trench structure 93, and forms an entirety of a bottom surface of the second dummy trench structure 93.

Referring to FIG. 17, the third electric field relaxation layer 113 has a laminated structure of a fifth layer 114 and a sixth layer 115 in this embodiment. The fifth layer 114 is a layer formed away from the bottom portion of the second dummy trench 110 toward the second principal surface 4. The sixth layer 115 is a layer formed between the fifth layer 114 and the bottom portion of the second dummy trench 110. The sixth layer 115 is exposed from the bottom surface of the second dummy trench 110 and is in contact with the second dummy insulating film 111. The sixth layer 115 is sandwiched between the fifth layer 114 and the bottom portion of the second dummy trench 110.

In this embodiment, the sixth layer 115 has a laminated structure of an upper layer 115a and an upper layer 115b. The upper layer 115a is exposed from the bottom portion of the second dummy trench 110 and is in contact with the second dummy insulating film 111. The upper layer 115b is in contact with the fifth layer 114 of the third electric field relaxation layer 113.

For example, the first impurity concentration of the sixth layer 115 may have a p-type impurity concentration of not less than 1×10¹⁵ cm⁻³ and not more than 1×10¹⁶ cm⁻³ as a peak value. The second impurity concentration of the upper layer 115a of the sixth layer 115 may have a p-type impurity concentration of not less than 1×10¹⁹ cm⁻³ and not more than 1×10²⁰ cm⁻³ as a peak value. The second impurity concentration of the upper layer 115b of the sixth layer 115 may have a p-type impurity concentration of not less than 1×10¹⁶ cm⁻³ and not more than 1×10¹⁷ cm⁻³ as a peak value.

The second impurity concentration of the upper layer 115a of the sixth layer 115 and the third impurity concentration of the upper layer 115b of the sixth layer 115 may be the same. That is, the sixth layer 115 may be an impurity region having a single p-type impurity concentration as a peak value.

The p-type impurity concentrations of the fifth layer 114 and the sixth layer 115 are preferably adjusted by at least one type of trivalent element. The trivalent element of the fifth layer 114 and the sixth layer 115 may be at least one type among boron, aluminum, gallium, and indium.

The laminated structure of the fifth layer 114 and the sixth layer 115 is continuous in the depth direction of the second dummy trench 110. In this embodiment, the third electric field relaxation layer 113 is formed in a band shape extending in the depth direction of the second dummy trench 110 such that the laminated structure of the fifth layer 114 and the sixth layer 115 is continuous over the entirety of the second dummy trench 110 in the depth direction.

A plurality of the third electric field relaxation layers 113 overlap the plurality of second dummy trench structures 93 in the depth direction of the second dummy trench 110. Specifically, the plurality of third electric field relaxation layers 113 overlap the plurality of second dummy trench structures 93 in a one-to-one correspondence in the thickness direction of the chip 2. In this embodiment, the plurality of third electric field relaxation layers 113 are connected to the bottom surfaces of the corresponding second dummy trench structures 93.

Referring to FIG. 17, the third electric field relaxation layer 113 has a third relaxation depth DR3 in the vertical direction Z. The third relaxation depth DR3 is preferably not less than 1.5 µm and not more than 2.5 µm. The third relaxation depth DR3 is preferably substantially equal to the second relaxation depth DR2 described above. The third relaxation depth DR3 is preferably substantially equal to the first relaxation depth DR1 described above.

Each of the plurality of third electric field relaxation layers 113 has a third relaxation width WR3 in the array direction. The third relaxation width WR3 may be not less than 0.25 µm and not more than 5 µm. The third relaxation width WR3 is preferably substantially equal to the second relaxation width WR2 described above. The third relaxation width WR3 is preferably substantially equal to the first relaxation width WR1 described above.

Referring to FIG. 18, the fourth contact region 86 connects the first high concentration p-region 83 and the third electric field relaxation layer 113. The fourth contact region 86 is formed along the side surface of the second dummy trench 110 from the first high concentration p-region 83 toward the second principal surface 4, and is connected to the third electric field relaxation layer 113. In this embodiment, the fourth contact region 86 is formed along both one side surface and the other side surface of the second mesa portion 109 from the first high concentration p-region 83 exposed from both side surfaces of the surface layer portion of the first principal surface 3.

The fourth contact region 86 penetrates through the body region 40 and extends between the body region 40 and the third electric field relaxation layer 113. The fourth contact region 86 forms the boundary with the body region 40, and is connected to the body region 40. Further, the fourth contact region 86 is further connected to the drift region 8 below the body region 40. That is, in the section between the body region 40 and the third electric field relaxation layer 113, a pn-junction portion is formed by the fourth contact region 86 and the drift region 8.

Referring to FIG. 18, the fourth contact region 86 is exposed from the side surface of the second dummy trench 110 and is in contact with the second dummy insulating film 111 on the side surface of the second dummy trench 110. The lower end portion of the fourth contact region 86 is in contact with the upper layer 115a of the sixth layer 115 of the third electric field relaxation layer 113.

In this embodiment, the fourth contact region 86 has the same p-type impurity concentration as the upper layer 105a of the fourth layer 105. In this case, an integral impurity region of the p-type may be formed by the first high concentration p-region 83, the fourth contact region 86, and the upper layer 115a of the sixth layer 115.

Referring to FIG. 18, the insulating layer 13 includes a second dummy interlayer insulating layer 124 embedded in a second dummy recess 123 of the semiconductor layer 7. The second dummy interlayer insulating layer 124 may be referred to as an "interlayer insulating film," an "insulating film," an "interlayer film," an "intermediate insulating film," etc. In this embodiment, the second dummy interlayer insulating layer 124 may include at least one among a silicon oxide film, a silicon nitride film, and a silicon oxynitride film. The second dummy interlayer insulating layer 124 is embedded in the second dummy recess 123 over the entirety of the second dummy trench 110 in the depth direction, and is formed in a band shape extending in the depth direction of the second dummy trench 110.

Referring to FIG. 18, the second dummy interlayer insulating layer 124 is embedded in the second dummy recess 123 such that an upper edge of the second dummy trench 110 is exposed from the first principal surface 3. The upper edge of the second dummy trench 110 may be a portion where the side surface of the second dummy trench 110 and the first principal surface 3 intersect at a top portion of the second dummy trench 110. That is, the second dummy interlayer insulating layer 124 does not cover the peripheral portion of the second dummy trench 110 on the first principal surface 3, and is accommodated in the inner region of the second dummy trench 110 in the width direction of the second dummy trench 110. In this embodiment, the upper surface of the second dummy interlayer insulating layer 124 is positioned further to the bottom portion side of the second dummy trench 110 than the first principal surface 3 in the depth direction of the second dummy trench 110. The second dummy interlayer insulating layer 124 is in contact with the first high concentration p-region 83 on the side surface of the second dummy recess 123 (the side surface of the second dummy trench 110).

Referring to FIG. 13A, a third mesa portion 108 formed by a portion of the semiconductor layer 7 is formed between the first dummy band-shaped structure 94 and the second dummy trench structure 93. A width of the third mesa portion 108 in the first direction X is defined by the interval I1. The width (the interval I1) of the third mesa portion 108 in the first direction X is narrower than a width (the trench pitch PT3) of the second mesa portion 109 in the second direction Y. The width (the interval I1) of the third mesa portion 108 in the first direction X is not less than 0.5 times and less than 0.8 times the width (the trench pitch PT3) of the second mesa portion 109 in the second direction Y.

The first dummy band-shaped structure 94 and the second dummy trench structure 93 are electrically and physically separated by the third mesa portion 108. The adjacent first mesa portions 96 are connected to each other by the third mesa portion 108. The third mesa portion 108 is aligned in regard to the first direction X. The end portions of a plurality of the third mesa portions 108 on one side in the first direction X are on the same straight line in the second direction Y. The end portions of the plurality of third mesa portions 108 on the other side in the first direction X are on the same straight line in the second direction Y.

As described above, in the first dummy trench structure 92, the second electric field relaxation layer 103 is formed at the bottom portion of the first dummy trench 100. By relaxing the electric field with respect to the bottom wall of the first dummy trench structure 92 by the second electric field relaxation layer 103, electric field concentration can be suppressed, and the withstand voltage of the first dummy trench structure 92 can be improved. Therefore, the first dummy trench structure 92 has a high withstand voltage. In the first dummy formation region 81 (the dummy formation region 80), the withstand voltage of the region in a vicinity of the first dummy trench structure 92 is high, and the withstand voltage decreases as the distance from the first dummy trench structure 92 increases.

Also, as described above, in the second dummy trench structure 93, the third electric field relaxation layer 113 is formed at the bottom portion of the second dummy trench 110. By relaxing the electric field with respect to the bottom wall of the second dummy trench structure 93 by the third electric field relaxation layer 113, electric field concentration can be suppressed, and the withstand voltage of the second dummy trench structure 93 can be improved. Therefore, the second dummy trench structure 93 has a high withstand voltage. In the first dummy formation region 81 (the dummy formation region 80), a region in a vicinity of the second dummy trench structure 93 has a high withstand voltage. In the first dummy formation region 81 (the dummy formation region 80), the withstand voltage of the region in the vicinity of the second dummy trench structure 93 is high, and the withstand voltage decreases as the distance from the second dummy trench structure 93 increases.

A configuration in which the first dummy trench structure 92 is divided in the first direction X in the middle of the first dummy trench structure 92 and the second dummy trench structure 93 is not disposed will be examined. In this case, the terminal portions of the two first dummy band-shaped structures 94 face each other with a facing interval in the first direction X.

The first dummy band-shaped structures 94 need to be electrically separated from the connection wiring structure 35 such that the first dummy trench structure 92 does not contribute to the formation of the channel. Therefore, the terminal portions of the two first dummy band-shaped structures 94 face each other with a wide facing interval in the first direction X. In this case, in the first dummy formation region 81 (the dummy formation region 80), there is a possibility that a region where the withstand voltage is significantly reduced is formed in a wide range in a region between the first dummy band-shaped structures 94 or a region in a periphery thereof.

In this embodiment, in the middle of the first dummy trench structure 92, the second dummy trench structure 93 extending side by side with the trench gate structure 11 and electrically separated from the first dummy trench structure 92 is formed. As described above, the withstand voltage of the second dummy trench structure 93 is high. Therefore, in a region between the two first dummy band-shaped structures 94 and a region in a periphery thereof, it is possible to reduce the region where the withstand voltage is significantly reduced. Thereby, in the first dummy formation region 81 (the dummy formation region 80), it is possible to reduce the region where the withstand voltage is significantly reduced.

Also, as described above, the first dummy trench structure 92 is a floating trench structure. Thereby, the capacitance of the first dummy trench structure 92 can be reduced. That is, it is possible to achieve both a reduction in the capacitance of the first dummy trench structure 92 and an improvement in the withstand voltage of the first dummy formation region 81 (the dummy formation region 80).

The second dummy trench structure 93 according to the first configuration example (FIG. 13A) has been described above. Next, a second dummy trench structure 93A according to a second configuration example (FIG. 13B) will be described with reference to FIG. 13B. The second dummy trench structure 93A is used instead of the second dummy trench structure 93. A plurality of (for example, three) the second dummy trench structures 93A are provided.

The second dummy trench structure 93A is different from the second dummy trench structures 93 according to the first configuration example (FIG. 13A) in that the terminal portions (a third terminal portion 243, a fourth terminal portion 244, a fifth terminal portion 245, and a sixth terminal portion 246) of the plurality of second dummy trench structures 93A are disposed shifted in regard to the first direction X.

Referring to FIG. 13B, similarly to the first configuration example (FIG. 13A), the first dummy trench structure 92 is divided in the first direction X by the second dummy trench structure 93A. The second dummy trench structure 93A is electrically connected to the connection wiring structure 35.

The second dummy trench structure 93A includes a long trench structure 241 and a short trench structure 242. The long trench structure 241 has the second trench length L2. The short trench structure 242 has a third trench length L3 shorter than the second trench length L2 (L3 < L2). The long trench structure 241 and the short trench structure 242 are alternately disposed in the second direction Y. The long trench structure 241 and the short trench structure 242 are opposed in the second direction Y.

The long trench structure 241 has the third terminal portion 243 and the fourth terminal portion 244. The second trench length L2 is shorter than the length of one first dummy band-shaped structure 94 in the first direction X. The second trench length L2 is wider than the connection width W1 of the connection wiring layer 130. The third terminal portion 243 is, with respect to the connection wiring layer 130, disposed at an interval from one side (the second side surface 5B side) in the first direction X in plan view. The fourth terminal portion 244 is, with respect to the connection wiring layer 130, disposed at an interval from the other side (the fourth side surface 5D side) in the first direction X in plan view. In this embodiment, the second trench length L2 is shorter than the length LC (FIG. 14) of the facing contact region 57A in the first direction X. The second trench length L2 is shorter than the length LB (FIG. 14) of the facing body portion 59A in the first direction X.

The short trench structure 242 has the fifth terminal portion 245 and the sixth terminal portion 246. The third trench length L3 is shorter than the length of one first dummy band-shaped structure 94 in the first direction X. The second trench length L2 is wider than the connection width W1 of the connection wiring layer 130. The fifth terminal portion 245 is, with respect to the connection wiring layer 130, disposed at an interval from one side (the second side surface 5B side) in the first direction X in plan view. The sixth terminal portion 246 is, with respect to the connection wiring layer 130, disposed at an interval from the other side (the fourth side surface 5D side) in the first direction X in plan view. In this embodiment, the third trench length L3 is shorter than the length LC (FIG. 14) of the facing contact region 57A in the first direction X. The third trench length L3 is shorter than the length LB (FIG. 14) of the facing body portion 59A in the first direction X.

A ratio of the third trench length L3 to the second trench length L2 may be not less than 0.1 and not more than 0.8. The ratio of the third trench length L3 to the second trench length L2 may have a value belonging to any one range among not less than 0.1 and not more than 0.2, not less than 0.2 and not more than 0.3, not less than 0.3 and not more than 0.4, not less than 0.4 and not more than 0.5, not less than 0.5 and not more than 0.6, not less than 0.6 and not more than 0.7, and not less than 0.7 and not more than 0.8. The ratio of the third trench length L3 to the second trench length L2 is preferably not less than 0.3 and not more than 0.6.

The third terminal portion 243 of the long trench structure 241 is shifted in the first direction X from the fifth terminal portion 245 of the short trench structure 242 adjacent to the long trench structure 241 in the second direction Y. The fourth terminal portion 244 of the long trench structure 241 is shifted in the first direction X from the sixth terminal portion 246 of the short trench structure 242 adjacent to the long trench structure 241 in the second direction Y.

The sixth terminal portions 246 of the two short trench structures 242 opposed in the second direction Y with the long trench structure 241 interposed therebetween are aligned in the first direction X. The sixth terminal portions 246 of the two short trench structures 242 opposed in the second direction Y with the long trench structure 241 interposed therebetween are aligned in the first direction X.

Referring to FIG. 13B, the second dummy trench structure 93A is disposed between the two first dummy band-shaped structures 94 adjacent in the first direction X at an interval from these two first dummy band-shaped structures 94. Therefore, the second dummy trench structure 93A is electrically separated (insulated) from the first dummy trench structure 92. The second dummy trench structure 93A is disposed at an interval I3 from the first dummy band-shaped structure 94 in the first direction X.

Referring to FIG. 13B, the second dummy trench structure 93A has the trench width WT3 in the second direction Y. The plurality of second dummy trench structures 93A are arrayed at intervals of the trench pitch PT3 in the second direction Y.

The interval I3 is narrower than the trench pitch PT3. The interval I3 is preferably not less than 0.5 times and less than 0.8 times the trench pitch PT3. The interval I3 is narrower than the trench pitch PT2. The interval I3 is preferably not less than 0.5 times and less than 0.8 times the trench pitch PT2. The interval I3 is narrower than the trench pitch PT1. The interval I3 is preferably not less than 0.5 times and less than 0.8 times the trench pitch PT1.

Referring to FIG. 13B, a fourth mesa portion 248 formed by a portion of the semiconductor layer 7 is formed between the first dummy band-shaped structure 94 and the second dummy trench structure 93A. In this embodiment, a width of the fourth mesa portion 248 in the first direction X is defined by the interval I3. In this embodiment, a plurality of the fourth mesa portions 248 are shifted in the first direction X.

Referring to FIG. 13B, a fifth mesa portion 249 formed by a portion of the semiconductor layer 7 is formed between the two second dummy trench structures 93A adjacent in the second direction Y. Also, the fifth mesa portion 249 formed by a portion of the semiconductor layer 7 is also formed between the second dummy trench structure 93A and the trench gate structure 11 adjacent in the second direction Y. The fifth mesa portion 249 extends in a band shape in the first direction X. A width of the fifth mesa portion 249 in the second direction Y is defined by the trench pitch PT3.

The width (the interval I3) of the fourth mesa portion 248 in the first direction X is narrower than the width (the trench pitch PT3) of the fifth mesa portion 249 in the second direction Y. The width (the interval I3) of the fourth mesa portion 248 in the first direction X is not less than 0.5 times and less than 0.8 times the width (the trench pitch PT3) of the fifth mesa portion 249 in the second direction Y.

The second dummy trench structure 93A has the structure equivalent to the second dummy trench structure 93 except for the length. That is, the second dummy trench structure 93A includes the second dummy trench 110, the second dummy insulating film 111, and the second dummy embedded body 112. Then, referring to FIG. 16B, the connection wiring layer 130 is in contact with the second dummy embedded body 112 of the second dummy trench structure 93A from above. Also, the third electric field relaxation layer 113 (FIG. 17) is formed in the second dummy trench 110 of the second dummy trench structure 93A. Therefore, the second dummy trench structure 93A has a high withstand voltage. In the first principal surface 3, the withstand voltage is high in a region in a vicinity of the second dummy trench structure 93A, and the withstand voltage significantly decreases as the distance from the second dummy trench structure 93A increases.

In the configuration example of FIG. 13B, the number of the long trench structures 241 is one, and the number of the short trench structures 242 is two. The second dummy trench structure 93A on the outermost side (opposite to the plurality of trench gate structures 11) is the short trench structure 242. The second dummy trench structure 93A on the innermost side (on the plurality of trench gate structures 11 side) is the short trench structure 242.

The number of the long trench structures 241 may be two, and the number of the short trench structures 242 may be one. In this case, the second dummy trench structure 93A on the outermost side (the side opposite to the plurality of trench gate structures 11) is the long trench structure 241, and the second dummy trench structure 93A on the innermost side (the plurality of trench gate structures 11 side) is the long trench structure 241.

The number of the second dummy trench structures 93A may be less than two or may be not less than four.

Also in the second configuration example (FIG. 13B), the same functions and effects equivalent to those in the first configuration example (FIG. 12 and FIG. 13A) are obtained. That is, in the middle of the first dummy trench structure 92, the second dummy trench structure 93A extending side by side with the trench gate structure 11 and electrically separated from the first dummy trench structure 92 is formed. As described above, the withstand voltage of the second dummy trench structure 93A is high. Therefore, in a region between the two first dummy band-shaped structures 94 and a region in a periphery thereof, it is possible to reduce the region where the withstand voltage is significantly reduced. Thereby, in the first dummy formation region 81 (the dummy formation region 80), it is possible to reduce the region where the withstand voltage is significantly reduced.

In the case of the first configuration example (FIG. 12 and FIG. 13A), when the first terminal portions 106 and the second terminal portions 107 of the plurality of second dummy trench structures 93 are respectively aligned in regard to the first direction X, in a region not facing the second dummy trench structure 93 or the first dummy band-shaped structure 94 in both the first direction X and the second direction Y (for example, a region R1 shown in FIG. 13A), among regions in peripheries of the first terminal portions 106 and the second terminal portions 107 of the second dummy trench structure 93, there is a possibility that a region having a significantly reduced withstand voltage will be generated.

Therefore, in the first configuration example (FIG. 12 and FIG. 13A), in a case of improving the withstand voltage in the first dummy formation region 81 (the dummy formation region 80), there are restrictions on the layout dimension such as the need to set the interval from the first dummy band-shaped structure 94 to be extremely narrow.

On the other hand, in the second configuration example (FIG. 13B), the terminal portions (the third terminal portion 243, the fourth terminal portion 244, the fifth terminal portion 245, and the sixth terminal portion 246) of the plurality of second dummy trench structures 93A are disposed shifted in regard to the first direction X. Therefore, even when the width (the interval I3) of the fourth mesa portion 248 in the first direction X is not set to be extremely narrow, a region in which the withstand voltage is significantly reduced as described above is not formed. Thereby, it is possible to reduce the region where the withstand voltage is significantly reduced in the first dummy formation region 81 (the dummy formation region 80) without restrictions on the layout dimension.

FIG. 13C is a plan view for describing the first dummy structure according to a third configuration example and is a view corresponding to FIG. 13B. FIG. 13D is a plan view for describing the first dummy structure according to a fourth configuration example and is a view corresponding to FIG. 13B. Both a third configuration example and a fourth configuration example are modification examples of the second configuration example (FIG. 13B).

In this embodiment, both the interval between the long trench structure 241 and the first dummy band-shaped structure 94 in the first direction X and the interval between the short trench structure 242 and the first dummy band-shaped structure 94 in the first direction X are the interval I3, and these intervals are the same. However, these intervals may be different.

In the third configuration example (FIG. 13C), an interval I31 between the long trench structure 241 and the first dummy band-shaped structure 94 in the first direction X is wider than an interval I32 between the short trench structure 242 and the first dummy band-shaped structure 94 in the first direction X (I31 > I32).

In the fourth configuration example (FIG. 13D), the interval I31 between the long trench structure 241 and the first dummy band-shaped structure 94 in the first direction X is narrower than the interval I32 between the short trench structure 242 and the first dummy band-shaped structure 94 in the first direction X (I31 < I32).

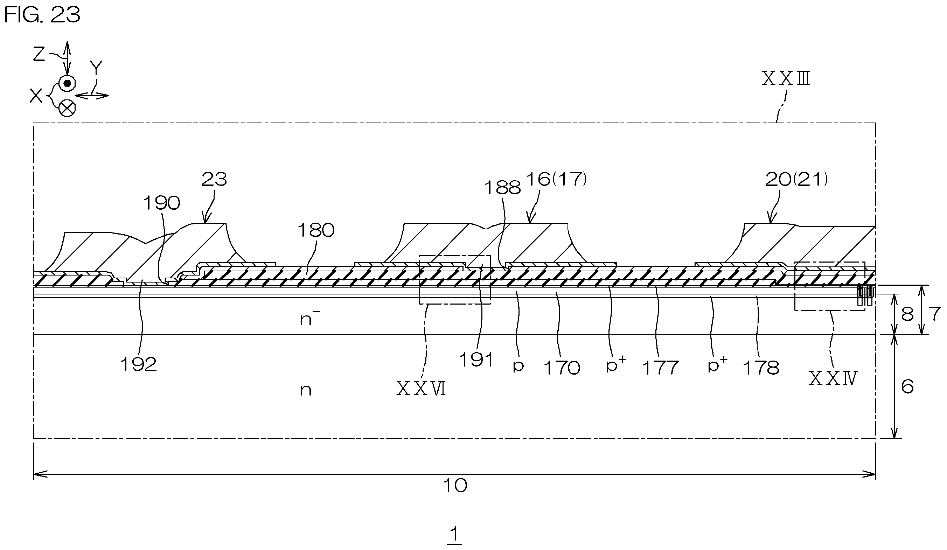

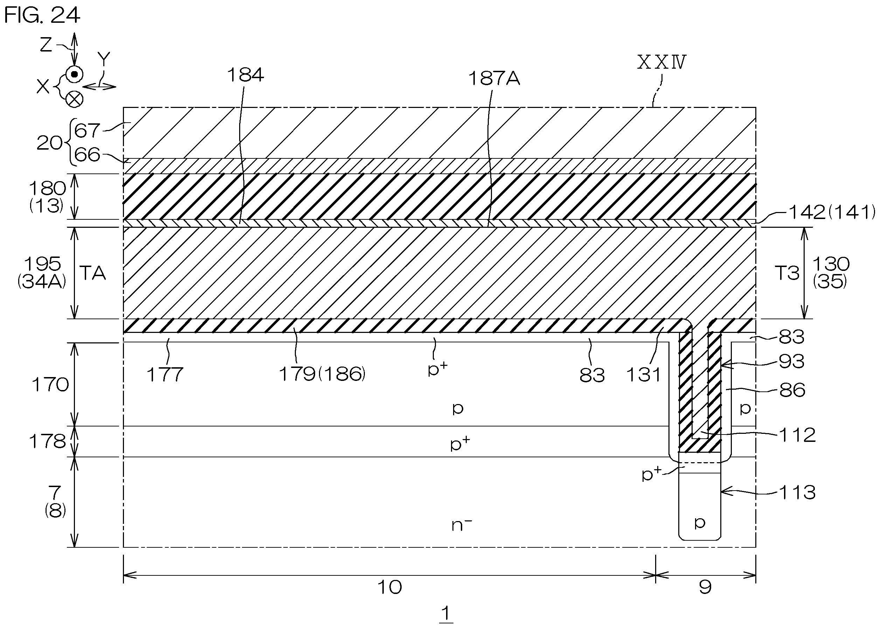

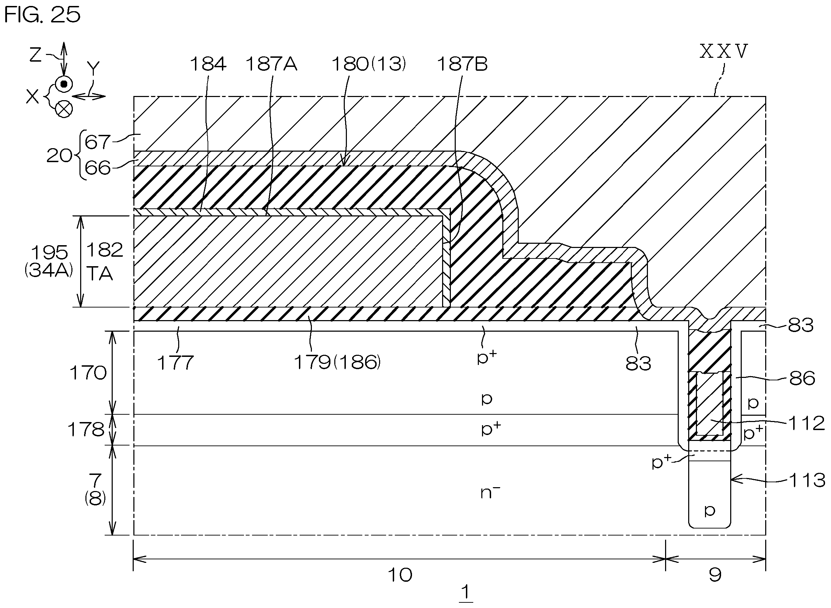

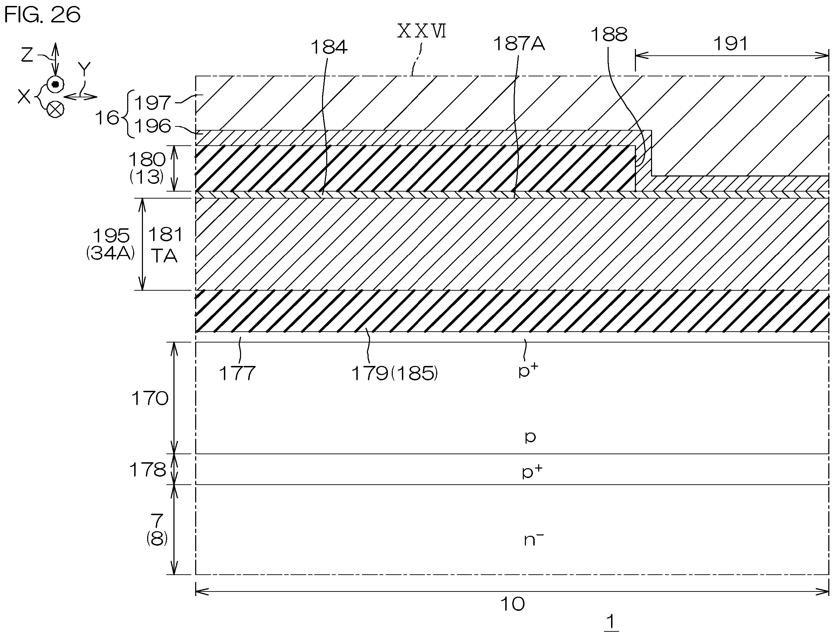

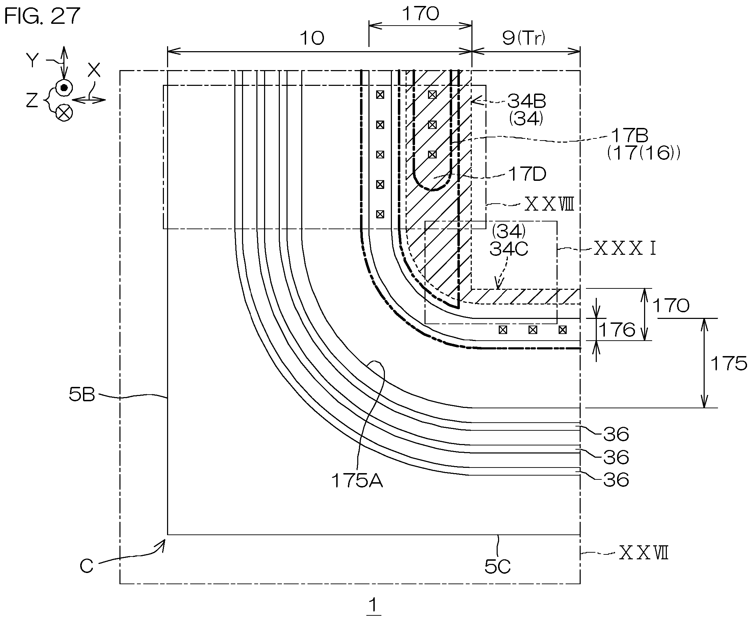

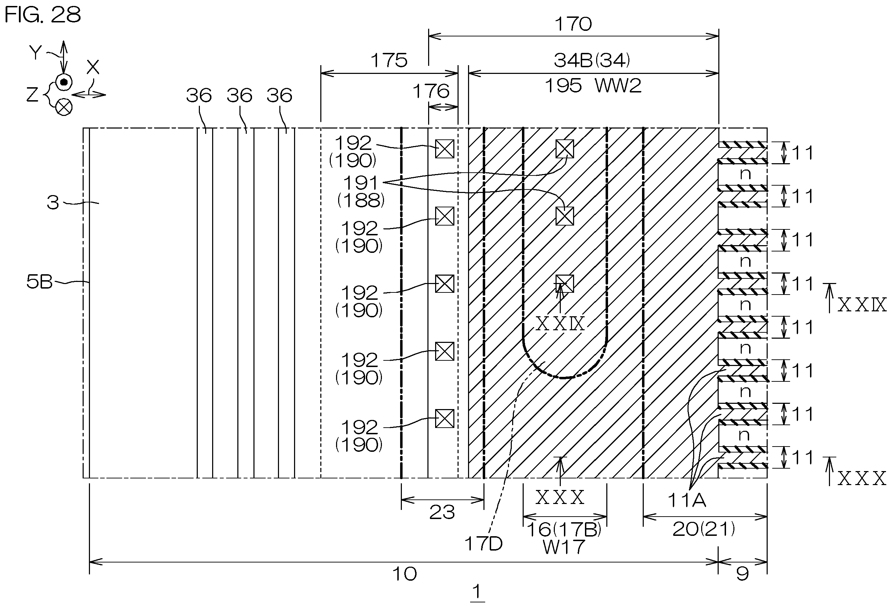

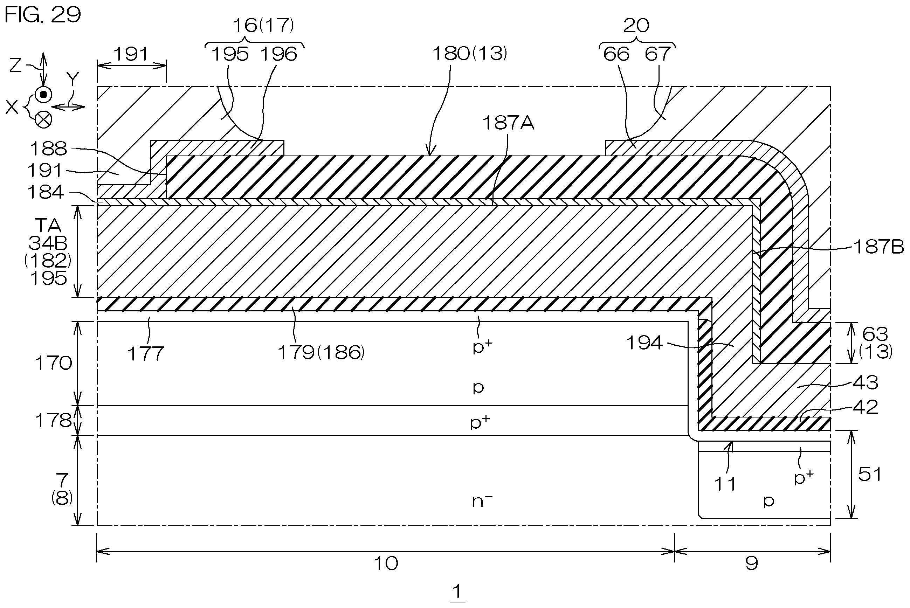

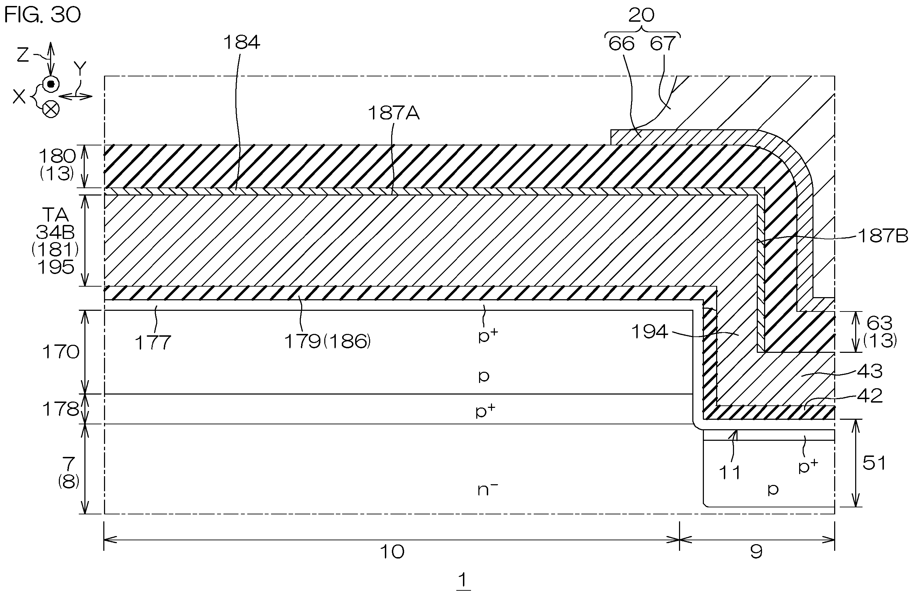

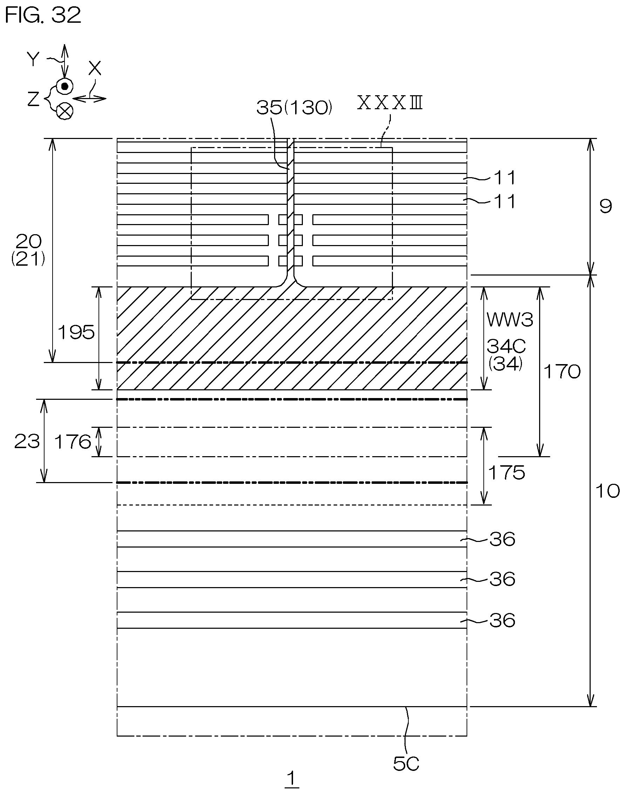

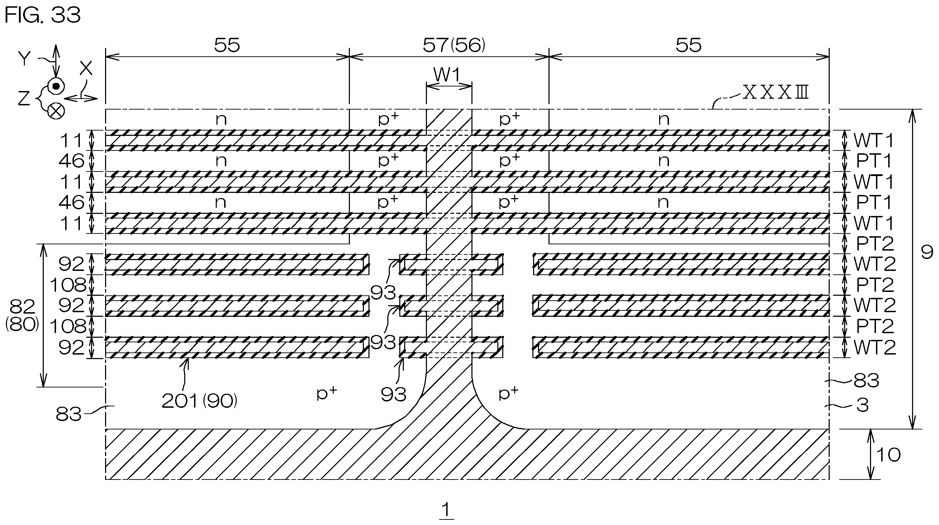

FIG. 23 is a sectional view taken along line XXIII-XXIII shown in FIG. 11. FIG. 24 is an enlarged view of a portion surrounded by an alternate long and short dashed line XXIV of FIG. 23. FIG. 25 is a sectional view taken along line XXV-XXV shown in FIG. 12. FIG. 26 is an enlarged view of a portion surrounded by an alternate long and short dashed line XXVI of FIG. 23. FIG. 27 is an enlarged view of a portion surrounded by an alternate long and short dashed line XXVII of FIG. 4. FIG. 28 is an enlarged view of a portion surrounded by an alternate long and short dashed line XXVIII of FIG. 27. FIG. 29 is a sectional view taken along line XXIX-XXIX shown in FIG. 28. FIG. 30 is a sectional view taken along line XXX-XXX shown in FIG. 28. FIG. 31 is an enlarged view of a portion surrounded by an alternate long and short dashed line XXXI of FIG. 27. FIG. 32 is an enlarged view of a portion surrounded by an alternate long and short dashed line XXXII of FIG. 5. FIG. 33 is an enlarged view of a portion surrounded by an alternate long and short dashed line XXXIII-XXXIII of FIG. 32.

Referring to FIG. 31 and FIG. 33, the dummy formation region 80 includes a second dummy formation region 82 disposed on the other side (the third side surface 5C side) in the second direction Y with respect to the plurality of trench gate structures 11. Also, the semiconductor device 1 includes a dummy structure 90. The dummy structure 90 includes the second dummy structure 201 formed in the second dummy formation region 82.

The second dummy structure 201 includes at least one (in this embodiment, a plurality) of the first dummy trench structures 92, a plurality of the second dummy trench structures 93 (FIG. 13A) disposed in the middle of the first dummy trench structure 92, and the two third dummy trench structures 202 disposed at a terminal portions of the first dummy trench structure 92. Hereinafter, the first dummy trench structure 92 and the second dummy trench structure 93 of the second dummy structure 201 have the same configuration as the first dummy trench structure 92 and the second dummy trench structure 93 (FIG. 13A) of the first dummy structure 91, and thus are denoted by the same reference signs, and description thereof is omitted.

FIG. 31 shows only the third dummy trench structure 202 on one side (the second side surface 5B side) in the first direction X among the two third dummy trench structures 202. The third dummy trench structure 202 faces the terminal portion of the first dummy trench structure 92. Specifically, the third dummy trench structure 202 is disposed at an interval I2 in the first direction X from the first dummy band-shaped structure 94 included in the first dummy trench structure 92. The third dummy trench structure 202 is disposed across the active region 9 and the outer peripheral region 10 on the first principal surface 3.

In this embodiment, the plurality of (for example, three) third dummy trench structures 202 have a seventh terminal portion 206 and an eighth terminal portion 207. The seventh terminal portion 206 faces the first dummy band-shaped structure 94 in the first direction X in the active region 9. The eighth terminal portion 207 is connected to the second structure 34B and the fourth structure 34D (the second structure 34B in the example of FIG. 31) of the peripheral wiring structure 34 in the outer peripheral region 10.

The seventh terminal portion 206 of the third dummy trench structure 202 is formed at an interval from the first dummy band-shaped structure 94. Therefore, the third dummy trench structure 202 is electrically separated (insulated) from the first dummy trench structure 92. That is, the first dummy trench structure 92 is electrically separated (insulated) from the second portions 17B and 18B of the gate wiring 16. Also, as described above, the first dummy trench structure 92 is electrically separated (insulated) from the connection wiring structure 35. By disposing the third dummy trench structure 202 at an interval from the terminal portion of the first dummy trench structure 92, the first dummy trench structure 92 can be maintained as a floating trench structure to which a potential is not applied.

The plurality of third dummy trench structures 202 have a fourth length L4 in the first direction X. The fourth length L4 is shorter than the length of one first dummy band-shaped structure 94 in the first direction X. In this embodiment, the fourth length L4 may be equivalent to the first trench length L1 (FIG. 13A) of the second dummy trench structure 93. The fourth length L4 may be longer than the first trench length L1 (FIG. 13A) or may be shorter than the first trench length L1 (FIG. 13A). In this embodiment, the third trench length L3 is shorter than the length LC (FIG. 14) of the facing contact region 57A in the first direction X. The third trench length L3 is shorter than the length LB (FIG. 14) of the facing body portion 59A in the first direction X.

The plurality of (for example, three) third dummy trench structures 202 are opposed in the second direction Y. The seventh terminal portions 206 of the plurality of third dummy trench structures 202 are aligned in the first direction X. The plurality of seventh terminal portions 206 are on the same straight line in the second direction Y. The eighth terminal portions 207 of the plurality of third dummy trench structures 202 are aligned in the first direction X. The plurality of eighth terminal portions 207 are on the same straight line in the second direction Y. Lengths of the plurality of third dummy trench structures 202 are the same.

Referring to FIG. 31, the third dummy trench structure 202 has a trench width WT4 in the second direction Y. The trench width WT4 is preferably substantially equal to the trench width WT2 described above. The trench width WT4 is preferably substantially equal to the trench width WT3 described above.

The plurality of third dummy trench structures 202 are arrayed at intervals of a trench pitch PT4 in the second direction Y. The trench pitch PT4 is preferably less than the thickness T2 of the semiconductor layer 7. The trench pitch PT4 is preferably substantially equal to the trench pitch PT3 described above. The trench pitch PT4 is preferably substantially equal to the trench pitch PT2 described above.

The interval I2 is narrower than the trench pitch PT4. The interval I2 is preferably not less than 0.5 times and less than 0.8 times the trench pitch PT4. The interval I2 is narrower than the trench pitch PT2. The interval I2 is preferably not less than 0.5 times and less than 0.8 times the trench pitch PT2. The interval I2 is narrower than the trench pitch PT1. The interval I2 is preferably not less than 0.5 times and less than 0.8 times the trench pitch PT1.

Referring to FIG. 31, a sixth mesa portion 208 formed by a portion of the semiconductor layer 7 is formed between the first dummy band-shaped structure 94 and the third dummy trench structure 202. A seventh mesa portion 209 formed by a portion of the semiconductor layer 7 is formed between the two third dummy trench structures 202 adjacent in the second direction Y.

The first dummy band-shaped structure 94 and the third dummy trench structure 202 are electrically and physically separated by the sixth mesa portion 208. The adjacent seventh mesa portions 209 are connected to each other by the sixth mesa portion 208. The sixth mesa portion 208 is aligned in regard to the first direction X. The end portions of the plurality of sixth mesa portions 208 on one side in the first direction X are on the same straight line in the second direction Y. The end portions of the plurality of sixth mesa portions 208 on the other side in the first direction X are on the same straight line in the second direction Y.

The third dummy trench structure 202 has the structure equivalent to the second dummy trench structure 93 except for the length. That is, the third dummy trench structure 202 includes a dummy trench (corresponding to the second dummy trench 110 (FIG. 17)), a dummy insulating film (corresponding to the second dummy insulating film 111 (FIG. 17)), and a dummy embedded body (corresponding to the second dummy embedded body 112 (FIG. 17)). Therefore, a detailed description of the third dummy trench structure 202 will be omitted.

The semiconductor device 1 includes a fourth electric field relaxation layer formed at the bottom portion of the third dummy trench structure 202. The fourth electric field relaxation layer has the configuration equivalent to the third electric field relaxation layer 113 (FIG. 17). The fourth electric field relaxation layer is formed at a bottom portion of the dummy trench over an entirety of the bottom portion of the dummy trench of the third dummy trench structure 202 in the depth direction, and is formed in a band shape extending in the depth direction of the dummy trench. By relaxing the electric field with respect to the bottom wall of the third dummy trench structure 202 by the fourth electric field relaxation layer, electric field concentration can be suppressed, and the withstand voltage of the third dummy trench structure 202 can be improved.

The second dummy structure 201 may include the second dummy trench structure 93A (FIG. 13B) of the second configuration example instead of the second dummy trench structure 93 (FIG. 13A) of the first configuration example. In this case, in this embodiment, the fourth length L4 may be equivalent to the third length L3 (FIG. 13B) of the short trench structure 242 of the second dummy trench structure 93A. The fourth length L4 may be longer than the third length L3 (FIG. 13B) or may be shorter than the third length L3 (FIG. 13B).

Referring to FIG. 11, FIG. 23, FIG. 27, FIG. 32, etc., the semiconductor device 1 includes an outer body region 170 of the p-type formed in the surface layer portion of the first principal surface 3 in the outer peripheral region 10. The outer body region 170 may have a p-type impurity concentration of not less than 1×10¹⁵ cm⁻³ and not more than 1×10¹⁸ cm⁻³ as a peak value. The outer body region 170 preferably has a p-type impurity concentration substantially equal to the p-type impurity concentration of the body region 40. As a matter of course, the p-type impurity concentration of the outer body region 170 may be less than the p-type impurity concentration of the body region 40, or may be higher than the p-type impurity concentration of the body region 40.

The outer body region 170 is formed at an interval toward the active region 9 side from the peripheral edge (the first to fourth side surfaces 5A to 5D) of the first principal surface 3, and extends in a band shape. In this embodiment, the outer body region 170 surrounds the active region 9 in plan view and is demarcated into a polygonal annular shape (in this embodiment, a quadrilateral annular shape) having four sides parallel to the peripheral edge of the first principal surface 3. That is, the outer body region 170 includes a region that forms a boundary portion between the active region 9 and the outer peripheral region 10.

The outer body region 170 has an inner edge portion on the active region 9 side and an outer edge portion on the peripheral edge side of the first principal surface 3. The inner edge portion of the outer body region 170 is connected to a plurality of the body regions 40 in a portion extending in the first direction X. Thereby, the outer body region 170 is electrically connected to the plurality of body regions 40.

The outer body region 170 is formed in the surface layer portion of the first principal surface 3. The outer body region 170 is formed at an interval toward the first principal surface 3 side from the bottom portion of the semiconductor layer 7, and faces the base layer 6 with a portion of the semiconductor layer 7 interposed therebetween. The outer body region 170 is preferably formed at an interval toward the first principal surface 3 side from the intermediate portion of the semiconductor layer 7.

Referring to FIG. 11, FIG. 27, FIG. 32, etc., the semiconductor device 1 includes a terminal region 175 of the p-type formed in the first principal surface 3 in the outer peripheral region 10. The terminal region 175 may be referred to as a "well region," a "terminal well region," etc. The terminal region 175 may have a p-type impurity concentration different from the p-type impurity concentration of the outer body region 170. The p-type impurity concentration of the terminal region 175 may be higher than the p-type impurity concentration of the outer body region 170. The p-type impurity concentration of the terminal region 175 may be lower than the p-type impurity concentration of the outer body region 170. As a matter of course, the p-type impurity concentration of the terminal region 175 may be substantially equal to the p-type impurity concentration of the outer body region 170.

In this embodiment, the terminal region 175 surrounds the outer body region 170 in plan view, and is demarcated into a polygonal annular shape (a quadrilateral annular shape in this embodiment) having four sides parallel to the peripheral edge (the first to fourth side surfaces 5A to 5D) of the first principal surface 3. As shown in FIG. 27, in this embodiment, the terminal region 175 has an arcuate corner portion 175A that connects a portion extending in the first direction X and a portion extending in the second direction Y in plan view in an arcuate shape (preferably a quarter arcuate shape).

The terminal region 175 is formed at an interval toward the first principal surface 3 side from the bottom portion of the semiconductor layer 7, and faces the base layer 6 with a portion of the semiconductor layer 7 interposed therebetween. The terminal region 175 is preferably formed at an interval toward the first principal surface 3 side from the intermediate portion of the semiconductor layer 7. The terminal region 175 may have a thickness (depth) substantially equal to a thickness (depth) of the outer body region 170.

Referring to FIG. 27, the terminal region 175 is formed in a region between the peripheral edge of the first principal surface 3 and the outer body region 170 at an interval inward from the peripheral edge (the first to fourth side surfaces 5A to 5D) of the first principal surface 3. The terminal region 175 extends in a band shape along the outer body region 170 in plan view. The terminal region 175 has a portion extending in a band shape in the first direction X and a portion extending in a band shape in the second direction Y in plan view, and demarcates the active region 9 in a plurality of directions.

Referring to FIG. 11, FIG. 27, FIG. 32, etc., the terminal region 175 has an inner edge portion on the active region 9 side and an outer edge portion on the peripheral edge side of the first principal surface 3. The inner edge portion of the terminal region 175 is connected to an outer edge portion of the outer body region 170. Thereby, the terminal region 175 is electrically connected to the outer body region 170. That is, in this embodiment, the terminal region 175 is electrically connected to the plurality of body regions 40 via the outer body region 170. In this embodiment, the inner edge portion of the terminal region 175 is connected to the outer edge portion of the outer body region 170 across an entire periphery.

Referring to FIG. 11, FIG. 27, FIG. 32, etc., the terminal region 175 (inner edge portion) has an overlap region 176 overlapping the outer edge portion of the outer body region 170. The overlap region 176 is a high concentration region including the outer edge portion of the outer body region 170 and the inner edge portion of terminal region 175. That is, the overlap region 176 includes both the p-type impurity of the outer body region 170 and the p-type impurity of the terminal region 175, and has a p-type impurity concentration higher than both the p-type impurity concentration of the outer body region 170 and the p-type impurity concentration of the terminal region 175.

The overlap region 176 extends in a band shape along the outer body region 170 in plan view. The overlap region 176 has a portion extending in a band shape in the first direction X and a portion extending in a band shape in the second direction Y in plan view. In this embodiment, the overlap region 176 is demarcated into a polygonal annular shape (a quadrilateral annular shape in this embodiment) having four sides parallel to the peripheral edge (the first to fourth side surfaces 5A to 5D) of the first principal surface 3.

The semiconductor device 1 may have a well region (176) of the p-type having a comparatively high concentration instead of the overlap region 176. In this case, the well region (176) has a p-type impurity concentration higher than both the p-type impurity concentration of the outer body region 170 and the p-type impurity concentration of the terminal region 175. The p-type impurity concentration of the well region (176) is higher than the p-type impurity concentration of the body region 40.

Referring to FIG. 24 to FIG. 26, FIG. 29, FIG. 30, etc., the semiconductor device 1 includes a second high concentration p-region 177 formed in the surface layer portion of the first principal surface 3 in the outer peripheral region 10. In this embodiment, the second high concentration p-region 177 is formed in the first principal surface 3. The second high concentration p-region 177 is formed such as to straddle the surface layer portion of the outer body region 170 and the surface layer portion of the terminal region 175 in the outer peripheral region 10.

The second high concentration p-region 177 is formed adjacent to the first high concentration p-region 83 in the second direction Y in the surface layer portion of the boundary portion between the body region 40 and the outer body region 170. The second high concentration p-region 177 is connected to the first high concentration p-region 83. The impurity concentration of the second high concentration p-region 177 may have a p-type impurity concentration of not less than 1×10¹⁹ cm⁻³ and not more than 1×10²⁰ cm⁻³ as a peak value. The second high concentration p-region 177 may have a p-type impurity concentration substantially equal to that of the first high concentration p-region 83. The second high concentration p-region 177 may have a depth substantially equal to the depth of the first high concentration p-region 83.

The semiconductor device 1 includes a third high concentration p-region 178 formed in the surface layer portion of the first principal surface 3 in the outer peripheral region 10. The third high concentration p-region 178 is embedded between the drift region 8 and the outer body region 170, and the terminal region 175 in the outer peripheral region 10. The third high concentration p-region 178 extends in a layer shape along the first principal surface 3. The third high concentration p-region 178 is connected to the outer body region 170, the terminal region 175, and the drift region 8.

The third high concentration p-region 178 may have a p-type impurity concentration of not less than 1×10¹⁹ cm⁻³ and not more than 1×10²⁰ cm⁻³ as a peak value. The third high concentration p-region 178 may have a p-type impurity concentration substantially equal to that of the first high concentration p-region 83. The third high concentration p-region 178 may have a p-type impurity concentration substantially equal to that of the second high concentration p-region 177. The withstand voltage (for example, breakdown voltage) can be improved by a depletion layer spreading with third high concentration p-region 178 as a starting point.

Referring to FIG. 17 and FIG. 18, the third high concentration p-region 178 is formed not only in the outer peripheral region 10 but also in a portion of the active region 9. Specifically, the third high concentration p-region 178 is formed in the first dummy formation region 81 of the active region 9.

As described above, the semiconductor device 1 includes the annular (specifically, substantially quadrangular annular) peripheral wiring structure 34 along the peripheral edge (the first to fourth side surfaces 5A to 5D) of the first principal surface 3. In FIG. 11, FIG. 28, FIG. 32, etc., the formation region of the peripheral wiring structure 34 is indicated by hatching for clarity.

Referring to FIG. 24, FIG. 29, etc., the peripheral wiring structure 34 includes a peripheral wiring layer 195 disposed on the first principal surface 3. The peripheral wiring layer 195 is disposed on the outer peripheral region 10. The peripheral wiring layer 195 is not disposed on the active region 9.

In this embodiment, the peripheral wiring layer 195 is a portion of the polysilicon wiring layer 33. When a polysilicon film covering the first principal surface 3 is formed by filling the trench 41 using a CVD method, a portion of the polysilicon film can be used to form the polysilicon wiring layer 33 (FIG. 4), and the peripheral wiring layer 195 can thereby be formed.

Thereby, the peripheral wiring structure 34 (the peripheral wiring layer 195) can be manufactured in the same step as the trench gate structure 11. Therefore, steps of the manufacturing process can be reduced as compared with a case in which the peripheral wiring structure 34 is formed of a material different from the trench gate structure 11. Also, in a case in which the peripheral wiring structure 34 is formed of polysilicon, manufacturing efficiency can be enhanced as compared with a case in which the peripheral wiring structure 34 is formed of another material.

Also, in this embodiment, the peripheral wiring structure 34 includes the peripheral wiring layer 195 formed on the first principal surface 3, and does not adopt a trench structure. When the peripheral wiring structure 34 is realized by the peripheral wiring layer 195, it can be easily formed using deposition and patterning of a material film. Thereby, the peripheral wiring structure 34 can be efficiently defined as compared with a case in which the peripheral wiring structure 34 is realized by the trench structure.

Referring to FIG. 24, FIG. 29, etc., the peripheral wiring layer 195 is disposed on a second insulating film 179 that selectively covers the first principal surface 3. The second insulating film 179 may include at least one among a silicon oxide film, a silicon nitride film, and a silicon oxynitride film. The second insulating film 179 may be referred to as a principal surface insulating film.

Referring to FIG. 4, the peripheral wiring structure 34 (that is, the peripheral wiring layer 195) has substantially the same thickness at each location of the peripheral wiring structure 34 (the first structure 34A, the second structure 34B, the third structure 34C, the fourth structure 34D, the fifth structure 34E, and the sixth structure 34F).

In other words, the first structure 34A, the second structure 34B, the third structure 34C, the fourth structure 34D, the fifth structure 34E, and the sixth structure 34F have the same thickness. Height positions of the upper surfaces of the first structure 34A, the second structure 34B, the third structure 34C, the fourth structure 34D, the fifth structure 34E, and the sixth structure 34F are the same. Depth positions of the bottom portions of the first structure 34A, the second structure 34B, the third structure 34C, the fourth structure 34D, the fifth structure 34E, and the sixth structure 34F are the same.

Referring to FIG. 24, FIG. 29, etc., a peripheral thickness TA of the peripheral wiring layer 195 may be not less than a thickness of the embedded body 43 of the trench gate structure 11. The peripheral thickness TA may be not less than the trench depth DT1 (FIG. 9) of the trench 41 of the trench gate structure 11. The peripheral thickness TA may be less than the trench depth DT1. The peripheral thickness TA of the peripheral wiring layer 195 may be the same as the connection thickness T3 (FIG. 24) of the connection wiring layer 130. The peripheral thickness TA of the peripheral wiring layer 195 may be not less than 2 µm and not more than 10 µm.

Referring to FIG. 11, FIG. 28, FIG. 32, etc., the peripheral wiring layer 195 (the peripheral wiring structure 34) is formed at an interval toward the active region 9 side from the peripheral edge (the first to fourth side surfaces 5A to 5D) of the first principal surface 3, and extends in a band shape along the active region 9.

Referring to FIG. 11, the first structure 34A as an example of a second structure portion extends in a band shape in the first direction X on one side (the first side surface 5A side) in the second direction Y with respect to the active region 9. The first structure 34A faces the outer body region 170 with the second insulating film 179 (FIG. 24, etc.) interposed therebetween. The first structure 34A does not face the terminal region 175.

Referring to FIG. 11, the first structure 34A overlaps the first portion 17A of the first gate wiring 17 and the first portion 18A of the second gate wiring 18 in plan view (In FIG. 11, only the first portion 17A is illustrated). A peripheral edge at an inner side of the first structure 34A is positioned further to the active region 9 side than the peripheral edge at inner sides of the first portion 17A and the first portion 18A. A peripheral edge at an outer side of the first structure 34A is positioned further to the peripheral edge of the first principal surface 3 side than the peripheral edge at the outer side of the first portion 17A and the peripheral edge at the outer side of the first portion 18A.

A first wiring width WW1 of the first structure 34A is wider than a wiring width of the gate wiring 16 (the first portion 17A and the first portion 18A). The first wiring width WW1 is wider than a wiring width of the source wiring 23. The first wiring width WW1 may be not less than 10 µm and not more than 100 µm.

Referring to FIG. 27 and FIG. 28, the second structure 34B as an example of the first wiring portion extends in a band shape in the second direction Y on one side (the second side surface 5B side) in the first direction X with respect to the active region 9. The second structure 34B overlaps the second portion 17B of the first gate wiring 17 in plan view. That is, the second structure 34B is formed below the second portion 17B of the first gate wiring 17. The second structure 34B faces the outer body region 170 with the second insulating film 179 (FIG. 29) interposed therebetween. The second structure 34B does not face the terminal region 175.

A peripheral edge at an inner side of the second structure 34B is positioned further to the active region 9 side than a peripheral edge at an inner side of the second portion 17B of the first gate wiring 17. A peripheral edge at an outer side of the second structure 34B is positioned further to the peripheral edge of the first principal surface 3 side than a peripheral edge at an outer side of the second portion 17B of the first gate wiring 17. A second wiring width (first width) WW2 of the second structure 34B is wider than a wiring width of the gate wiring 16 (the second portion 17B of the first gate wiring 17).

The second wiring width WW2 is wider than the wiring width of the source wiring 23. In this embodiment, the second wiring width WW2 of the second structure 34B is substantially equal to the first wiring width WW1. The second wiring width WW2 may be wider than the first wiring width WW1 or may be narrower than the first wiring width WW1. The second wiring width WW2 may be not less than 10 µm and not more than 100 µm.

Referring to FIG. 31, etc., the second structure 34B of the peripheral wiring structure 34 covers the terminal portion 11A of the trench gate structure 11 and the eighth terminal portion 207 of the third dummy trench structure 202 in the outer peripheral region 10 of the first principal surface 3. Thereby, the second structure 34B is electrically connected to the trench gate structure 11 and the third dummy trench structure 202.

Specifically, with reference to FIG. 29 and FIG. 30, the second structure 34B of the peripheral wiring structure 34 includes connection wiring portions 194 connected to the embedded body 43 at the terminal portions of the plurality of trench gate structures 11. The connection wiring portion 194 extends in the vertical direction Z and connects a peripheral edge at an inner side of the peripheral wiring layer 195 and the embedded body 43 at the terminal portions of the plurality of trench gate structures 11.

Referring to FIG. 27, the third structure 34C as an example of a second wiring portion extends in a band shape in the first direction X on the other side (the third side surface 5C side) in the second direction Y with respect to the active region 9. Both terminal portions of the third structure 34C are connected to the second structure 34B and the fourth structure 34D, respectively (in FIG. 27, only the second structure 34B is illustrated.).

The third structure 34C extends along the third side surface 5C in plan view from the end portion of the second structure 34B on the third side surface 5C side. In other words, the third structure 34C extends along the third side surface 5C from the terminal portion 18D (FIG. 3) of the second portion 18B of the second gate wiring 18 in plan view.

Referring to FIG. 32, the third structure 34C faces the outer body region 170 with the second insulating film 179 (FIG. 29) interposed therebetween. The third structure 34C does not face terminal region 175.

Referring to FIG. 31, in this embodiment, a third wiring width (second width) WW3 of the third structure 34C is narrower than the first wiring width WW1 (FIG. 11) (WW3 < WW1). The third wiring width WW3 is narrower than the second wiring width WW2 (WW3 < WW2). The third wiring width WW3 is narrower than a wiring width W17 (FIG. 28) of the second portion 17B of the first gate wiring 17 and a wiring width W18 (FIG. 3) of the second portion 18B of the second gate wiring 18. The third wiring width WW3 may be substantially equal to the wiring widths W17 and W18 of the second portion 18B, and may be wider than the wiring widths W17 and W18 of the second portion 18B. The third wiring width WW3 is narrower than the wiring width of the source wiring 23.

The third wiring width WW3 may be not less than 0.1 times and 0.8 times the second wiring width WW2. The third wiring width WW3 may have a value belonging to any one range among not less than 0.1 times and not more than 0.2 times, not less than 0.2 times and not more than 0.3 times, not less than 0.3 times and not more than 0.4 times, not less than 0.4 times and not more than 0.5 times, not less than 0.5 times and not more than 0.6 times, and not less than 0.6 times and not more than 0.8 times of the second wiring width WW2 (a fourth wiring width WW4). The third wiring width WW3 is preferably not less than 0.3 times and not more than 0.6 times the second wiring width WW2.

Although unillustrated, the fourth structure 34D (FIG. 4) of the peripheral wiring structure 34 covers the terminal portion 11A of the trench gate structure 11 and the eighth terminal portion 207 of the third dummy trench structure 202 in the outer peripheral region 10 of the first principal surface 3. Thereby, the fourth structure 34D is electrically connected to the trench gate structure 11 and the third dummy trench structure 202.

Referring to FIG. 4, the fourth structure 34D as an example of the first wiring portion extends in a band shape in the second direction Y on the other side (the fourth side surface 5D side) in the first direction X with respect to the active region 9. Although unillustrated, the fourth structure 34D overlaps the second portion 18B (FIG. 3) of the second gate wiring 18 in plan view.

The fourth structure 34D has a line symmetrical shape with respect to the second structure 34B about a center line (not illustrated) extending in the second direction Y passing through the center of the active region 9. Therefore, the detailed illustration of the fourth structure 34D is omitted, and the description of a second structure 32B is incorporated.

For the sake of completeness, the structure of the fourth structure 34D will be described just in case. Referring to FIG. 4, the fourth structure 34D is formed below the second portion 18B (FIG. 3) of the second gate wiring 18. The fourth structure 34D faces the outer body region 170 with the second insulating film 179 (FIG. 29) interposed therebetween. The fourth structure 34D does not face the terminal region 175 (FIG. 28).

Referring to FIG. 4, a peripheral edge at an inner side of the fourth structure 34D is positioned further to the active region 9 side than a peripheral edge at an inner side of the second portion 18B (FIG. 3) of the second gate wiring 18. A peripheral edge at an outer side of the fourth structure 34D is positioned further to the peripheral edge of the first principal surface 3 side than a peripheral edge at an outer side of the second portion 18B of the second gate wiring 18. The fourth wiring width WW4 of the fourth structure 34D is wider than the wiring width W18 (FIG. 3) of the gate wiring 16 (the second portion 18B of the second gate wiring 18).

Referring to FIG. 4, the fourth wiring width (first width) WW4 is wider than the wiring width of the source wiring 23. In this embodiment, the fourth wiring width WW4 is wider than the third wiring width WW3 (FIG. 31) (WW4 > WW3). The fourth wiring width WW4 is substantially equal to the first wiring width WW1 (FIG. 11) (WW4=WW1). The fourth wiring width WW4 may be wider than the first wiring width WW1 or may be narrower than the first wiring width WW1. The fourth wiring width WW4 is substantially equal to the second wiring width WW2 (FIG. 31) (WW4=WW2). The fourth wiring width WW4 may be wider than the second wiring width WW2 or may be narrower than the second wiring width WW2. The fourth wiring width WW4 may be not less than 10 µm and not more than 100 µm.

Referring to FIG. 25, FIG. 26, etc., the peripheral wiring layer 195 includes an upper wiring layer 181 and a lower wiring layer 182 having different depth positions in the vertical direction Z. The lower wiring layer 182 is disposed on the active region 9 side, and the upper wiring layer 181 is disposed on the end surface side of the chip 2. The upper wiring layer 181 and the lower wiring layer 182 are each of a flat shape extending in the first direction X and the second direction Y. The peripheral wiring layer 195 includes a connection wiring that electrically and mechanically connects the upper wiring layer 181 and the lower wiring layer 182. The connection wiring extends in the vertical direction Z and connects a peripheral edge at an outer side of the lower wiring layer 182 and a peripheral edge at an inner side of the upper wiring layer 181.

As described above, in the outer peripheral region 10, the second insulating film 179 is disposed below the peripheral wiring layer 195. The second insulating film 179 includes a thick film 185 disposed under the upper wiring layer 181 and a thin film 186 formed under the lower wiring layer 182. The thin film 186 is thinner than the thick film 185. The thin film 186 may have the same thickness as the first insulating film 131. Referring to FIG. 24, the thin film 186 is connected to the first insulating film 131 at a boundary portion between the outer peripheral region 10 and the active region 9.

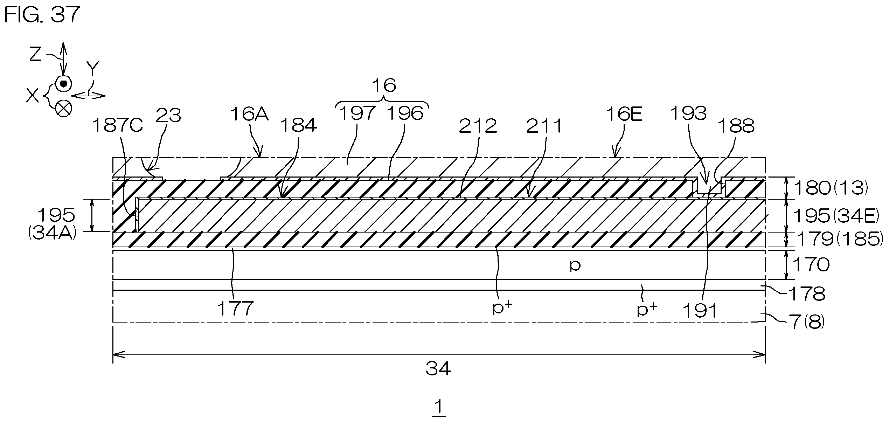

Referring to FIG. 25, FIG. 26, etc., the semiconductor device 1 includes a second silicide layer 184 formed on the surface of the peripheral wiring layer 195. The second silicide layer 184 covers an upper surface 187A, an inner side surface 187B, and an outer side surface 187C (FIG. 37) of the peripheral wiring layer 195. The second silicide layer 184 is a polyside portion obtained by silicidation of polysilicon of the peripheral wiring layer 195. The second silicide layer 184 may be referred to as a "second metal semiconductor compound layer," a "second silicide layer (polyside layer)," a "second silicide region (polyside region)," etc.

The second silicide layer 184 includes a first covering layer covering the upper surface 187A of the peripheral wiring layer 195, a second covering layer covering the inner side surface 187B,of the peripheral wiring layer 195, and a third covering layer covering the outer side surface 187C (FIG. 37) of the peripheral wiring layer 195. The first covering layer of the second silicide layer 184 covers an entire area of the upper surface 187A of the peripheral wiring layer 195. The peripheral edge at an inner side of the first covering layer of the second silicide layer 184 is exposed to the inner side surface 187B of the peripheral wiring layer 195.

The second covering layer of the second silicide layer 184 covers an entire area of the inner side surface 187B of the peripheral wiring layer 195. An upper end of the second covering layer of the second silicide layer 184 is exposed to the upper surface 187A of the peripheral wiring layer 195. The third covering layer of the second silicide layer 184 covers an entire area of the outer side surface 187C (FIG. 37) of the peripheral wiring layer 195. An upper end of the third covering layer of the second silicide layer 184 is exposed to the upper surface 187A of the peripheral wiring layer 195.

The second silicide layer 184 may contain at least one of Ti silicide, Ni silicide, Co silicide, Mo silicide, and W silicide. The second silicide layer 184 is preferably constituted of Ti silicide, Ni silicide, or Co silicide. A thickness of the second silicide layer 184 may be of a flat shape along the surface (the upper surface 187A, the inner side surface 187B, and the outer side surface 187C) of the peripheral wiring layer 195.

As described above, the semiconductor device 1 includes the insulating layer 13. Referring to FIG. 24, FIG. 29, etc., the insulating layer 13 includes a third interlayer insulating layer 180 covering the outer peripheral region 10. The third interlayer insulating layer 180 may be referred to as an "insulating film," an "interlayer film," an "intermediate insulating film," etc. The third interlayer insulating layer 180 may include at least one among a silicon oxide film, a silicon nitride film, and a silicon oxynitride film. The third interlayer insulating layer 180 may have a laminated structure. The third interlayer insulating layer 180 may have a single layer structure.

Referring to FIG. 24, FIG. 29, etc., the third interlayer insulating layer 180 covers an upper side, an inner side, and an outer side of the peripheral wiring layer 195. That is, the third interlayer insulating layer 180 covers an upper surface 187A and the inner side surface 187B of the peripheral wiring layer 195 via the second silicide layer 184. Although unillustrated, the third interlayer insulating layer 180 collectively covers the outer body region 170, the terminal region 175, and a plurality of the field regions 36 in the outer peripheral region 10.

The semiconductor device 1 includes at least one (in this embodiment, a plurality) of gate openings 188 formed in the third interlayer insulating layer 180 in the outer peripheral region 10. Referring to FIG. 23, FIG. 26, etc., a plurality of gate openings 188 are formed in a portion covering the peripheral wiring layer 195 in the third interlayer insulating layer 180. The plurality of gate openings 188 penetrate through the third interlayer insulating layer 180 and expose the upper surface 187A of the peripheral wiring layer 195 via the second silicide layer 184.

Referring to FIG. 11 and FIG. 28, the plurality of gate openings 188 are formed at intervals along the peripheral wiring structure 34 (the peripheral wiring layer 195). The plurality of gate openings 188 may be formed in a quadrangular shape (square shape), a rectangular shape, a hexagonal shape, a circular shape, etc., in plan view. The plurality of gate openings 188 may be formed in a band shape extending along the peripheral wiring structure 34 in plan view. The semiconductor device 1 may have the single gate opening 188. The single gate opening 188 may be formed in a band shape extending along the peripheral wiring structure 34.

Referring to FIG. 11 and FIG. 28, the semiconductor device 1 includes at least one (in this embodiment, a plurality) of outer openings 190 formed in the third interlayer insulating layer 180 in the outer peripheral region 10. The plurality of outer openings 190 are formed in a portion covering the terminal region 175 in the third interlayer insulating layer 180. The plurality of outer openings 190 penetrate through the third interlayer insulating layer 180 to expose the terminal region 175. In this embodiment, the plurality of outer openings 190 are formed in a portion covering the overlap region 176 of the terminal region 175 in the third interlayer insulating layer 180 and expose the overlap region 176. The plurality of outer openings 190 may expose the outer body region 170 instead of or in addition to the terminal region 175 (the overlap region 176).

Referring to FIG. 11 and FIG. 28, the plurality of outer openings 190 are formed at intervals along the terminal region 175 (the overlap region 176). The plurality of outer openings 190 may be formed in a quadrangular shape (square shape), a rectangular shape, a hexagonal shape, a circular shape, etc., in plan view. The plurality of outer openings 190 may be formed in a band shape extending along the terminal region 175 (the overlap region 176) in plan view.

The semiconductor device 1 may have the single outer opening 190. The single outer opening 190 may be formed in a band shape extending along the terminal region 175 (the overlap region 176). The single outer opening 190 may have a portion extending in a band shape in the first direction X and a portion extending in a band shape in the second direction Y in plan view.

The gate wiring 16 is selectively routed on the third interlayer insulating layer 180, and transmits the gate potential to the peripheral wiring structure 34. The gate wiring 16 is routed on a portion of the third interlayer insulating layer 180 covering the peripheral wiring structure 34 (that is, on the outer peripheral region 10), and is electrically connected to the peripheral wiring structure 34 (the peripheral wiring layer 195) via the plurality of gate openings 188.

The gate wiring 16 is formed on the first principal surface 3 such as to cover the third interlayer insulating layer 180. Referring to FIG. 26, the gate wiring 16 has a laminated structure including a barrier layer 196 and a main body layer 197 laminated in that order from the first principal surface 3 side.

The barrier layer 196 is formed in a film shape along the first principal surface 3. The barrier layer 196 is in contact with the second high concentration p-region 177. The barrier layer 196 may include at least one among a Ti layer, a Pd layer, a Cr layer, a V layer, a Mo layer, a W layer, a Pt layer, and a Ni layer. A thickness of the barrier layer 196 may be not less than 0.05 µm and not more than 0.3 µm. A thickness of the barrier layer 196 is preferably not less than 0.1 µm and not more than 0.2 µm.

Referring to FIG. 26, the main body layer 197 is formed on the barrier layer 196. The main body layer 197 covers an entire area of the principal surface of the barrier layer 196. A thickness of the main body layer 197 exceeds the thickness of the barrier layer 196. The thickness of the barrier layer 196 may be not less than 1 µm and not more than 10 µm. The thickness of the main body layer 197 is preferably not less than 3 µm and not more than 6 µm.

Referring to FIG. 26, the gate wiring 16 (the first gate wiring 17, the second gate wiring 18) is disposed such as to face the peripheral wiring layer 195 with the third interlayer insulating layer 180 interposed therebetween, and extends in a band shape along the peripheral wiring layer 195. The gate wiring 16 (the first gate wiring 17, the second gate wiring 18) collectively covers a region of the third interlayer insulating layer 180 where the plurality of gate openings 188 are formed in a film shape.

Referring to FIG. 26, the gate wiring 16 includes a plurality of first connection electrode portions 191 that enter into the plurality of gate openings 188 and are connected to the peripheral wiring layer 195. The plurality of first connection electrode portions 191 correspond to the plurality of gate openings 188 on a one-to-one basis. The first connection electrode portions 191 have a portion covering the second silicide layer 184 of the peripheral wiring layer 195 in a film shape at the bottom portion of each gate opening 188, and are mechanically and electrically connected to the second silicide layer 184.

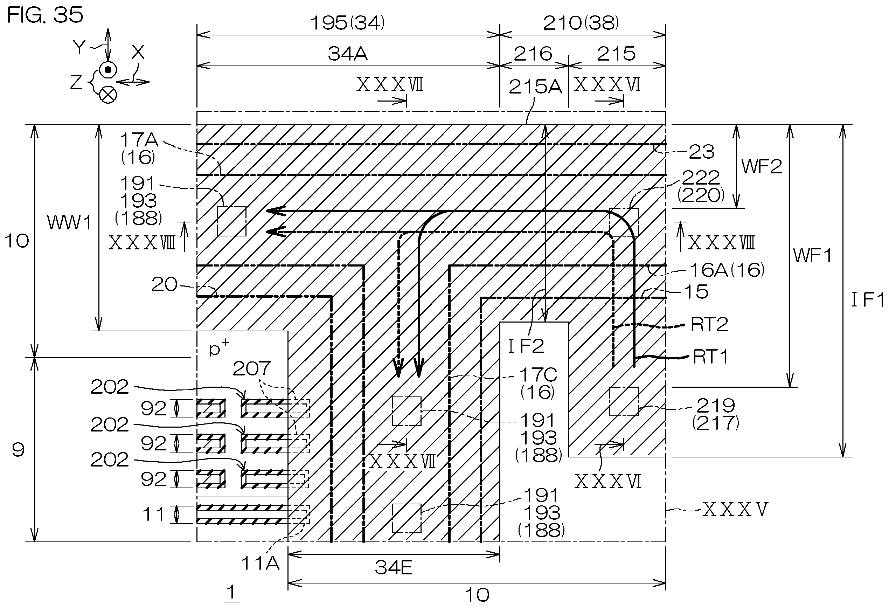

In this embodiment, the plurality of first connection electrode portions 191 are formed in the first structure 34A, the second structure 34B, the fourth structure 34D, and the fifth structure 34E (FIG. 35) in the peripheral wiring structure 34.

As described above, the semiconductor device 1 includes the source wiring 23. The source wiring 23 is led out from above the third interlayer insulating layer 180 onto the terminal region 175, and is electrically connected to the terminal region 175 via the plurality of outer openings 190. The source wiring 23 transmits the source potential applied to the source pad 20 to the terminal region 175. The source wiring 23 extends in a band shape along terminal region 175 (the overlap region 176).

Referring to FIG. 23, the source wiring 23 has a plurality of second connection electrode portions 192 that enter into the plurality of outer openings 190. The plurality of second connection electrode portions 192 correspond to the plurality of outer openings 190 on a one-to-one basis. The second connection electrode portions 192 cover the first principal surface 3 in a film shape at a bottom portion of the outer openings 190, and are electrically connected to the first principal surface 3 (the chip 2).

Referring to FIG. 11 and FIG. 28, the second connection electrode portions 192 are electrically connected to the terminal region 175 (the overlap region 176) at the bottom portion of the outer openings 190.

Referring to FIG. 27, in this embodiment, the first gate wiring 17 and the second gate wiring 18 have the terminal portions 17D and 18D at the corner portion C of the chip 2. Therefore, the first gate wiring 17 and the second gate wiring 18 do not have a portion extending along the third side surface 5C from the terminal portions 17D and 18D of the second portions 17B and 18B. When the portion extending along the third side surface 5C is provided, it is necessary to bend the first gate wiring 17 and the second gate wiring 18 at the corner portion C of the chip 2.

Between the first gate wiring 17 and the second gate wiring 18 constituted of a metal wiring, and an insulating film such as the upper insulating film 25, there is a difference in linear expansion coefficient. When bent portions of the first gate wiring 17 and the second gate wiring 18 are present at the corner portion C of the chip 2, the insulating film may be damaged due to the difference in the deformation amount between the bent portions and the insulating film.

On the other hand, in this embodiment, since it is not necessary to bend the first gate wiring 17 and the second gate wiring 18 at the corner portion C of the chip 2, the occurrence of such a problem can be avoided.

Also, in this embodiment, the terminal portions 17D and 18D of the gate wiring 16 (the first gate wiring 17 and the second gate wiring 18) are not disposed in the region between the peripheral edge of the active region 9 on the third side surface 5C side and the third side surface 5C of the chip 2. More specifically, referring to FIG. 27, terminal portions 17D and 18D of the gate wiring 16 (the first gate wiring 17 and the second gate wiring 18) are retracted to the first side surface 5A side (the side opposite to the third side surface 5C side (second end surface)) such as not to face an arcuate corner portion 45A in the first direction X in plan view at the corner portion C of the chip 2.

Therefore, the peripheral edge of the active region 9 on the third side surface 5C side can be disposed close to the third side surface 5C side. Thereby, an area ratio of the active region 9 to an entirety of the chip 2 can be increased. The in-plane space of the chip 2 can be effectively utilized, and the loss can be reduced.

Also, in this embodiment, as described above, the third wiring width WW3 is narrower in comparison to the first wiring width WW1, the second wiring width WW2, and the fourth wiring width WW4 (WW3 < WW1, WW3 < WW2, WW3 < WW4). Therefore, the peripheral edge of the active region 9 on the third side surface 5C side can be disposed even more closer to the third side surface 5C side. Thereby, an area ratio of the active region 9 to an entirety of the first principal surface 3 can be more effectively increased.

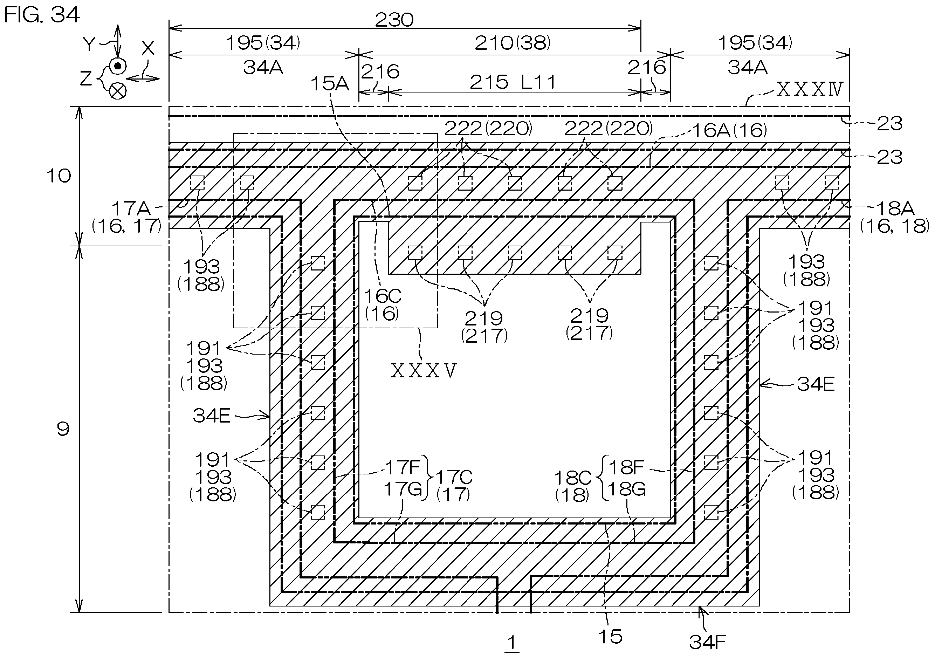

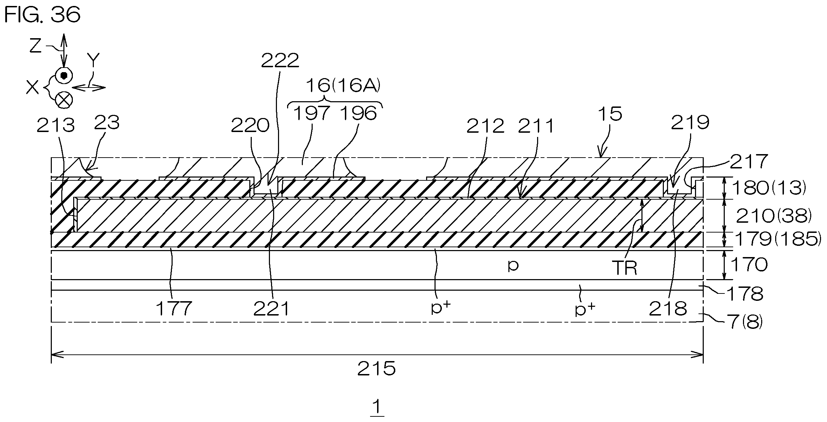

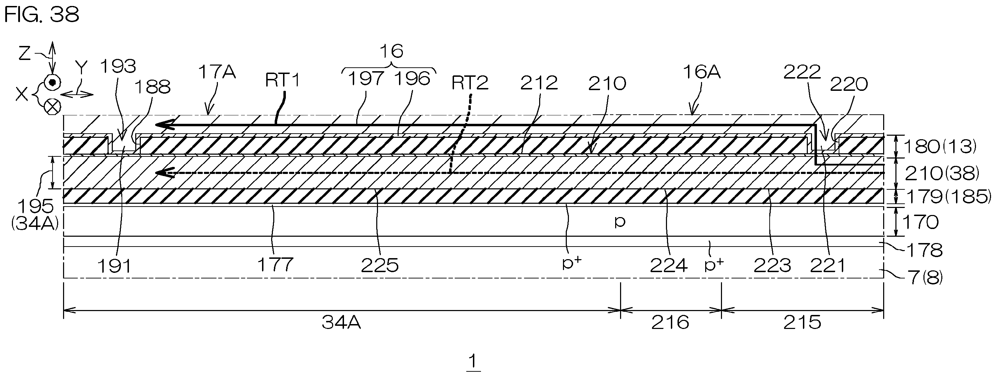

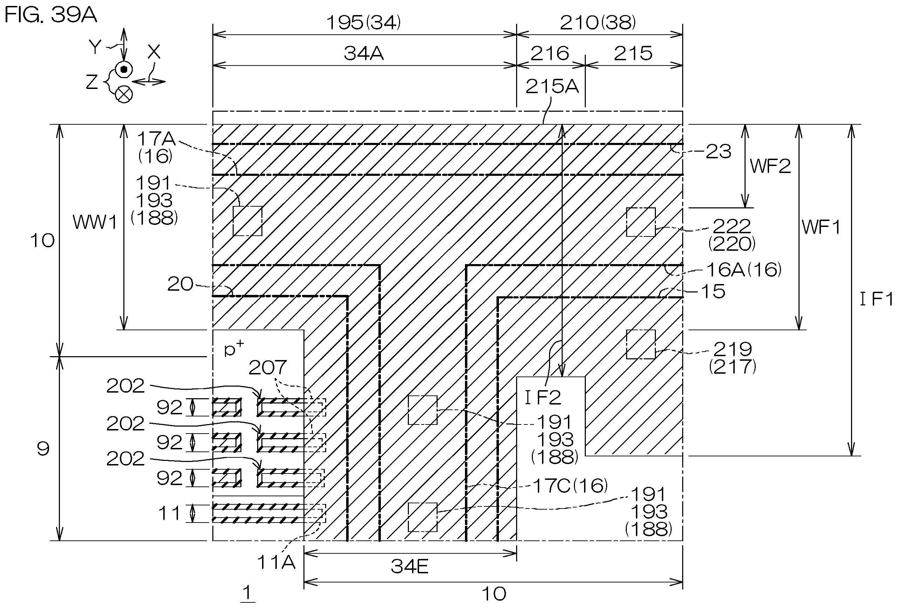

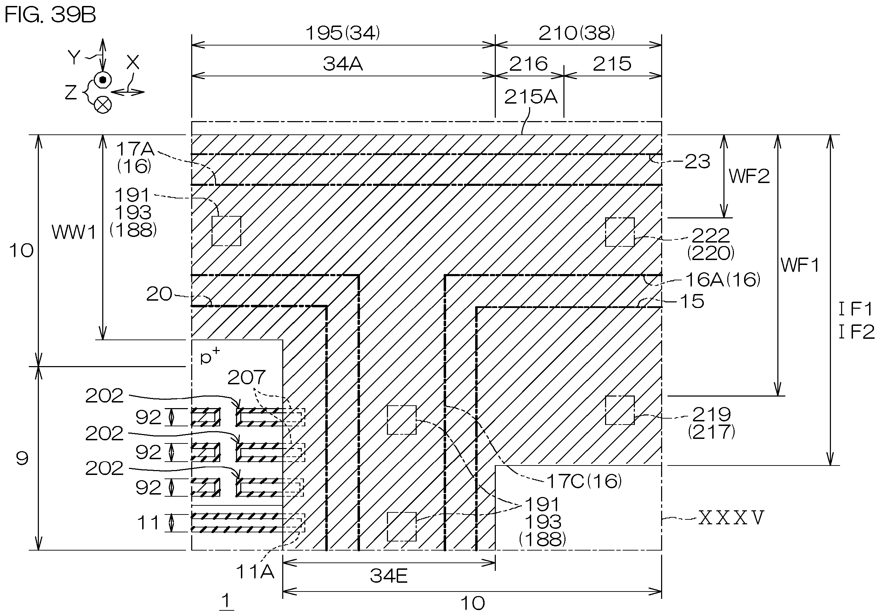

FIG. 34 is an enlarged view of a portion surrounded by an alternate long and short dashed line XXXIV of FIG. 4. FIG. 35 is an enlarged view of a portion surrounded by an alternate long and short dashed line XXXV of FIG. 34. FIG. 36 is a sectional view taken along line XXXVI-XXXVI shown in FIG. 35. FIG. 37 is a sectional view taken along line XXXVII-XXXVII shown in FIG. 35. FIG. 38 is a sectional view taken along line XXXVIII-XXXVIII shown in FIG. 35. FIG. 39A is a plan view of a second configuration example of a connection structure portion 216, and is a view corresponding to FIG. 35. FIG. 39B is a plan view of a third configuration example of the connection structure portion 216, and is a view corresponding to FIG. 35.

As described above, the peripheral wiring structure 34 includes the fifth structure 34E and the sixth structure 34F disposed in the region in a periphery of the gate pad 15 in the outer peripheral region 10. In FIG. 34 and FIG. 35, the formation region of the peripheral wiring structure 34 is indicated by hatching for clarity.

Referring to FIG. 34, the fifth structure 34E as an example of the second structure portion is a pair of structures. The fifth structure 34E is formed in a band shape extending in the second direction Y from the first structure 34A toward the third side surface 5C. The fifth structure 34E sandwiches the active region 9 in the first direction X between the second structure 34B and the fourth structure 34D.

Referring to FIG. 34, the fifth structure 34E on one side (the second side surface 5B side) in the first direction X overlaps the band-shaped portion 17F extending in the second direction Y in the connection portion 17C of the first gate wiring 17 in plan view. The fifth structure 34E on the other side (the fourth side surface 5D side) in the first direction X overlaps the band-shaped portion 18F extending in the second direction Y in the connection portion 18C of the second gate wiring 18 in plan view.

The peripheral edge at an inner side (a peripheral edge on the active region 9 side) of the fifth structure 34E is positioned further to the active region 9 side than the band-shaped portion 17F and the peripheral edge at an inner side (the peripheral edge on the active region 9 side) of the band-shaped portion 18F. A peripheral edge at an outer side of the fifth structure 34E (the peripheral edge on the side opposite to the active region 9 side) is positioned on the side opposite to the active region 9 side with respect to a peripheral edge at outer sides of the band-shaped portion 18F and the band-shaped portion 17F (the peripheral edge on the side opposite to the active region 9 side). A wiring width of the fifth structure 34E is wider than a wiring width of the gate wiring 16 (the band-shaped portion 17F and the band-shaped portion 18F). The wiring width of the fifth structure 34E is wider than the wiring width of the source wiring 23.

Referring to FIG. 35, the fifth structure 34E of the peripheral wiring structure 34 covers the terminal portion 11A of the trench gate structure 11 and the eighth terminal portion 207 of the third dummy trench structure 202 in the outer peripheral region 10 of the first principal surface 3. Thereby, the fifth structure 34E is electrically connected to the trench gate structure 11 and the third dummy trench structure 202.

Referring to FIG. 34, the gate wiring 16 includes the plurality of first connection electrode portions 191 that enter into the plurality of gate openings 188 and are connected to the peripheral wiring structure 34 (the peripheral wiring layer 195). In other words, the peripheral wiring structure 34 has a contact portion (third contact portion) 193 electrically connected to a first structure portion 215. The contact portion (third contact portion) 193 is formed in the first structure 34A, the second structure 34B, the fourth structure 34D, and the fifth structure 34E in the peripheral wiring structure 34.

Referring to FIG. 34, the sixth structure 34F is formed in a band shape extending in the first direction X, connecting the end portions on the inner side (the third side surface 5C side) of the pair of the fifth structures 34E. Referring to FIG. 34, the sixth structure 34F overlaps the second band-shaped portion 17G extending in the first direction X in the connection portion 17C of the first gate wiring 17 and the band-shaped portion 18G extending in the first direction X in the connection portion 18C of the second gate wiring 18 in plan view.

The peripheral edge at an inner side (the peripheral edge on the active region 9 side) of the sixth structure 34F is positioned further to the active region 9 side than the peripheral edge at an inner side (the peripheral edge on the active region 9 side) of the second band-shaped portion 17G and the band-shaped portion 18G. A peripheral edge at an outer side of the sixth structure 34F (the peripheral edge on the side opposite to the active region 9 side) is positioned on the side opposite to the active region 9 side with respect to a peripheral edge at an outer side of the second band-shaped portion 17G and the band-shaped portion 18G. A wiring width of the sixth structure 34F is wider than the wiring width of the gate wiring 16 (the band-shaped portion 17F and the band-shaped portion 18F). The wiring width of the sixth structure 34F is wider than the wiring width of the source wiring 23.

Referring to FIG. 34 and FIG. 35, the semiconductor device 1 includes the resistive wiring structure 38 disposed in the middle of the first structure 34A of the peripheral wiring structure 34 as described above. In this embodiment, the resistive wiring structure 38 includes a resistive wiring layer 210 disposed on the first principal surface 3 in the outer peripheral region 10. The resistive wiring structure 38 is of a band shape along the first peripheral edge 15A of the gate pad 15 in plan view. The resistive wiring structure 38 is connected to the first structure 34A of the peripheral wiring structure 34.

Referring to FIG. 34, the resistive wiring layer 210 is of a band shape along the first peripheral edge 15A of the gate pad 15. The resistive wiring layer 210 is formed across a region under the periphery of the first peripheral edge 15A of the gate pad 15 and a region under the connection wiring 16A. The resistive wiring layer 210 is disposed in the outer peripheral region 10. The resistive wiring layer 210 is not disposed in the active region 9.

The resistive wiring layer 210 includes a semiconductor polycrystal having conductivity. In this embodiment, the resistive wiring layer 210 is formed of polysilicon as a first conductive material. The polysilicon may contain either or both of p-type conductive polysilicon and n-type conductive polysilicon. The polysilicon is a material having a higher resistance than a metal material used for the gate pad 15, the gate wiring 16, the source pad 20, the source wiring 23, etc.

In this embodiment, the resistive wiring layer 210 is a portion of the polysilicon wiring layer 33 (FIG. 4). When a polysilicon film covering the first principal surface 3 is formed by filling the trench 41 using a CVD method, a portion of the polysilicon film can be used to form the polysilicon wiring layer 33, and the resistive wiring layer 210 can thereby be formed.

Thereby, the resistive wiring structure 38 (the resistive wiring layer 210) can be manufactured in the same step as the trench gate structure 11. Therefore, steps of the manufacturing process can be reduced as compared with a case in which the resistive wiring structure 38 is formed of a material different from the trench gate structure 11. Also, in a case in which the resistive wiring structure 38 is formed of polysilicon, manufacturing efficiency can be enhanced as compared with a case in which the resistive wiring structure 38 is formed of another material.

Also, in this embodiment, the resistive wiring structure 38 includes the resistive wiring layer 210 formed on the first principal surface 3, and does not adopt a trench structure. When the resistive wiring structure 38 is realized by the resistive wiring layer 210, it can be easily formed using deposition and patterning of a material film. Thereby, it is possible to efficiently form the resistive wiring structure 38 as compared with a case in which the resistive wiring structure 38 is realized by a trench structure.

Referring to FIG. 34, a peripheral edge at an outer side of the resistive wiring layer 210 is aligned with the outer peripheral edge of the first structure 34A. The resistive wiring layer 210 is connected to the first structure 34A. The resistive wiring layer 210 is disposed in the middle of the first structure 34A of the peripheral wiring structure 34 and divides the first structure 34A in the first direction X. In other words, the resistive wiring layer 210 is sandwiched in the first direction X by two portions of the first structure 34A.

Referring to FIG. 36 and FIG. 38, the resistive wiring layer 210 is disposed on the second insulating film 179 (the thick film 185). The resistive wiring layer 210 faces the outer body region 170 with the second insulating film 179 interposed therebetween. An upper surface 212 of the resistive wiring layer 210 has the depth position equivalent to the upper surface of the upper wiring layer 181 of the peripheral wiring structure 34. Referring to FIG. 38, the resistive wiring layer 210 is connected to the peripheral wiring layer 195 of the peripheral wiring structure 34.

Referring to FIG. 36, the semiconductor device 1 includes a third silicide layer 211 formed on the surface of the resistive wiring layer 210. The third silicide layer 211 covers the upper surface 212 and an outer side surface 213 of the resistive wiring layer 210. The third silicide layer 211 is a polysilicon portion obtained by silicidation of polysilicon of the resistive wiring layer 210. The third silicide layer 211 may be referred to as a "third metal semiconductor compound layer," a "third silicide layer (polyside layer)," a "third silicide region (polyside region)," etc.

The third silicide layer 211 may contain at least one of Ti silicide, Ni silicide, Co silicide, Mo silicide, and W silicide. The third silicide layer 211 is preferably constituted of Ti silicide, Ni silicide, or Co silicide. The third silicide layer 211 may be of a flat shape along the surface (the upper surface 212 and the outer side surface 213) of the resistive wiring layer 210.

Referring to FIG. 36, the resistive wiring layer 210 is covered with the third interlayer insulating layer 180. The third interlayer insulating layer 180 covers not only the peripheral wiring layer 95 but also an upper side and a lateral side of the resistive wiring layer 210. That is, the third interlayer insulating layer 180 covers the upper surface 212 and the outer side surface 213 of the resistive wiring layer 210 via the third silicide layer 211.

Referring to FIG. 34, the resistive wiring layer 210 includes the first structure portion 215 and two (a pair of) the connection structure portions 216 sandwiching the first structure portion 215 in the first direction X. The first structure portion 215 and the two connection structure portions 216 are formed to be integrated. A peripheral edge at an outer side of the first structure portion 215 and peripheral edges at outer sides of the connection structure portions 216 are aligned with each other.

The first structure portion 215 is incorporated in the chip 2 as a resistor electrically connected to the trench gate structure 11. That is, in this embodiment, the first structure portion 215 which is a portion of the polysilicon wiring layer 33 serves as a gate resistance portion. The first structure portion 215 delays a switching speed during a switching operation to suppress a surge current. That is, the first structure portion 215 suppresses noise caused by a surge current.

Referring to FIG. 34, in this embodiment, the first structure portion 215 is disposed on a portion of the third interlayer insulating layer 180 covering the outer peripheral region 10, and faces the first peripheral edge 15A of the gate pad 15 in the second direction Y in plan view. In this embodiment, the first structure portion 215 is formed in a band shape extending in the first direction X in plan view. The first structure portion 215 has a resistance length L11 in the first direction X. A planar shape of the first structure portion 215 is arbitrary.

Referring to FIG. 35, the first structure portion 215 has a first facing width IF1 in a direction (that is, the second direction Y) in which the gate pad 15 and the gate wiring 16 (the connection wiring 16A) face each other. In this embodiment, the first facing width IF1 may be wider than the first wiring width WW1.

Referring to FIG. 36, the first structure portion 215 has a resistance thickness TR in the vertical direction Z. The resistance thickness TR is appropriately adjusted in accordance with a resistance value to be achieved. That is, the resistance value of the first structure portion 215 is adjusted by an increase/decrease in the resistance thickness TR and an increase/decrease in the resistance length L11.

Referring to FIG. 34 and FIG. 36, the semiconductor device 1 includes at least (in this embodiment, a plurality) of the first contact openings 217 formed in the third interlayer insulating layer 180 in the outer peripheral region 10. In this embodiment, the plurality of first contact openings 217 are arrayed in a line at intervals from each other in the first direction X. The plurality of first contact openings 217 are formed in a portion covering the first structure portion 215 in the third interlayer insulating layer 180.

The plurality of first contact openings 217 may be formed in a quadrangular shape (square shape), a rectangular shape, a hexagonal shape, a circular shape, etc., in plan view. The semiconductor device 1 may have the single first contact opening 217. The single first contact opening 217 may be formed in a band shape extending in the first direction X along the first structure portion 215 in plan view.

Referring to FIG. 36, the gate pad 15 includes a plurality of third connection electrode portions 218 that enter into the plurality of first contact openings 217 and are connected to the first structure portion 215. The plurality of third connection electrode portions 218 correspond to the plurality of first contact openings 217 on a one-to-one basis. The third connection electrode portions 218 have a portion covering the third silicide layer 211 of the resistive wiring layer 210 in a film shape at the bottom portion of the first contact openings 217, and are mechanically and electrically connected to the third silicide layer 211. In other words, the first structure portion 215 has a first contact portion 219 electrically connected to the gate pad 15 in the region demarcated by the first contact opening 217.

Referring to FIG. 34 and FIG. 36, the semiconductor device 1 includes at least (in this embodiment, a plurality) of second contact openings 220 formed in the third interlayer insulating layer 180 in the outer peripheral region 10. In this embodiment, the plurality of second contact openings 220 are arrayed in a line at intervals from each other in the first direction X. The plurality of second contact openings 220 are formed in a portion covering the first structure portion 215 in the third interlayer insulating layer 180.

The plurality of second contact openings 220 may be formed in a quadrangular shape (square shape), a rectangular shape, a hexagonal shape, a circular shape, etc., in plan view. The semiconductor device 1 may have the single second contact opening 220. The single second contact opening 220 may be formed in a band shape extending in the first direction X along the first structure portion 215 in plan view.

Referring to FIG. 36, the gate wiring 16 (the connection wiring 16A) includes a plurality of fourth connection electrode portions 221 that enter into the plurality of second contact openings 220 and are connected to the first structure portion 215. The plurality of fourth connection electrode portions 221 correspond to the plurality of second contact openings 220 on a one-to-one basis. The fourth connection electrode portions 221 have a portion covering the third silicide layer 211 of the resistive wiring layer 210 in a film shape at the bottom portion of the second contact openings 220, and are mechanically and electrically connected to the third silicide layer 211. In other words, the first structure portion 215 has a second contact portion 222 electrically connected to the gate wiring 16 (the connection wiring 16A) in a region demarcated by the second contact opening 220.

Referring to FIG. 35, a second facing distance WF2 is appropriately adjusted in accordance with the resistance value to be achieved. That is, the resistance value of the first structure portion 215 is adjusted not only by an increase/decrease in the resistance thickness TR and an increase/decrease in the resistance length L11 but also by an increase/decrease in the second facing distance WF2. The second facing distance WF2 may be less than 0.5 times a second facing width IF2. The second facing distance WF2 may have a value belonging to any one range among not less than 0.1 times and not more than 0.2 times, not less than 0.2 times and not more than 0.3 times, and not less than 0.4 times and less than 0.5 times of the second facing width IF2. The second facing distance WF2 may be not less than 0.5 times the second facing width IF2.

Referring to FIG. 35, the connection structure portion 216 is a region sandwiched between the first structure portion 215 and the first structure 34A in the first direction X. In this embodiment, the outer shape of the connection structure portion 216 is formed in a quadrangular shape in plan view. In this embodiment, the connection structure portion 216 faces the first peripheral edge 15A of the gate pad 15 in the second direction Y in plan view. The connection structure portion 216 may be aligned with the first peripheral edge 15A in plan view.

The connection structure portion 216 is adjacent to the second side surface 5B side (the fourth side surface 5D) with respect to the first structure 34A. The connection structure portion 216 is mechanically and electrically connected to the first structure 34A. In other words, the first structure portion 215 is mechanically and electrically connected to the first structure 34A by the connection structure portion 216. In yet other words, the first structure portion 215 is electrically connected to the fifth structure 34E via the connection structure portion 216 and the first structure 34A.

Referring to FIG. 35, in this embodiment, the connection structure portion 216, the first structure portion 215, the first structure 34A, and the fifth structure 34E are included in a wiring structure 230 that is a portion of the polysilicon wiring layer 33 (FIG. 4). As described above, the connection structure portion 216 and the first structure portion 215 are included in the resistive wiring layer 210, and the first structure 34A and the fifth structure 34E are included in the peripheral wiring layer 195. That is, the wiring structure 230 includes a wiring layer formed on the first principal surface 3.

Referring to FIG. 35, the connection structure portion 216 has the second facing width IF2 in the direction (that is, the second direction Y) in which the gate pad 15 and the gate wiring 16 (the connection wiring 16A) face each other. The second facing width IF2 may be different from the first facing width IF1. In this embodiment, the second facing width IF2 is narrower than the first facing width IF1. The second facing width IF2 is wider than the first wiring width WW1.

Referring to FIG. 35, in this embodiment, a first facing distance WF1 between the first contact portion 219 and an outer edge 215A of the first structure portion 215 is narrower than the first facing width IF1 and wider than the second facing width IF2 (IF2 < WF1 < IF1). That is, the first contact portion 219 does not face the connection structure portion 216 in the first direction X (the direction intersecting the second direction Y).

Referring to FIG. 35, the second facing distance WF2 between the second contact portion 222 and the outer edge 215A of the first structure portion 215 is narrower than the second facing width IF2 (WF2 < IF2). That is, the second contact portion 222 faces the connection structure portion 216 in the first direction X.

Referring to FIG. 38, in this embodiment, a lower surface 223 of the first structure portion 215, a lower surface 224 of the connection structure portion 216, and a lower surface 225 of the first structure 34A have the same plane (a plane parallel to the first principal surface 3). In other words, the lower portion (the lower surface 224) of the connection structure portion 216, the lower portion (the lower surface 223) of the first structure portion 215, and the lower portion (the lower surface 225) of the first structure 34A are at the same depth position as each other.

Specifically, the lower surface 223 of the first structure portion 215 is continuous to the lower surface 224 of the connection structure portion 216 on the same plane. The lower surface 224 of the connection structure portion 216 is continuous to the lower surface 225 of the first structure 34A on the same plane.

Although unillustrated, the lower surface of the fifth structure 34E is at the same depth position as the lower surface 225 of the first structure 34A. Therefore, the lower surface of the fifth structure 34E has the same plane (the plane parallel to the first principal surface 3) as the lower surface 223 of the first structure portion 215, the lower surface 224 of the connection structure portion 216, and the lower surface 225 of the first structure 34A. In other words, the lower surface of the wiring structure 230 has the same plane.

Referring to FIG. 38, as described above, the resistance thickness TR is equivalent to the peripheral thickness TA. The resistance thickness TR may be thicker than the peripheral thickness TA or may be thinner than the peripheral thickness TA.

Referring to FIG. 34, the number of the first structure portions 215 is not limited to one (single), and may be two or more (plural). The number of connection structure portions 216 is not limited to two, and may be one (single) or may be three or more (plural).

In the semiconductor device 1, the gate potential applied to the gate pad 15 from the exterior is transmitted to the plurality of trench gate structures 11. Referring to FIG. 35 and FIG. 38, in this embodiment, there are at least two paths of a first path RT1 and a second path RT2 as current paths from the gate pad 15 to the plurality of trench gate structures 11. The first path RT1 is a current path from the gate pad 15 to the plurality of trench gate structures 11 through the first structure portion 215, the gate wiring 16 (the connection wiring 16A), and at least one of either of the first structure 34A and the fifth structure 34E.

Referring to FIG. 35 and FIG. 38, the second path RT2 is a current path from the gate pad 15 to the plurality of trench gate structures 11 through the first structure portion 215, the connection structure portion 216, and at least one of either of the first structure 34A and the fifth structure 34E of the peripheral wiring structure 34.

The gate wiring 16 (the connection wiring 16A) constituted of a metal has a lower resistance than the connection structure portion 216 made of polysilicon. In addition, the second facing width IF2 of the connection structure portion 216 is narrow (narrower than the first facing width IF1). Therefore, the current reaching the first structure portion 215 from the gate pad 15 easily flows to the gate wiring 16 (the connection wiring 16A) compared to the connection structure portion 216. That is, as the current path from the gate pad 15 to the plurality of trench gate structures 11, the first path RT1 is preferentially selected over the second path RT2.

It is considered to eliminate the connection structure portion 216 in the wiring structure 230. In this case, polysilicon is removed from the formation position of the connection structure portion 216 in the wiring structure 230, and the first structure portion 215, and the first structure 34A and the fifth structure 34E are divided in the first direction X. Then, the third interlayer insulating layer 180 enters in between the first structure portion 215 and the first structure 34A and the fifth structure 34E. In this case, since the polysilicon layer is removed, an uneven shape is generated in the wiring structure 230. However, if the wiring structure 230 has an uneven shape, there is a possibility that a bias in stress distribution occurs in the wiring structure 230 (the polysilicon wiring layer 33).

On the other hand, in this embodiment, the first structure portion 215, and the first structure 34A and the fifth structure 34E are connected by the connection structure portion 216. Since the first structure portion 215 and the first structure 34A are not divided, the uneven shape in the wiring structure 230 can be reduced. Thereby, it is possible to suppress or prevent the stress distribution from being biased in the wiring structure 230 (a portion of the polysilicon wiring layer 33).

Also, as described above, the lower surface of the wiring structure 230 has the same plane. Therefore, it is possible to more effectively suppress or prevent the stress distribution from being biased in the wiring structure 230 (the polysilicon wiring layer 33).

Also, as described above, as the current path from the gate pad 15 to the plurality of trench gate structures 11, the first path RT1 is preferentially selected over the second path RT2. Therefore, an optimal current path can be secured. Therefore, even when the first structure portion 215 is electrically connected to the first structure 34A and the fifth structure 34E, a problem associated therewith does not occur.

The connection structure portion 216 according to the first configuration example (FIG. 35) has been described above.

Referring to FIG. 39A, in the second configuration example of the connection structure portion 216, the second facing width IF2 is wider than both the first facing distance WF1 and the second facing distance WF2. That is, the first facing distance WF1 is narrower than the second facing width IF2. The second facing width IF2 may be equivalent to the first facing distance WF1. That is, the first facing distance WF1 may be substantially the same as the second facing width IF2.

Referring to FIG. 39B, in the third configuration example of the connection structure portion 216, the second facing width IF2 is equivalent to the first facing width IF1. Also in this case, the second facing width IF2 is wider than both the first facing distance WF1 and the second facing distance WF2. That is, the first facing distance WF1 is narrower than the second facing width IF2.

In the case of FIG. 39A and FIG. 39B, both the first contact portion 219 and the second contact portion 222 face the connection structure portion 216 in the first direction X.

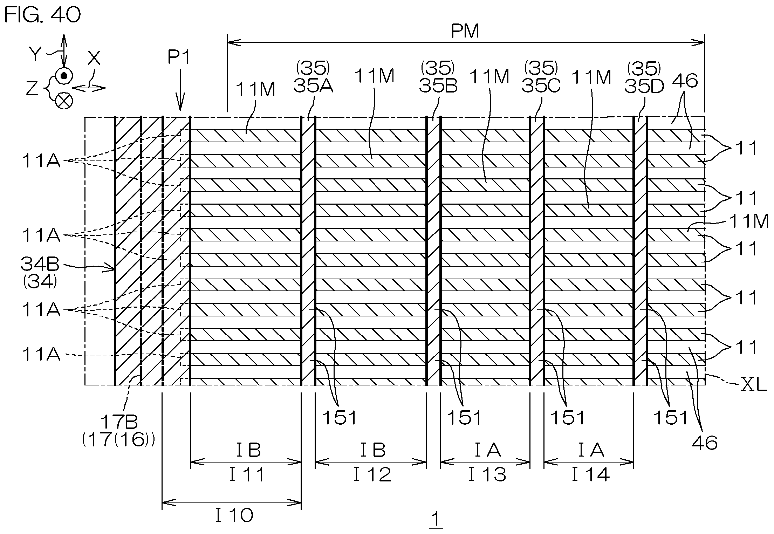

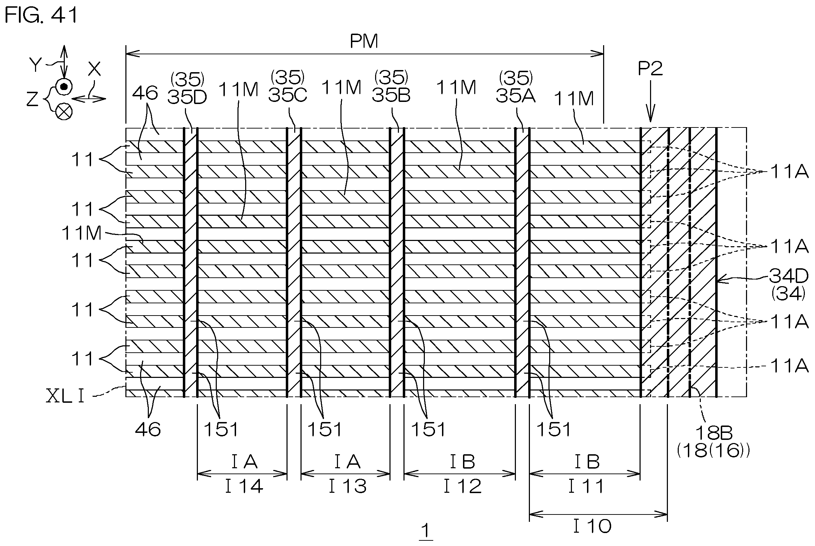

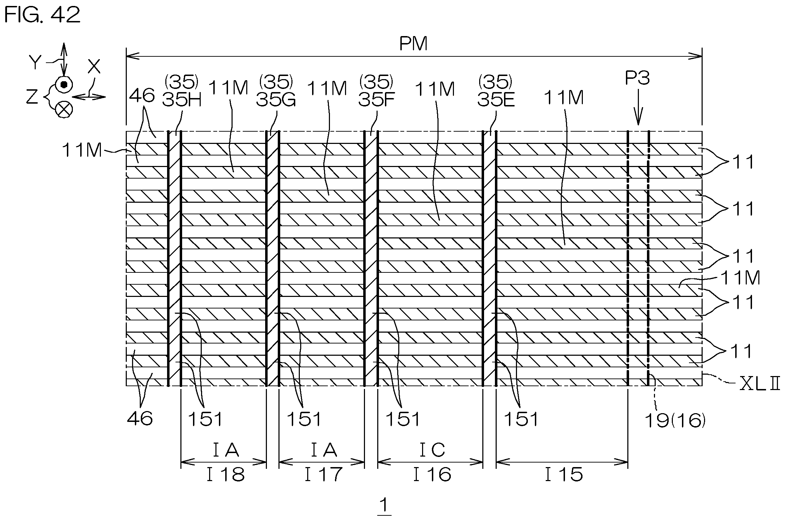

FIG. 40 is an enlarged view of a portion surrounded by an alternate long and short dashed line XL of FIG. 4. FIG. 41 is an enlarged view of a portion surrounded by an alternate long and short dashed line XLI of FIG. 4. FIG. 42 is an enlarged view of a portion surrounded by an alternate long and short dashed line XLII of FIG. 4.

Referring to FIG. 40 and FIG. 41, as described above, the both terminal portions 11A of the plurality of trench gate structures 11 are electrically connected to the second structure 34B and the fourth structure 34D of the peripheral wiring structure 34. Both terminal portions 11A of the trench gate structure 11 are a portion at the first outer edge position (first position) P1 in the first direction X of the trench gate structure 11 and a portion at the second outer edge position (first position) P2 in the first direction X of the trench gate structure 11. That is, the both terminal portions 11A of the trench gate structure 11 are electrically connected to the second portions 17B and 18B of the gate wiring 16 via both the second structure 34B and the fourth structure 34D.

Also, as this embodiment, as described above, the plurality of connection wiring structures 35 cross, in a line shape, the plurality of mesa portions 46 extending in a stripe shape in the second direction Y. Referring to FIG. 40 to FIG. 42, the plurality of connection wiring structures 35 are connected to the trench gate structures 11 extending in a stripe shape. The plurality of connection wiring structures 35 are connected to an intermediate portion 11M of the trench gate structure 11. The intermediate portion 11M is a portion at an intermediate position PM of the trench gate structure 11 in the first direction X.

Referring to FIG. 40 to FIG. 42, the plurality of connection wiring structures 35 electrically connect the trench gate structure 11 and the first portions 17A and 18A (FIG. 3) of the gate wiring 16. A plurality of the connection portions 151 with the connection wiring structures 35 are formed in the intermediate portion 11M of the trench gate structure 11. The plurality of connection portions 151 are formed at a plurality of locations in the first direction X in the trench gate structures 11.

In this embodiment, a gate signal applied from the gate pad 15 to the first portions 17A and 18A (FIG. 3) of the gate wiring 16 is transmitted to the plurality of trench gate structures 11 through any of the plurality of connection wiring structures 35 and the first portions 17A and 18A of the gate wiring 16.

That is, in this embodiment, by disposing the plurality of connection wiring structures 35, the gate signal applied to the first portions 17A and 18A (FIG. 3) of the gate wiring 16 is transmitted not only to the second portions 17B and 18B of the gate wiring 16 but also to the trench gate structures 11 through the plurality of connection wiring structures 35.

Referring to FIG. 40 and FIG. 41, the plurality of connection wiring structures 35 disposed in the region close to the second portion 17B of the gate wiring 16 are referred to as a first connection wiring structure 35A, a second connection wiring structure 35B, a third connection wiring structure 35C, and a fourth connection wiring structure 35D in order from the second portion 17B side of the gate wiring 16. Also, referring to FIG. 41, the plurality of connection wiring structures 35 disposed in the region close to the second portion 18B of the gate wiring 16 are symmetrically disposed with respect to the plurality of connection wiring structures 35 disposed in the region close to the second portion 17B of the gate wiring 16 and the third gate wiring 19. Therefore, the common components are denoted by the same reference signs as that in the case of FIG. 40, and the description thereof is omitted.

Although unillustrated, the third gate wiring 19 is electrically connected to the plurality of trench gate structures 11. As described above, the third gate wiring 19 extends in the second direction Y from a gate pad position (third position) P3 the same as that of the gate pad 15 in regard to the first direction X. In this embodiment, the gate pad position P3 is a central position of the gate pad 15 in the first direction X. Specifically, the third gate wiring 19 is connected to all of the trench gate structures 11 facing the third gate wiring 19 in the vertical direction Z3 in plan view at the gate pad position P3. The third gate wiring 19 may be connected to the trench gate structures 11 using a portion of the polysilicon wiring layer 33. The third gate wiring 19 may be connected to the trench gate structures 11 using another wiring layer.

Referring to FIG. 40 and FIG. 41, the first connection wiring structure 35A is disposed on the third gate wiring 19 side (the gate pad 15 side) at an interval I11 from the second structure 34B (the fourth structure 34D) in the first direction X. The second connection wiring structure 35B is disposed on the third gate wiring 19 side (the gate pad 15 side) at an interval I12 from the first connection wiring structure 35A in the first direction X. The third connection wiring structure 35C is disposed on the third gate wiring 19 side (the gate pad 15 side) at an interval I13 from the second connection wiring structure 35B in the first direction X. The fourth connection wiring structure 35D is disposed on the third gate wiring 19 side (the gate pad 15 side) at an interval I14 from the third connection wiring structure 35C in the first direction X.

In this embodiment (first configuration example), both the interval I13 and the interval I14 are the first interval IA. Both the interval I11 and the interval I12 are the second interval IB. The second interval IB is wider than the first interval IA. That is, the interval I11 and the interval I12 are wider than the interval I13 and the interval I14 (I11 > I13, I11 > I14, I12 > I13, I12 > I14). Also, the interval I10 between the first connection wiring structure 35A and the second portion 17B of the first gate wiring 17 (the second portion 18B of the second gate wiring 18) is wider than the interval I11 and the interval I12 (I10 > I11, I10 > I12).

The first interval IA may be not less than 100 µm and not more than 300 µm. The first interval IA is preferably not less than 150 µm and not more than 250 µm.

The second interval IB may be not less than 1.2 times and not more than 2.5 times the first interval IA. The second interval IB may have a value belonging to any one range among not less than 1.2 times and not more than 1.5 times, not less than 1.5 times and not more than 1.8 times, not less than 1.8 times and not more than 2 times, not less than 2 times and not more than 2.3 times, and not less than 2.3 times and not more than 2.5 times of the first interval IA.

Referring to FIG. 42, the plurality of connection wiring structures 35 disposed in the region close to the third gate wiring 19 between the third gate wiring 19 and the second portion 17B of the gate wiring 16 are referred to as a fifth connection wiring structure 35E, a sixth connection wiring structure 35F, a seventh connection wiring structure 35G, and an eighth connection wiring structure 35H in order from the third gate wiring 19 side.

Referring to FIG. 42, the fifth connection wiring structure 35E is disposed on the second structure 34B side (the fourth structure 34D side) at an interval I15 from the third gate wiring 19 in the first direction X. The sixth connection wiring structure 35F is disposed on the second structure 34B side (the fourth structure 34D side) at an interval I16 from the fifth connection wiring structure 35E in the first direction X. The seventh connection wiring structure 35G is disposed on the second structure 34B side (the fourth structure 34D side) at an interval I17 from the sixth connection wiring structure 35F in the first direction X. The eighth connection wiring structure 35H is disposed on the second structure 34B side (the fourth structure 34D side) at an interval I18 from the seventh connection wiring structure 35G in the first direction X.

In this embodiment (first configuration example), the interval I16 is a third interval IC. Both the interval I17 and the interval I18 are the first interval IA. The third interval IC is wider than the first interval IA. That is, the interval I16 is wider than the interval I17 and the interval I18 (I16 > I17, I16 > I18). Also, the interval I15 is wider than the interval I16 (I15 > I16).

The third interval IC may be not less than 1.2 times and not more than 2.5 times the first interval IA. The third interval IC may have a value belonging to any one range among not less than 1.2 times and not more than 1.5 times, not less than 1.5 times and not more than 1.8 times, not less than 1.8 times and not more than 2 times, not less than 2 times and not more than 2.3 times, and not less than 2.3 times and not more than 2.5 times the second interval IB.

According to this embodiment, the plurality of connection wiring structures 35 cross, in a line shape, the plurality of mesa portions 46 extending in a stripe shape in the second direction Y. The plurality of connection wiring structures 35 are connected to the trench gate structures 11 extending in a stripe shape and electrically connect the trench gate structures 11 and the gate wiring 16.

By connecting the plurality of connection wiring structures 35 to the trench gate structures 11, the connection portions 151 with the connection wiring structures 35 are formed at a plurality of locations in the trench gate structures 11 in the first direction X. The transmission of the gate signal from the gate wiring 16 to the trench gate structures 11 is performed using a path passing through the connection wiring structures 35 to the connection portions 151 of the trench gate structures 11.

In the trench gate structures 11, since the gate signal is transmitted through the plurality of connection portions 151 formed at a plurality of locations in the first direction X, the signal transmission distance from the gate wiring 16 can be shortened in each portion of the trench gate structures 11. Thereby, the gate signal from the gate wiring 16 can be transmitted to each portion of the trench gate structures 11 in a short time. Therefore, even when the size of the chip 2 is increased and the trench gate structures 11 become long in the first direction X accordingly, signal delay can be suppressed.

In this embodiment, if the plurality of connection wiring structures 35 are not disposed, the gate signal is transmitted to the trench gate structures 11 only through the second portions 17B and 18B of the gate wiring 16 connected to the terminal portions 11A of the trench gate structures 11. In this case, in a portion far from the terminal portion 11A of the trench gate structure 11 (a portion close to the third gate wiring 19), a distance from the gate wiring 16 increases, and a signal delay may occur. In particular, when the trench gate structures 11 become long in the first direction X along with the increase in size of the chip 2, the problem of occurrence of signal delay may become apparent.

On the other hand, in this embodiment, by disposing the plurality of connection wiring structures 35, the gate signal is transmitted to the trench gate structures 11 through not only the second portions 17B and 18B of the gate wiring 16 but also through the plurality of connection wiring structures 35. Since the gate signal is transmitted through the plurality of connection portions 151 formed at a plurality of locations in the trench gate structures 11 in the first direction X, the signal transmission distance from the gate wiring 16 can be shortened in each portion of the trench gate structures 11.

Therefore, the gate signal from the gate wiring 16 can be transmitted to a portion (a portion close to the third gate wiring 19) far from the second portions 17B and 18B of the gate wiring 16 in the trench gate structures 11 in a short time. This makes it possible to suppress the occurrence of signal delay. Therefore, even when the size of the chip 2 is increased and the trench gate structures 11 become long in the first direction X accordingly, signal delay can be suppressed.

Also, as described above, in this embodiment, the terminal portions (the terminal portions 17D and 18D (FIG. 3)) of the gate wiring 16 (the first gate wiring 17 and the second gate wiring 18) are not disposed in the region between the peripheral edge of the active region 9 on the third side surface 5C side and the third side surface 5C of the chip 2. In this case, a signal delay of the gate signal may occur in the trench gate structure 11 close to the peripheral edge on the third side surface 5C side of the active region 9.

In this embodiment, by disposing the plurality of connection wiring structures 35, it is possible to suppress the occurrence of a signal delay in the trench gate structure 11 close to the peripheral edge on the third side surface 5C side of the active region 9. Thereby, it is possible to increase the area ratio of the active region 9 to the entirety of the chip 2 while suppressing the occurrence of a signal delay.

Also, according to this embodiment, the terminal portions 11A of the trench gate structures 11 are connected to the second portions 17B and 18B of the gate wiring 16, and the intermediate portions 11M of the trench gate structures 11 are connected to the connection wiring structures 35.

The second portions 17B and 18B of the gate wiring 16 has a low resistance. Therefore, in the second portions 17B and 18B of the gate wiring 16 to which the terminal portions 11A of the trench gate structures 11 are connected, the gate signal transmission speed is high. On the other hand, the connection wiring structures 35 have a high resistance. Therefore, in the first portions 17A and 18A (FIG. 3) of the gate wiring 16 to which the intermediate portions 11M of the trench gate structures 11 are connected, the gate signal transmission speed is slow.

Also, since the terminal portion 11A of the trench gate structure 11 is far from the gate pad 15 (FIG. 3), a signal transmission distance to the gate pad 15 is long. On the other hand, since the intermediate portion 11M of the trench gate structure 11 is closer to the gate pad 15 (the third gate wiring 19) than the terminal portion 11A of the trench gate structure 11, the signal transmission distance to the gate pad 15 (FIG. 3) is short.

In this embodiment, the second portions 17B and 18B of the gate wiring 16 having a high signal transmission speed are used to transmit the gate signal to the terminal portions 11A of the trench gate structures 11 having a long signal transmission distance. Also, the connection wiring structure 35 having a low signal transmission speed is used to transmit the gate signal to the intermediate portion 11M of the trench gate structure 11 having a short signal transmission distance.

By using the transmission speed difference between the second portions 17B and 18B of the gate wiring 16 and the connection wiring structures 35, the arrival timing of the gate signal at each location of the trench gate structures 11 can be made uniform. Therefore, the balance of in-plane signal transmission of the chip 2 can be improved.

Also, according to this embodiment, in the region between the second portions 17B and 18B of the gate wiring 16 and the gate pad 15, the plurality of connection wiring structures 35 are arrayed at intervals in the first direction X. The plurality of connection wiring structures 35 cross, in a line shape, the plurality of mesa portions 46 extending in a stripe shape in the second direction Y. Thereby, the connection portions 151 between the trench gate structures 11 and the connection wiring structures 35 are formed at a plurality of locations in the trench gate structures 11 in the first direction X.

Since the gate signal is transmitted through the plurality of connection portions 151 formed at a plurality of locations in the trench gate structures 11 in the first direction X, the signal transmission distance from the gate wiring 16 can be shortened in each portion of the trench gate structures 11. Thereby, the gate signal from the gate wiring 16 can be transmitted to each portion of the trench gate structures 11 in a short time. Thereby, the balance of in-plane signal transmission of the chip 2 can be improved further.

Also, according to this embodiment (the first configuration example of the plurality of connection wiring structures 35), between the second portions 17B and 18B of the gate wiring 16 and the gate pad 15 (FIG. 3), the intervals I13 and I14 of the connection wiring structures 35 far from the second portions 17B and 18B are narrower than the interval I12 of the connection wiring structures 35 close to the second portions 17B and 18B. In this case, in the intermediate portion 11M of the trench gate structure 11, a portion of the connection wiring structure 35 far from the second portions 17B and 18B has a higher disposition density of the connection portions 151 than a portion of the connection wiring structure 35 close to the second portions 17B and 18B.

Since the disposition density of the connection portions 151 can be increased in a portion far from the second portions 17B and 18B in the intermediate portion 11M of the trench gate structure 11, the signal transmission distance to the gate wiring 16 can be more effectively shortened in this portion. Thereby, the balance of in-plane signal transmission of the chip 2 can be improved further.

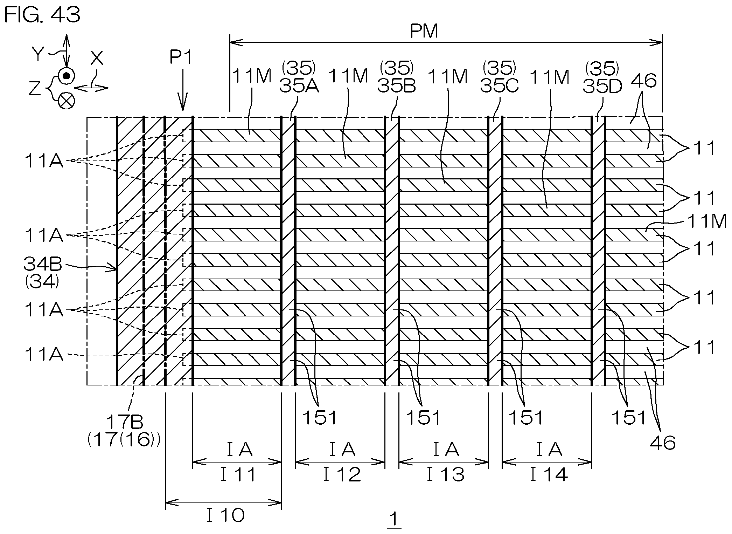

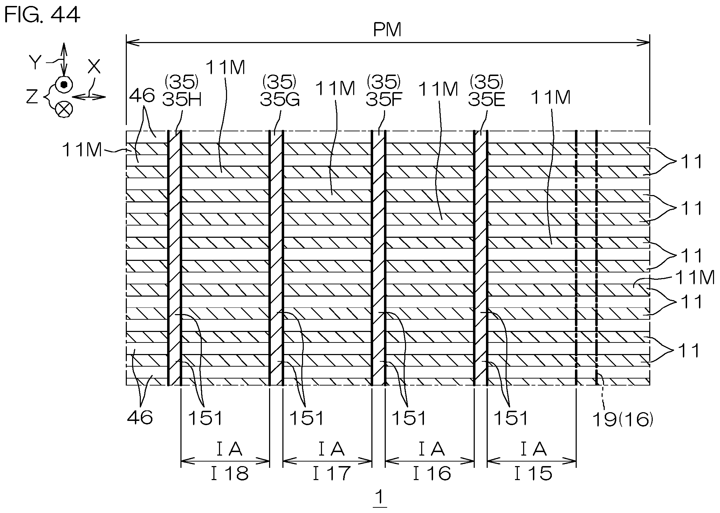

FIG. 43 is a plan view for describing a disposition example of the plurality of connection wiring structures 35 according to a second configuration example, and is a view corresponding to FIG. 40. FIG. 44 is a plan view for describing a disposition example of the plurality of connection wiring structures 35 according to the second configuration example, and is a view corresponding to FIG. 42.

In the second configuration example, all of the interval I11, the interval I12, the interval I13, and the interval I14 are the first interval IA (I11 = I12 = I13 = I14). The interval I10 is wider than the interval I11, the interval I12, the interval I13, and the interval I14 (I10 > I11, I10 > I12, I10 > I13, I10 > I14).

In the second configuration example, all of the interval I16, the interval I17, and the interval I18 are the first interval IA (I16 = I17 = I18). In the second configuration example, the interval I15 is the first interval IA (I15 = I16, I15 = I17, I15=I18). The interval I15 may be wider than the first interval IA (I15 > I16, I15 > I17, I15 > I18).

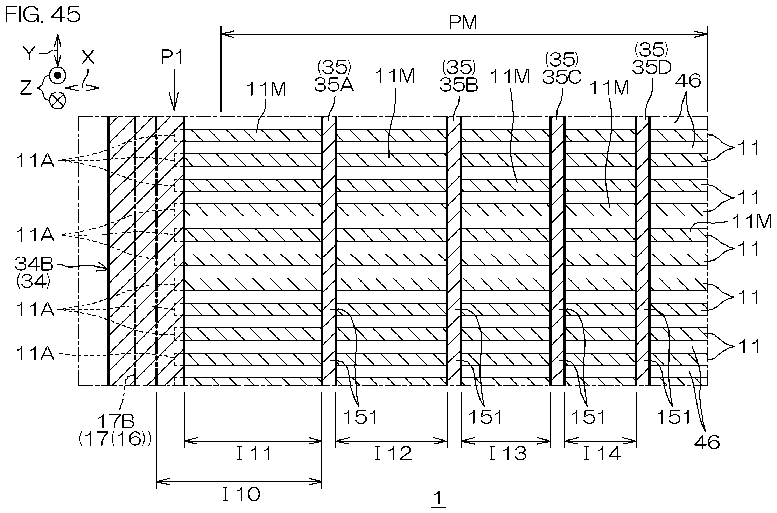

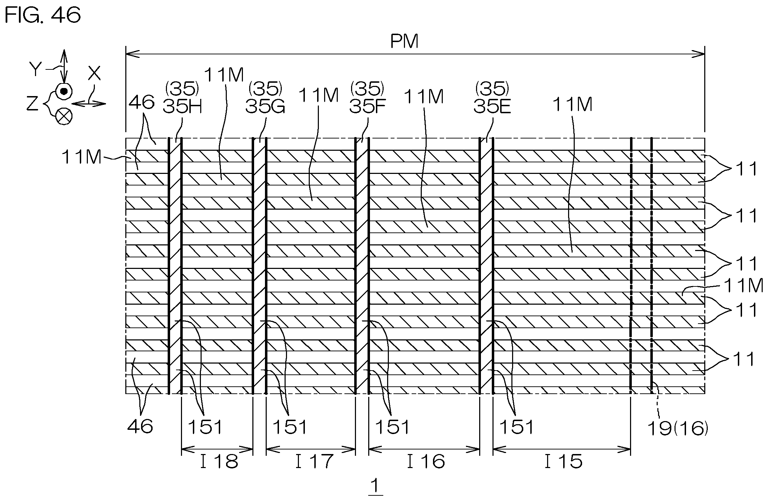

FIG. 45 is a plan view for describing a disposition example of the plurality of connection wiring structures 35 according to a third configuration example, and is a view corresponding to FIG. 40. FIG. 46 is a plan view for describing a disposition example of the plurality of connection wiring structures 35 according to the third configuration example, and is a view corresponding to FIG. 42.

In the third configuration example, in the region between the second portions 17B and 18B of the gate wiring 16 and the third gate wiring 19, a wiring pitch of the plurality of connection wiring structures 35 becomes narrower toward the center of the region between the second portions 17B and 18B and the third gate wiring 19 in the first direction X.

Specifically, referring to FIG. 45, the interval I12 is narrower than the interval I11. The interval I13 is narrower than the interval I12. The interval I14 is narrower than the interval I13 (I11 > I12 > I13 > I14). In the third configuration example, the interval I10 may be wider than the interval I11 (I10 > I11).

Also, referring to FIG. 46, the interval I17 is narrower than the interval I16. The interval I18 is narrower than the interval 17 (I16 > I17 > I18). In the third configuration example, the interval I15 may be wider than the interval I16 (I15 > I16).

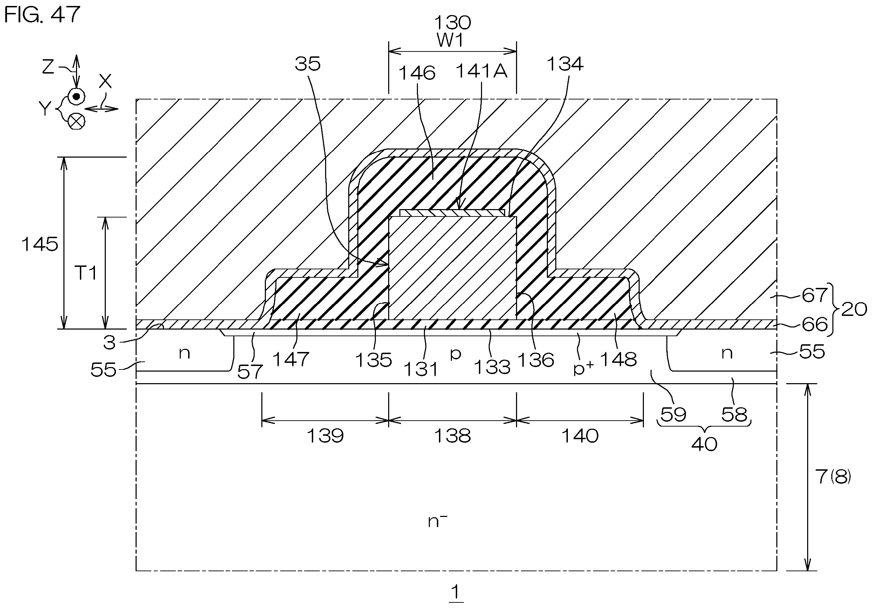

FIG. 47 shows a first modification example where the configuration of the first silicide layer 141 is changed. Referring to FIG. 47, in the first modification example, a first silicide layer 141A is formed on the surface of the connection wiring layer 130 in place of the first silicide layer 141 (FIG. 14, etc.). The first silicide layer 141A is different from the first silicide layer 141 (FIG. 14, etc.) in that the first silicide layer 141A is partially formed on the surface of connection wiring layer 130.

The first silicide layer 141A covers the upper surface 134 of the connection wiring layer 130. The first silicide layer 141A exposes the first side surface 135 and the second side surface 136 of the connection wiring layer 130.

The first silicide layer 141A may contain at least one of Ti silicide, Ni silicide, Co silicide, Mo silicide, and W silicide. The first silicide layer 141A is preferably constituted of Ti silicide, Ni silicide, or Co silicide. The first silicide layer 141A is of a flat shape along the upper surface 134 of the connection wiring layer 130.

A thickness of the first silicide layer 141A is not less than 0.01 times and not more than 0.2 times the connection width W1 (FIG. 13) of the connection wiring layer 130. The first silicide layer 141A is formed in a band shape extending along the connection wiring layer 130 in plan view. That is, the extension direction of the first silicide layer 141A intersects the off direction of the SiC monocrystal.

The first silicide layer 141A is formed at intervals inward from both the first side surface 135 and the second side surface 136 of the connection wiring layer 130, and exposes, on the upper surface 134 of the connection wiring layer 130, both a peripheral edge portion on the first side surface 135 side and a peripheral edge portion on the second side surface 136 side.

That is, in the first modification example shown in FIG. 47, the first silicide layer 141A is not exposed from both the first side surface 135 and the second side surface 136. The first silicide layer 141A is formed at intervals inward from both the first side surface 135 and the second side surface 136 in an entire area of the upper surface 134 in plan view.

In the first silicide layer 141A, a metal film of Ti, Ni, Co, etc., is formed on the upper surface 134 of the connection wiring layer 130 constituted of polysilicon, and then the metal film reacts with polysilicon of the connection wiring layer 130 to be silicided. Thereafter. Unnecessary portions of the connection wiring layer 130 (the connection wiring structure 35) are removed (polysilicon etching step).

If the first silicide layer 141A is also formed on at least one of either of the first side surface 135 and the second side surface 136, there is a possibility that the first silicide layer 141A is also etched (removed) along with the etching (removal) of the connection wiring layer 130 (the connection wiring structure 35) in the polysilicon etching step.

On the other hand, according to the first modification example, the first silicide layer 141A is not formed on either the first side surface 135 or the second side surface 136. Thereby, in the manufacturing process (polysilicon etching step) of the connection wiring layer 130 (the connection wiring structure 35), the first silicide layer 141A does not need to be removed at the first side surface 135 and the second side surface 136. Thereby, metal contamination (metal particle contamination) of other structures on the first principal surface 3 and metal contamination (metal particle contamination) of the manufacturing apparatus due to etching of the first silicide layer 141A are suppressed.

In particular, in the case of the semiconductor device 1 having SiC, an extremely high voltage is to be applied due to its characteristics (physical properties), unlike a lateral type Si semiconductor device such as an LSI. Metal contamination on the first principal surface 3 may have an unexpected effect on the electrical characteristics of the semiconductor device 1 due to the high voltage. Therefore, by eliminating the possibility of metal contamination on the first principal surface 3, the semiconductor device 1 having appropriate electrical characteristics is provided.

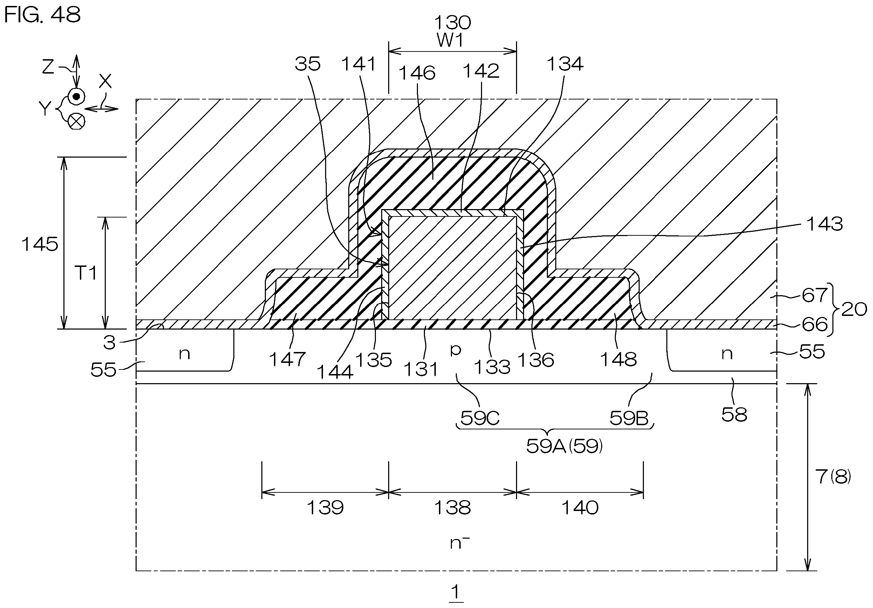

FIG. 48 shows a second modification example where the region where the connection wiring structure 35 is disposed is changed. Referring to FIG. 48, in the second modification example, the connection wiring layer 130 faces the facing body portion 59A with the first insulating film 131 interposed therebetween. In the second modification example, the first contact region 57 is not present between the first insulating film 131 and the facing body portion 59A. In the embodiment of FIG. 48, the p-type impurity concentration of the facing body portion 59A may be higher than the p-type impurity concentration of the other body region 40.

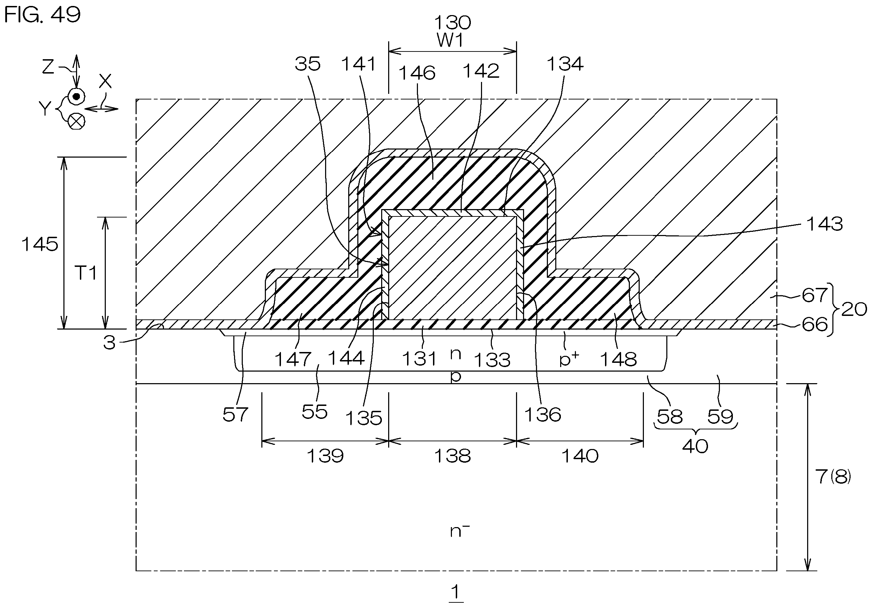

FIG. 49 shows a third modification example where the region where the connection wiring structure 35 (the connection wiring layer 130) is disposed is changed. Referring to FIG. 49, in the third modification example, the connection wiring layer 130 faces the source region 55 (that is, the n-type impurity region) with the first insulating film 131 interposed therebetween. That is, the connection wiring layer 130 overlaps the source region 55 in plan view.

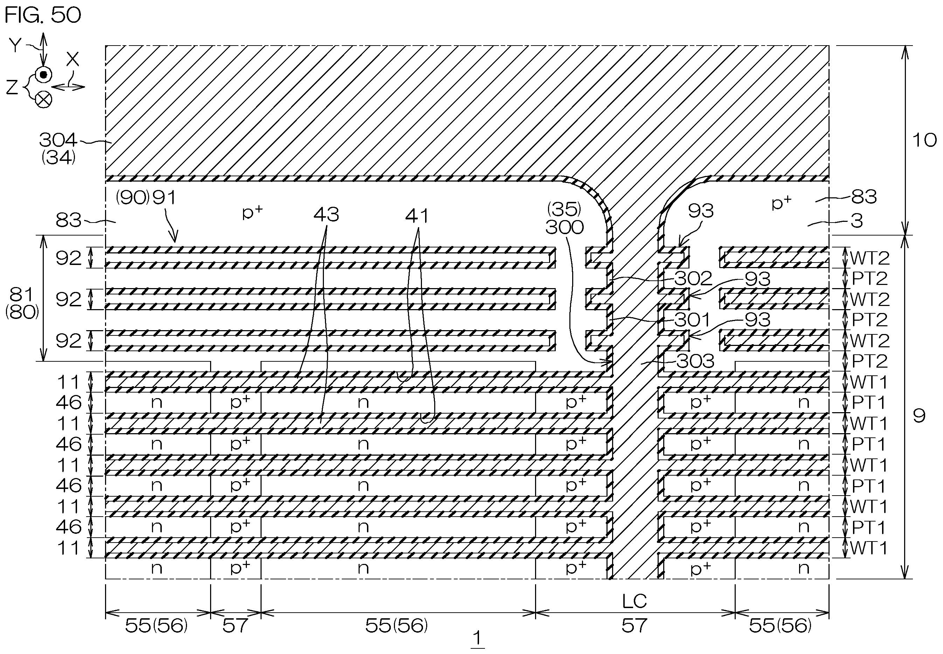

FIG. 50 is a sectional view showing another preferred embodiment of the semiconductor device 1 and corresponding to FIG. 12. The connection wiring structure 35 has a trench wiring structure 300. The trench wiring structure 300 includes a trench 301, an insulating film 302 covering a side surface of the trench 301, and a conductor 303 embedded in the trench 301 with the insulating film 302 interposed therebetween. The conductor 303 is electrically connected to a high concentration region of an impurity region via the bottom wall of the trench 301.

The conductor 303 is formed of polysilicon as a first conductive material. The polysilicon may contain either or both of p-type conductive polysilicon and n-type conductive polysilicon.

The trench 301 of the trench wiring structure 300 is connected to the trench 41 of the trench gate structure 11. The trench wiring structure 300 is connected to the embedded body 43 of the trench gate structure 11 at a portion where the trench 301 and the trench 41 intersect.

Also, in this embodiment, the peripheral wiring structure 34 has a trench type peripheral wiring 304. A terminal portion of the trench wiring structure 300 is connected to the trench type peripheral wiring 304.

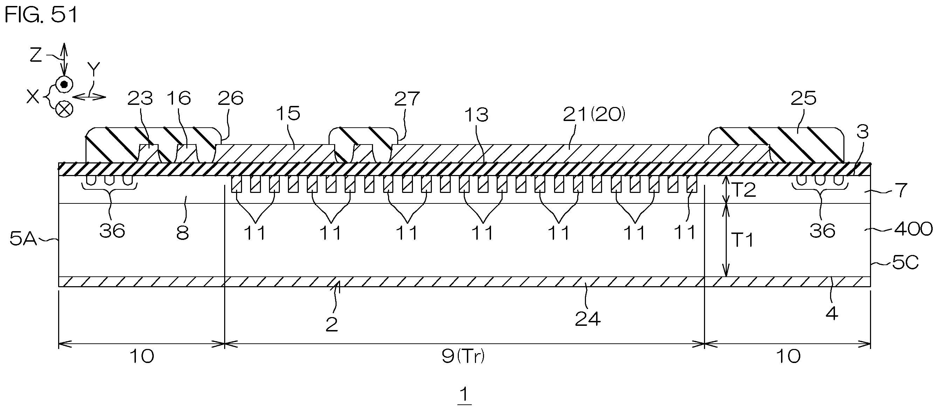

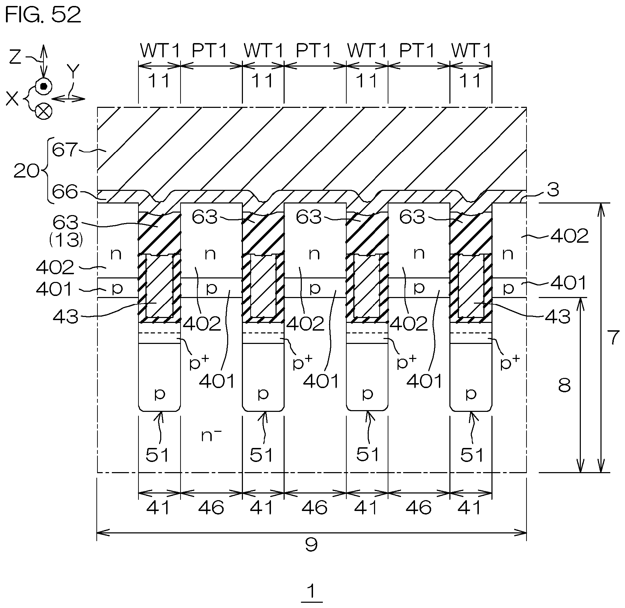

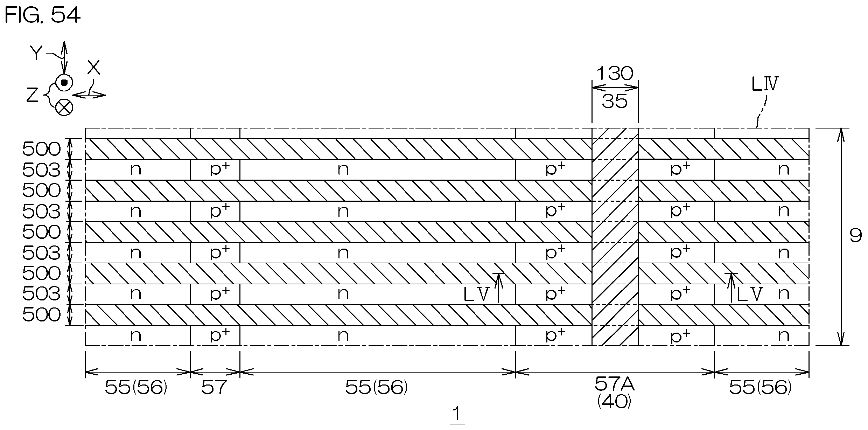

FIG. 51 is a sectional view showing another preferred embodiment of the semiconductor device 1 and corresponding to FIG. 2. FIG. 52 is a sectional view showing another preferred embodiment of the semiconductor device 1 and corresponding to FIG. 7. Referring to FIG. 54, the element structure of the semiconductor device 1 may be an IGBT (Insulated Gate Bipolar Transistor) structure, unlike the MISFET structure. In this case, a collector region 400 of the p-type (FIG. 51) may be formed in place of the base layer 6. Also, a base region 401 of the p-type (FIG. 52) may be formed by the body region 40, and an emitter region 402 of the n-type (FIG. 52) may be formed by the source region 55.

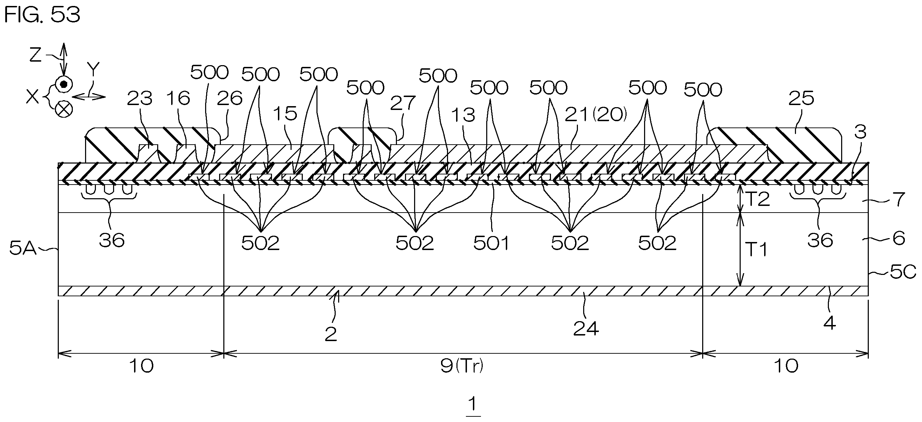

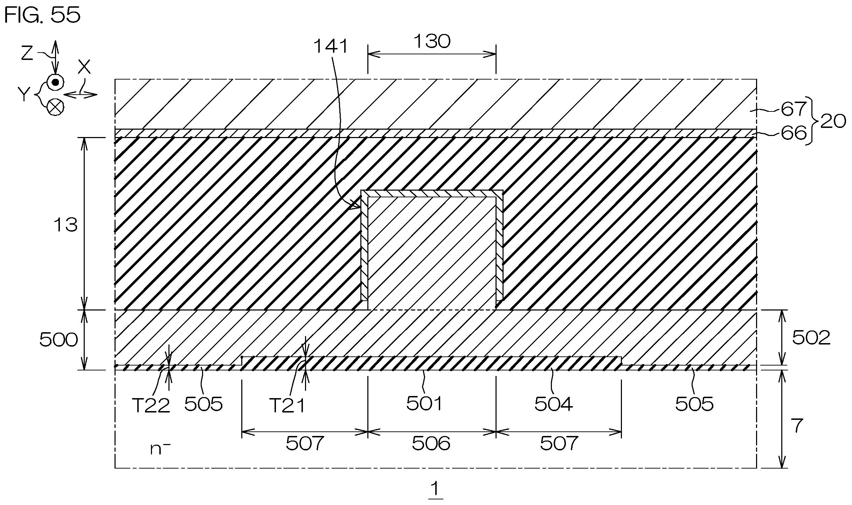

FIG. 53 is a sectional view showing another preferred embodiment of the semiconductor device 1 and corresponding to FIG. 2. FIG. 54 is a plan view showing another preferred embodiment of the semiconductor device 1 and corresponding to a portion surrounded by an alternate long and short dashed line LIV shown in FIG. 12. FIG. 55 shows another preferred embodiment of the semiconductor device 1, and is a sectional view taken along line LV-LV shown in FIG. 54.

Unlike the trench gate structure 11, the gate structure of the semiconductor device 1 may be a planar gate structure (first conductive structure, gate structure) 500 of a planar electrode type. In this case, the semiconductor device 1 includes a plurality of the planar gate structures 500 disposed on the first principal surface 3 in the active region 9. The plurality of planar gate structures 500 are arrayed in a stripe shape extending in the first direction X.

The planar gate structure 500 may include a gate electrode 502 formed on an insulating film 501 as a base insulating film. The insulating film 501 may include at least one among a silicon oxide film, a silicon nitride film, and a silicon oxynitride film and cover the first principal surface 3.

Referring to FIG. 54, the connection wiring layer 130 (the connection wiring structure 35) extends in the second direction Y such as to cross the plurality of planar gate structures 500 and a plurality of cell portions 503 formed between the plurality of planar gate structures 500. The connection wiring layer 130 may be disposed such as to face the first contact region 57 (the body region 40) in the vertical direction Z. The connection wiring layer 130 does not face the source region 55 in the vertical direction Z.

Referring to FIG. 55, the connection wiring layer 130 may be in contact with a gate electrode 502 of the planar gate structure 500 from above. Thereby, the connection wiring layer 130 and the gate electrode 502 are electrically connected. The insulating film 501 includes a thick film portion 504 and a thin film portion 505. The thick film portion 504 is selectively formed in the insulating film 501. The thin film portion 505 is formed in a region of the insulating film 501 where the thick film portion 504 is not formed.

In this embodiment, in the insulating film 501, the thick film portion 504 is formed below a connection portion 506 between the trench gate structure 11 and the planar gate structure 500 and below a lateral side region 507 of the connection portion 506. The surface of the insulating film 501 forms a convex toward the first principal surface 3 in a sectional view in the first direction X.

A thickness T21 of the thick film portion 504 of the insulating film 501 is, for example, not less than 2 µm and not more than 10 µm. A thickness T22 of the thin film portion 505 of the insulating film 501 is, for example, not less than 1 µm and not more than 5 µm. The thickness T21 of the thick film portion 504 may be not more than 3 times the thickness T22 of the thin film portion 505. The thickness T21 of the thick film portion 504 is preferably not less than 1.5 times and not more than 2.5 times the thickness T22 of the thin film portion 505. The thickness T21 of the thick film portion 504 is more preferably not less than 1.7 times and not more than 2.3 times the thickness T22 of the thin film portion 505.

The thick film portion 504 may be formed below the connection portion 506 and does not have to be formed below the lateral side region 507.

Although the preferred embodiments of the present disclosure have been described, the present disclosure can be implemented in other forms. Although with each of the preferred embodiments described above (including modification examples), an example where the first conductivity type is the n-type and the second conductivity type is the p-type was described, the first conductivity type may be the p-type and the second conductivity type may be the n-type instead. Specific configurations in this case are obtained by replacing the n-type regions with p-type regions and replacing the p-type regions with n-type regions in the description above and the attached drawings.

With the preferred embodiments described above (including modification examples), the chip 2 including the SiC monocrystal is adopted. However, the chip 2 may include a wide band gap semiconductor monocrystal other than the SiC monocrystal.

For example, with each of the preferred embodiments described above, the base layer 6 and the semiconductor layer 7 each including the SiC monocrystal are adopted. However, at least one or all of the base layer 6 and the semiconductor layer 7 may include a monocrystal of a wide band gap semiconductor other than the SiC monocrystal.

The wide bandgap semiconductor is a semiconductor having a bandgap greater than a bandgap of silicon. Examples of the monocrystal of the wide bandgap semiconductor include silicon carbide (SiC), gallium nitride (GaN), diamond (C), and gallium oxide (Ga₂O₃). The base layer 6 and the semiconductor layer 7 may be constituted of monocrystals of the same type, or may be constituted of monocrystals of different types. Also, at least one or all of the base layer 6 and the semiconductor layer 7 may be constituted of silicon (Si).

Hereinafter, examples of features extracted from the present description and the drawings shall be indicated below. Hereinafter, the alphanumeric characters, etc., in parentheses represent the corresponding components, etc., in the preferred embodiment described above, but are not intended to limit the scope of each Clause to the preferred embodiment. The "semiconductor device" in the following clauses may be replaced with an "SiC semiconductor device," a "wide bandgap semiconductor device," "a semiconductor switching device," a "semiconductor rectifier," a "MISFET device," an "IGBT device," a "diode device," etc., as needed.

### [Clause A-1]

A semiconductor device (1) including:
a chip (2) having a first principal surface (3) in which an element region (9) is formed;
a plurality of first conductive structures (11, 500) extending in a stripe shape in a first direction (X) in the element region (9) and formed of a first conductive material;
a cell portion (46, 503) formed between the plurality of first conductive structures (11, 500);
an insulating layer (13) formed on the first principal surface (3) such as to cover the first conductive structure (11, 500);
a second conductive structure (16) formed on the insulating layer (13) such as to surround the element region (9) in plan view and formed of a second conductive material having a lower resistance than the first conductive material; and
a plurality of connection wiring structures (35) formed on the first principal surface (3) such as to be covered with the insulating layer (13), extending in a line shape from the second conductive structure (16) such as to cross the cell portion (46, 503) in a second direction (Y) intersecting the first direction (X), and electrically connecting the first conductive structure (11, 500) and the second conductive structure (16).

According to this configuration, the plurality of connection wiring structures (35) cross, in a line shape, the cell portion (46, 503) extending in a stripe shape in the second direction (Y). The plurality of connection wiring structures (35) are connected to the first conductive structures (11, 500) extending in a stripe shape and electrically connect the first conductive structures (11, 500) and the second conductive structure (16).

By connecting the plurality of connection wiring structures (35) to the first conductive structures (11, 500), connection portions (151) with the connection wiring structures (35) are formed at a plurality of locations in the first direction (X) in the first conductive structures (11, 500). Signal transmission from the second conductive structure (16) to the first conductive structures (11, 500) is performed by using a path from the second conductive structure (16) to the connection portions (151) of the first conductive structures (11, 500) through the connection wiring structures (35).

Since signals are transmitted through the plurality of connection portions (151) formed at a plurality of locations in the first direction (X) in the first conductive structures (11, 500), a signal transmission distance from the second conductive structure (16) can be shortened in each portion of the first conductive structures (11, 500). Thereby, a signal from the second conductive structure (16) can be transmitted to each portion of the first conductive structures (11, 500) in a short time. Therefore, even when the size of the chip (2) is increased and the first conductive structures (11, 500) become long in the first direction (X) accordingly, signal delay can be suppressed.

### [Clause A-2]

The semiconductor device (1) according to Clause A-1, wherein the connection wiring structure (35) is formed of the first conductive material.

### [Clause A-3]

The semiconductor device (1) according to Clause A-2, wherein the first conductive material is polysilicon.

### [Clause A-4]

The semiconductor device (1) according to any one of Clauses A-1 to A-3, wherein the connection wiring structure (35) includes a connection wiring layer (130) formed on the first principal surface (3).

### [Clause A-5]

The semiconductor device (1) according to any one of Clauses A-1 to A-4, further including:
a first impurity region (7) of a first conductivity type formed in the chip (2);
a second impurity region (40) of a second conductivity type formed in a surface layer portion of the first impurity region (7) on the first principal surface (3) side; and
a third impurity region (55) of the first conductivity type formed in a surface layer portion of the second impurity region (40) on the first principal surface (3) side,
wherein the first conductive structure (11, 500) includes a gate structure (11, 500) that faces the second impurity region (40) and forms a channel in the second impurity region (40).

### [Clause A-6]

The semiconductor device (1) according to Clause A-5, wherein the gate structure (11, 500) is a trench gate structure (11) formed in the element region (9), and the second conductive structure (16) is a gate wiring (16).

### [Clause A-7]

The semiconductor device (1) according to Clause A-6, wherein the trench gate structure (11) includes a trench (41) that reaches the first impurity region (7) from the first principal surface (3) through the third impurity region (55) and the second impurity region (40), a trench insulating film (42) formed on an inner surface of the trench (41), and an embedded body (43) embedded in the trench (41) via the trench insulating film (42),
the connection wiring structure (35) includes a connection wiring layer (130) formed on the first principal surface (3), and
the connection wiring layer (130) is in contact with the embedded body (43) at an upper portion of the trench (41).

### [Clause A-8]

The semiconductor device (1) according to Clause A-7, wherein the insulating layer (13) includes a first interlayer insulating layer (63) embedded in an upper portion of the trench (41) and covering the embedded body (43), and a second interlayer insulating layer (145) covering a surface of the connection wiring layer (130).

### [Clause A-9]

The semiconductor device (1) according to Clause A-7 or A-8, wherein the cell portion (46, 503) includes a mesa portion (46) formed by being sandwiched between the plurality of adjacent trenches (41), and
further includes a first insulating film (131) covering an upper surface of the mesa portion (46), and
the connection wiring layer (130) is disposed on the mesa portion (46) via the first insulating film (131).

### [Clause A-10]

The semiconductor device (1) according to any one of Clauses A-7 to A-9, wherein a thickness (T3) of the connection wiring layer (130) is greater than a depth (DT1) of the trench (41).

### [Clause A-11]

The semiconductor device (1) according to any one of Clauses A-1 to A-10, further including a peripheral wiring structure (34) formed on the first principal surface (3) such as to be covered with the insulating layer (13) and surround the element region (9) in plan view, and electrically connected to the first conductive structure (11, 500),
wherein the connection wiring structure (35) is connected to the peripheral wiring structure (34).

### [Clause A-12]

The semiconductor device (1) according to Clause A-11, wherein the connection wiring structures (35) are connected across portions (34A, 34C; 34A, 34E) of the peripheral wiring structure (34) that face each other.

### [Clause A-13]

The semiconductor device (1) according to Clause A-11 or A-12, wherein the peripheral wiring structure (34) includes a first wiring portion (34B, 34D) formed below the second conductive structure (16).

### [Clause A-14]

The semiconductor device (1) according to any one of Clauses A-1 to A-13, wherein the chip (2) is an SiC chip.

### [Clause A-15]

The semiconductor device (1) according to any one of Clauses A-1 to A-14, wherein the second conductive material is a metal containing aluminum.

### [Clause A-16]

The semiconductor device (1) according to Clause A-5, wherein the gate structure (11, 500) is a planar gate structure (500), and
the second conductive structure (16) is a gate wiring (16).

### [Clause A-17]

The semiconductor device (1) according to any one of Clauses A-5 to A-10, including a fourth impurity region (59A) of the second conductivity type formed in a surface layer portion of the first principal surface (3) of the chip (2) and facing the connection wiring structure (35) in a thickness direction (Z) of the chip (2).

### [Clause A-18]

The semiconductor device (1) according to Clause A-17, wherein the fourth impurity region (59A) has the same depth as the second impurity region (40).

### [Clause A-19]

The semiconductor device (1) according to Clause A-17 or A-18, wherein the fourth impurity region (59A) has the same impurity concentration as the second impurity region (40).

### [Clause A-20]

The semiconductor device (1) according to any one of Clauses A-5 to A-10 and A-16, wherein the chip (2) has a second principal surface (4) opposite to the first principal surface (3),
the semiconductor device (1) further including:
a drain region (6) of the first conductivity type formed on the second principal surface side with respect to the first impurity region (7);
a body region (40) formed by the second impurity region (40); and
a source region (55) formed by the third impurity region (55).

### [Clause A-21]

The semiconductor device (1) according to any one of Clauses A-5 to A-10 and A-16, wherein the chip (2) further has a second principal surface (4) opposite to the first principal surface (3),
the semiconductor device (1) further including:
a collector region (400) of the second conductivity type formed on the second principal surface (4) side with respect to the first impurity region (7);
a base region (401) formed by the second impurity region (40); and
an emitter region (402) formed by the third impurity region (55).

### [Clause B-1]

A semiconductor device (1) including:
a chip (2) having a first principal surface (3) in which an element region (9) is formed;
a pad (15) formed on the first principal surface (3) of the chip (2);
a plurality of first conductive structures (11, 500) extending in a stripe shape in a first direction (X) between the pad (15) and an end surface (5B, 5D) of the chip (2) in the element region (9) and formed of a first conductive material;
a second conductive structure (16) electrically connected to the pad (15), having a first portion (17A, 18A) extending in the first direction (X) along the first conductive structures (11, 500) toward the end surface (5B, 5D) of the chip (2) and a second portion (17B, 18B) extending from the first portion (17A, 18A) in a second direction (Y) intersecting the first direction (X) at a first position (P1, P2) away from the pad (15) toward the end surface (5B, 5D) of the chip (2) in the first direction (X), and formed of a second conductive material having a lower resistance than the first conductive material; and
a connection wiring structure (35) formed of a third conductive material having a higher resistance than the second conductive material, and extending from the first portion (17A, 18A) of the second conductive structure (16) along the second portion (17B, 18B) of the second conductive structure (16),
wherein, in the first conductive structure (11, 500), a portion (11A) at the first position (P1, P2) in the first direction (X) is connected to the second portion (17B, 18B) of the second conductive structure (16), and a portion (11M) at a second position (PM) closer to the pad (15) than the first position (P1, P2) in the first direction (X) is connected to the connection wiring structure (35).

According to this configuration, the portion (11A) at the first position (P1, P2) in the first conductive structures (11, 500) is connected to the second portion (17B, 18B) of the second conductive structure (16) at the first position (P1, P2) far from the pad (15). The portion (11M) at the second position (PM) close to the pad (15) in the first conductive structures (11, 500) is connected to the connection wiring structure (35).

The second portion (17B, 18B) of the second conductive structure (16) has low resistance. Therefore, a signal transmission speed is high in the second portion (17B, 18B) of the second conductive structure (16) to which the portion (11A) at the first position (P1, P2) in the first conductive structures (11, 500) is connected.

On the other hand, the connection wiring structure (35) has a high resistance. Therefore, in the first portion (17A, 18A) of the second conductive structure (16) to which the portion (11M) at the second position (PM) close to the pad (15) in the first conductive structures (11, 500) is connected, the signal transmission speed is low.

Also, since the portion (11A) at the first position (P1, P2) in the first conductive structures (11, 500) is far from the pad (15), the signal transmission distance to the pad (15) is long. On the other hand, since the portion (11M) at the second position (PM) close to the pad (15) in the first conductive structures (11, 500) is close to the pad (15), the signal transmission distance to the pad (15) is short.

In this configuration, the second portion (17B, 18B) of the second conductive structure (16) having a high signal transmission speed is used for signal transmission to the portion (11A) at the first position (P1, P2) in the first conductive structures (11, 500). Also, the connection wiring structure 35 having a low signal transmission speed is used for signal transmission to the portion (11M) at the second position (PM) close to the pad (15) in the first conductive structures (11, 500).

By using the transmission speed difference between the second portion (17B, 18B) of the second conductive structure (16) and the connection wiring structure (35), arrival timings of signals at various locations of the first conductive structures (11, 500) can be made uniform. Therefore, the balance of in-plane signal transmission of the chip (2) can be improved.

### [Clause B-2]

The semiconductor device (1) according to Clause B-1, wherein a plurality of the connection wiring structures (35) are arrayed at intervals in the first direction (X) between the second portion (17B, 18B) of the second conductive structure (16) and the pad (15).

### [Clause B-3]

The semiconductor device (1) according to Clause B-2, wherein the plurality of connection wiring structures (35) are disposed at a first interval (IA) relatively far from the second portion of the second conductive structure (16), and are disposed at a second interval (IB) wider than the first interval (IA) relatively close to the second portion (17B, 18B) of the second conductive structure (16).

### [Clause B-4]

The semiconductor device (1) according to Clause B-3, wherein the second interval (IB) is not less than 1.5 times and not more than 2 times the first interval (IA).

### [Clause B-5]

The semiconductor device (1) according to Clause B-3 or B-4, wherein the second conductive structure (16) further has a third portion (19) electrically connected to the pad (15) and extending in the second direction (Y) from a third position (P3) the same as the pad (15) in the first direction (X),
wherein, in the first conductive structure, a portion at the third position (P3) in the first direction (X) is connected to the third portion (19) of the second conductive structure (16), and
wherein the plurality of connection wiring structures (35) are disposed at a third interval (IC) wider than the first interval (IA) relatively close to the third portion (19) of the second conductive structure (16).

### [Clause B-6]

The semiconductor device (1) according to Clause B-5, wherein the third interval (I16) is not less than 1.5 times and not more than 2 times the first interval (I17, I18).

### [Clause B-7]

The semiconductor device (1) according to Clause B-5 or B-6, wherein in a region between the second portion (17B, 18B) of the second conductive structure (16) and the third portion (19) of the second conductive structure (16), a wiring pitch of the plurality of connection wiring structures (35) becomes narrower toward a center in the first direction.

### [Clause B-8]

The semiconductor device (1) according to Clause B-2, wherein the plurality of connection wiring structures (35) are disposed at equal intervals.

### [Clause B-9]

The semiconductor device (1) according to any one of Clauses B-1 to B-8, wherein the third conductive material is polysilicon.

### [Clause B-10]

The semiconductor device (1) according to Clause B-9, wherein the third conductive material is the same material as the first conductive material.

### [Clause B-11]

The semiconductor device (1) according to any one of Clauses B-1 to B-10, wherein the connection wiring structure (35) includes a connection wiring layer (130) formed on the first principal surface (3).

### [Clause B-12]

The semiconductor device (1) according to any one of Clauses B-1 to B-11, further including:
a first impurity region (7) of a first conductivity type formed in the chip (2);
a second impurity region (40) of a second conductivity type formed in a surface layer portion of the first impurity region (7) on the first principal surface (3) side; and
a third impurity region (55) of the first conductivity type formed in a surface layer portion of the second impurity region (40) on the first principal surface (3) side,
wherein the first conductive structure (11, 500) includes a gate structure (11, 500) that faces the second impurity region (40) and forms a channel in the second impurity region (40).

### [Clause B-13]

The semiconductor device (1) according to Clause B-12, wherein the gate structure (11, 500) is a trench gate structure (11), and the second conductive structure (16) is a gate wiring (16).

### [Clause B-14]

The semiconductor device (1) according to any one of Clauses B-1 to B-13, wherein the chip (2) is an SiC chip.

### [Clause B-15]

The semiconductor device (1) according to any one of Clauses B-1 to B-14, wherein the second conductive material is a metal containing aluminum.

### [Clause B-16]

The semiconductor device (1) according to Clause B-12, wherein the gate structure (11, 500) is a planar gate structure (500), and
the second conductive structure (16) is a gate wiring (16).

### [Clause B-17]

The semiconductor device (1) according to any one of Clauses B-12, B-13, and B-16, including a fourth impurity region (59A) of the second conductivity type formed in a surface layer portion of the first principal surface (3) of the chip (2) and facing the connection wiring structure (35) in a thickness direction (Z) of the chip (2).

### [Clause B-18]

The semiconductor device (1) according to Clause B-17, wherein the fourth impurity region (59A) has the same depth as the second impurity region (40).

### [Clause B-19]

The semiconductor device (1) according to Clause B-17 or B-18, wherein the fourth impurity region (59A) has the same impurity concentration as the second impurity region (40).

### [Clause B-20]

The semiconductor device (1) according to any one of Clauses B-12, B-13, and B-16, wherein the chip (2) has a second principal surface (4) opposite to the first principal surface (3),
the semiconductor device (1) further including:
a drain region (6) of the first conductivity type formed on the second principal surface side with respect to the first impurity region (7);
a body region (40) formed by the second impurity region (40); and
a source region (55) formed by the third impurity region (55).

### [Clause B-21]

The semiconductor device (1) according to any one of Clauses B-12, B-13, and B-16, wherein the chip (2) further has a second principal surface (4) opposite to the first principal surface (3),
the semiconductor device (1) further including:
a collector region (400) of the second conductivity type formed on the second principal surface (4) side with respect to the first impurity region (7);
a base region (401) formed by the second impurity region (40); and
an emitter region (402) formed by the third impurity region (55).

### [Clause C-1]

A semiconductor device (1) including:
a chip (2) of a quadrangular shape in plan view and having a first principal surface (3) in which an element region (9) is formed;
a plurality of first conductive structures (11, 500) extending in a stripe shape in a first direction (X) in the element region (9) and formed of a first conductive material;
an insulating layer (13) formed on the first principal surface (3) such as to cover the first conductive structures (11, 500),
a pad (15) formed on the insulating layer (13);
a second conductive structure (16) formed on the insulating layer (13) such as to be electrically connected to the pad (15), having a first portion (17A, 18A) extending in the first direction (X) along the first conductive structure (11, 500) toward a first end surface (5B, 5D) of the chip (2) and a second portion (17B, 18B) extending from the first portion (17A, 18A) along the first end surface (5B, 5D) in a second direction (Y) intersecting the first direction (X) and having a terminal portion (17D, 18D) at a corner portion (C) of the chip (2), and constituted of a metal wiring; and
a peripheral wiring structure (34) formed on the first principal surface (3) such as to be covered with the insulating layer (13), extending from the terminal portion (17D, 18D) of the second portion (17B, 18B) of the second conductive structure (16) along a second end surface (5C) intersecting the first end surface (5B, 5D), and electrically connected to the first conductive structure (11, 500).

According to this configuration, the second conductive structure (16) constituted of a metal wiring is not formed in a region between the element region (9) and the second end surface (5C). Therefore, the element region (9) can be enlarged by disposing a peripheral edge at an outer side of the element region (9) close to the second end surface (5C). Thereby, an area ratio of the element region (9) to an entirety of the chip (2) can be increased. Therefore, the in-plane surface of the chip (2) can be effectively used, and loss can be reduced.

### [Clause C-2]

The semiconductor device (1) according to Clause C-1, wherein the peripheral wiring structure (34) is formed of the first conductive material.

### [Clause C-3]

The semiconductor device (1) according to Clause C-2, wherein the first conductive material is polysilicon.

### [Clause C-4]

The semiconductor device (1) according to Clauses C-1 to C-3, wherein a terminal region (170) having an arcuate corner portion (175A) of an arcuate shape in plan view at a corner portion (C) of the chip (2) and surrounding the element region (9) is formed in the first principal surface (3) of the chip (2), and
the terminal portion (17D, 18D) of the second portion (17B, 18B) retreats to a side opposite to the second end surface (5C) such as not to face the arcuate corner portion in the first direction (X) in plan view at the corner portion (C) of the chip (2).

### [Clause C-5]

The semiconductor device (1) according to any one of Clauses C-1 to C-4, further including a plurality of connection wiring structures (35) connected to the peripheral wiring structure (34) and extending in a line shape such as to cross the plurality of the first conductive structures (11, 500).

### [Clause C-6]

The semiconductor device (1) according to Clause C-5, wherein the peripheral wiring structure (34) is formed in an annular shape surrounding the element region (9), and
the connection wiring structure (35) is connected across portions (34A, 34C; 34F, 34C) of the peripheral wiring structure (34) facing each other.

### [Clause C-7]

The semiconductor device (1) according to Clause C-5 or C-6, wherein the peripheral wiring structure (34) includes
a first wiring portion (34B, 34D) formed below the second portion (17B, 18B) of the second conductive structure (16) and
a second wiring portion (34C) connected to the first wiring portion (34B, 34D) and extending along the second end surface (5C) from the terminal portion (17D, 18D) of the second portion (17B, 18B) of the second conductive structure (16), and
wherein the connection wiring structure (35) electrically connects the first wiring portion (34B, 34D) and the second wiring portion (34C).

### [Clause C-8]

The semiconductor device (1) according to any one of Clauses C-5 to C-7, wherein the connection wiring structure (35) is formed of the first conductive material.

### [Clause C-9]

The semiconductor device (1) according to any one of Clauses C-5 to C-8, wherein the connection wiring structure (35) includes a connection wiring layer (130) formed on the first principal surface (3).

### [Clause C-10]

The semiconductor device (1) according to any one of Clauses C-1 to C-4, wherein the peripheral wiring structure (34) includes
a first wiring portion (34B, 34D) formed below the second portion (17B, 18B) of the second conductive structure (16) and
a second wiring portion (34C) connected to the first wiring portion (34B, 34D) and extending along the second end surface (5C) from the terminal portion (17D, 18D) of the second portion (17B, 18B) of the second conductive structure (16).

### [Clause C-11]

The semiconductor device (1) according to Clause C-7 or C-10, wherein the first wiring portion (34B, 34D) has a first width (WW2, WW4), and the second wiring portion (34C) has a second width (WW3) narrower than the first width (WW2, WW4).

### [Clause C-12]

The semiconductor device (1) according to claim 11, wherein the second width (WW3) is narrower than a width of the second portion (17B, 18B) of the second conductive structure (16).

### [Clause C-13]

The semiconductor device (1) according to any one of Clauses C-1 to C-12, further including:
a first impurity region (7) of a first conductivity type formed in the chip (2);
a second impurity region (40) of a second conductivity type formed in a surface layer portion of the first impurity region (7) on the first principal surface (3) side; and
a third impurity region (55) of the first conductivity type formed in a surface layer portion of the second impurity region (40) on the first principal surface (3) side,
wherein the first conductive structure (11, 500) includes a gate structure (11, 500) that faces the second impurity region (40) and forms a channel in the second impurity region (40).

### [Clause C-14]

The semiconductor device (1) according to Clause C-13, wherein the gate structure (11, 500) is a trench gate structure (11), and the second conductive structure (16) is a gate wiring (16).

### [Clause C-15]

The semiconductor device (1) according to any one of Clauses C-1 to C-14, wherein the chip (2) is an SiC chip.

### [Clause C-16]

The semiconductor device (1) according to any one of Clauses C-1 to C-15, wherein the metal wiring is formed of a metal containing aluminum.

### [Clause C-17]

The semiconductor device (1) according to Clause C-13, wherein the gate structure (11, 500) is a planar gate structure (500), and
the second conductive structure (16) is a gate wiring (16).

### [Clause C-18]

The semiconductor device (1) according to any one of Clauses C-13, C-14, and C-17, further including a connection wiring structure (35) connected to the peripheral wiring structure (34) and extending in a line shape such as to cross the plurality of the first conductive structures (11, 500),
the semiconductor device (1) including a fourth impurity region (59A) of the second conductivity type formed in a surface layer portion of the first principal surface (3) of the chip (2) and facing the connection wiring structure (35) in a thickness direction (Z) of the chip (2).

### [Clause C-19]

The semiconductor device (1) according to Clause C-18, wherein the fourth impurity region (59A) has the same depth as the second impurity region (40).

### [Clause C-20]

The semiconductor device (1) according to Clause C-18 or C-19, wherein the fourth impurity region (59A) has the same impurity concentration as the second impurity region (40).

### [Clause C-21]

The semiconductor device (1) according to any one of Clauses C-13, C-14, and C-17, wherein the chip (2) has a second principal surface (4) opposite to the first principal surface (3),
the semiconductor device (1) further including:
a drain region (6) of the first conductivity type formed on the second principal surface (4) side with respect to the first impurity region (7);
a body region (40) formed by the second impurity region (40); and
a source region (55) formed by the third impurity region (55).

### [Clause C-22]

The semiconductor device (1) according to any one of Clauses C-13, C-14, and C-17, wherein the chip (2) further has a second principal surface (4) opposite to the first principal surface (3),
the semiconductor device (1) further including:
a collector region (400) of the second conductivity type formed on the second principal surface (4) side with respect to the first impurity region (7);
a base region (401) formed by the second impurity region (40); and
an emitter region (402) formed by the third impurity region (55).

### [Clause D-1]

A semiconductor device (1) including:
a chip (2) having a first principal surface (3) in which an element region (9) is formed;
a first conductive structure (11, 500) formed in the element region (9);
an insulating layer (13) formed on the first principal surface (3) such as to cover the first conductive structure (11, 500);
a pad (15) formed on the insulating layer (13);
a second conductive structure (16) formed on the insulating layer (13) and constituted of a metal wiring extending along a peripheral edge of the element region (9) at an interval from the pad (15) in a facing direction (Y) along the first principal surface (3); and
a wiring structure (230) formed on the first principal surface (3) such as to be covered with the insulating layer (13), constituted of a material having a higher resistance than the metal wiring (16), and connected to the first conductive structure (11, 500),
wherein the wiring structure (230) includes
a first structure portion (215) formed to straddle between below the pad (15) and below the second conductive structure (16), and having a first contact portion (218) electrically connected to the pad (15) and a second contact portion (220) electrically connected to the second conductive structure (16),
a second structure portion (34A, 34E) disposed below the second conductive structure (16), having a third contact portion (193) electrically connected to the second conductive structure (16), and connected to the first conductive structure (11, 500), and
a connection structure portion (216) that connects the first structure portion (215) and the second structure portion (34A, 34E).

According to this configuration, as current paths from the pad (15) to the first conductive structure (11, 500), there are at least two paths of a first path (RT1) that passes through the first structure portion (215), the second conductive structure (16), and the second structure portion (34A, 34E) to the first conductive structure (11, 500), and a second path (RT2) that passes through the first structure portion (215), the connection structure portion (216), and the second structure portion (34A, 34E) to the first conductive structure (11, 500) through the second structure portion (34A, 34E).

The second conductive structure (16) constituted of a metal wiring has a lower resistance than the connection structure portion (216). Therefore, a current reaching the first structure portion (215) from the pad (15) is more likely to flow to the second conductive structure (16) than the connection structure portion (216). That is, the first path (RT1) is preferentially selected over the second path (RT2) based on the difference in resistivity. Therefore, an optimal current path can be secured.

Also, the first structure portion (215) and the second structure portion (34A, 34E) are connected by the connection structure portion (216). Since the first structure portion (215) and the second structure portion (34A, 34E) are not divided, an uneven shape in the wiring structure (230) can be reduced. Thereby, it is possible to suppress or prevent a stress distribution from being biased in the wiring structure (230).

### [Clause D-2]

The semiconductor device (1) according to Clause D-1, wherein the wiring structure (230) is formed of the same material as the first conductive structure (11, 500).

### [Clause D-3]

The semiconductor device (1) according to Clause D-2, wherein the wiring structure (230) is formed of polysilicon.

### [Clause D-4]

The semiconductor device (1) according to any one of Clauses D-1 to D-3, wherein a lower portion (223) of the first structure portion (215), a lower portion (225) of the second structure portion (34A, 34E), and a lower portion (224) of the connection structure portion (216) are at the same depth position as each other.

### [Clause D-5]

The semiconductor device (1) according to any one of Clauses D-1 to D-4, wherein the wiring structure (230) includes a wiring layer formed on the first principal surface (3).

### [Clause D-6]

The semiconductor device (1) according to any one of Clauses D-1 to D-5, wherein the connection structure portion (216) has a second facing width (IF2) in the facing direction (Y) that is different from a first facing width (IF1) in the facing direction (Y) of the first structure portion (215).

### [Clause D-7]

The semiconductor device (1) according to Clause D-6, wherein the second facing width (IF2) is equal to the first facing width (IF1) or narrower than the first facing width (IF1).

### [Clause D-8]

The semiconductor device (1) according to Clause D-7, wherein the second contact portion (222) faces the connection structure portion (216) in a direction (X) intersecting the facing direction (Y), and
wherein the first contact portion (219) does not face the connection structure portion (216) in the direction (X) intersecting the facing direction (Y).

### [Clause D-9]

The semiconductor device (1) according to Clause D-7, wherein the first contact portion (219) and the second contact portion (222) face the connection structure portion (216) in a direction (X) intersecting the facing direction (Y).

### [Clause D-10]

The semiconductor device (1) according to any one of Clauses D-1 to D-9, wherein the connection structure portion (216) includes a pair of the connection structure portions (216) sandwiching the first structure portion (215) in a direction (X) intersecting the facing direction (Y).

### [Clause D-11]

The semiconductor device (1) according to any one of Clauses D-1 to D-10, wherein the wiring structure (230) is formed in an annular shape surrounding a periphery of the element region (9) in plan view.

### [Clause D-12]

The semiconductor device (1) according to any one of Clauses D-1 to D-11, further including a connection wiring structure (35) connected to the wiring structure (230) and extending in a line shape such as to cross the plurality of the first conductive structures (11, 500).

### [Clause D-13]

The semiconductor device (1) according to any one of Clauses D-1 to D-12, further including:
a first impurity region (7) of a first conductivity type formed in the chip (2);
a second impurity region (40) of a second conductivity type formed in a surface layer portion of the first impurity region (7) on the first principal surface (3) side; and
a third impurity region (55) of the first conductivity type formed in a surface layer portion of the second impurity region (40) on the first principal surface (3) side,
wherein the first conductive structure (11, 500) includes a gate structure (11, 500) that faces the second impurity region (40) and forms a channel in the second impurity region (40).

### [Clause D-14]

The semiconductor device (1) according to Clause D-13, wherein the gate structure (11, 500) is a trench gate structure (11), and the second conductive structure (16) is a gate wiring (16).

### [Clause D-15]

The semiconductor device (1) according to any one of Clauses D-1 to D-14, wherein the chip (2) is an SiC chip.

### [Clause D-16]

The semiconductor device (1) according to any one of Clauses D-1 to D-15, wherein the metal wiring (16) is formed of a metal containing aluminum.

### [Clause D-17]

The semiconductor device (1) according to Clause D-13, wherein the gate structure (11, 500) is a planar gate structure (500), and
the second conductive structure (16) is a gate wiring (16).

### [Clause D-18]

The semiconductor device (1) according to any one of Clauses D-13, D-14, and D-17, further including a connection wiring structure (35) connected to the wiring structure (230) and extending in a line shape such as to cross the plurality of the first conductive structures (11, 500),
the semiconductor device (1) including a fourth impurity region (59A) of the second conductivity type formed in a surface layer portion of the first principal surface (3) of the chip (2) and facing the connection wiring structure (35) in a thickness direction (Z) of the chip (2).

### [Clause D-19]

The semiconductor device (1) according to Clause D-18, wherein the fourth impurity region (59A) has the same depth as the second impurity region (40).

### [Clause D-20]

The semiconductor device (1) according to Clause D-18 or D-19, wherein the fourth impurity region (59A) has the same impurity concentration as the second impurity region (40).

### [Clause D-21]

The semiconductor device (1) according to any one of Clauses D-13, D-14, and D-17, wherein the chip (2) has a second principal surface (4) opposite to the first principal surface (3),
the semiconductor device (1) further including:
a drain region (6) of the first conductivity type formed on the second principal surface (4) side with respect to the first impurity region (7);
a body region (40) formed by the second impurity region (40); and
a source region (55) formed by the third impurity region (55).

### [Clause D-22]

The semiconductor device (1) according to any one of Clauses D-13, D-14, and D-17, wherein the chip (2) further has a second principal surface (4) opposite to the first principal surface (3),
the semiconductor device (1) further including:
a collector region (400) of the second conductivity type formed on the second principal surface (4) side with respect to the first impurity region (7);
a base region (401) formed by the second impurity region (40); and
an emitter region (402) formed by the third impurity region (55).

### [Clause E-1]

A semiconductor device (1) including:
a chip (2) having a first principal surface (3) in which an element region (9) is formed;
a plurality of first conductive structures (11, 500) extending in a stripe shape in a first direction (X) in the element region (9) and formed of a first conductive material;
a cell portion (46, 503) formed between the plurality of first conductive structures (11, 500);
an insulating layer (13) formed on the first principal surface (3) such as to cover the first conductive structure (11, 500);
a second conductive structure (16) formed on the insulating layer (13) such as to surround the element region (9) in plan view and formed of a second conductive material having a lower resistance than the first conductive material;
a plurality of connection wiring structures (35) formed on the first principal surface (3) such as to be covered with the insulating layer (13), extending in a line shape from the second conductive structure (16) such as to cross the cell portion (46, 503) in a second direction (Y) intersecting the first direction (X), and electrically connecting the first conductive structure (11, 500) and the second conductive structure (16); and
a first silicide layer (141) formed on a surface of the connection wiring structures (35).

According to this configuration, the plurality of connection wiring structures (35) cross, in a line shape, the cell portion (46, 503) extending in a stripe shape in the second direction (Y). The plurality of connection wiring structures (35) are connected to the first conductive structures (11, 500) extending in a stripe shape and electrically connect the first conductive structures (11, 500) and the second conductive structure (16).

By connecting the plurality of connection wiring structures (35) to the first conductive structures (11, 500), connection portions (151) with the connection wiring structures (35) are formed at a plurality of locations in the first direction (X) in the first conductive structures (11, 500). Signal transmission from the second conductive structure (16) to the first conductive structures (11, 500) is performed by using a path from the second conductive structure (16) to the connection portions (151) of the first conductive structures (11, 500) through the connection wiring structures (35).

Since a signal is transmitted through a plurality of connecting portions formed at a plurality of locations in the first direction (X) in the first conductive structures (11, 500), a signal transmission distance from the second conductive structure (16) can be shortened in each portion of the first conductive structures (11, 500). Thereby, a signal from the second conductive structure (16) can be transmitted to each portion of the first conductive structures (11, 500) in a short time. Therefore, even when the size of the chip (2) is increased and the first conductive structures (11, 500) become long in the first direction (X) accordingly, signal delay can be suppressed.

Also, the first silicide layer (141) is formed on the surface of the connection wiring structures (35). As compared with a case in which the first silicide layer (141) is not formed in the connection wiring structures (35), the resistance of the connection wiring structures (35) can be reduced. Therefore, even when the chip (2) is increased in size, signal delay can be suppressed.

### [Clause E-2]

The semiconductor device (1) according to Clause E-1, wherein the first silicide layer (141) is formed on an upper surface (134) and a side surface (135, 136) of the connection wiring structures (35).

### [Clause E-3]

The semiconductor device (1) according to Clause E-1, wherein the first silicide layer (141) is formed on the upper surface (134) of the connection wiring structures (35), and is not formed on the side surface (135, 136) of the connection wiring structures (35).

### [Clause E-4]

The semiconductor device (1) according to any one of Clauses E-1 to E-3, wherein the first silicide layer (141) contains at least one among Ni silicide, Ti silicide, and W silicide.

### [Clause E-5]

The semiconductor device (1) according to any one of Clauses E-1 to E-4, further including a peripheral wiring structure (34) formed on the first principal surface (3) such as to be covered with the insulating layer (13) and surround the element region (9) in plan view, and electrically connected to the first conductive structures (11, 500),
wherein the connection wiring structure (35) is connected to the peripheral wiring structure (34), and
the semiconductor device (1) further including a second silicide layer (184) formed on a surface of the peripheral wiring structure (34).

Also, the first silicide layer (141) is formed on the surface of the peripheral wiring structure (34). As compared with a case in which the second silicide layer (184) is not formed in the peripheral wiring structure (34), the resistance of the peripheral wiring structure (34) can be reduced.

### [Clause E-6]

The semiconductor device (1) according to Clause E-5, wherein the second silicide layer (184) is formed on an upper surface (186) and a side surface (188) of the peripheral wiring structure (34).

As compared with a case in which the second silicide layer (184) is formed only on one of the upper surface (186) and the side surface (188) of the peripheral wiring structure (34) in which the second silicide layer (184) is formed on both the upper surface (186) and the side surface (188) of the peripheral wiring structure (34), the resistance of the peripheral wiring structure (34) can be effectively reduced.

### [Clause E-7]

The semiconductor device (1) according to Clause E-5 or E-6, wherein the first silicide layer (141) contains at least one among Ni silicide, Ti silicide, and W silicide.

### [Clause E-8]

The semiconductor device (1) according to any one of Clauses E-1 to E-7, wherein the connection wiring structure (35) is formed of the first conductive material.

### [Clause E-9]

The semiconductor device (1) according to Clause E-8, wherein the first conductive material is polysilicon.

### [Clause E-10]

The semiconductor device (1) according to any one of Clauses E-1 to E-9, wherein the connection wiring structure (35) includes a connection wiring layer (130) formed on the first principal surface (3).

### [Clause E-11]

The semiconductor device (1) according to any one of Clauses E-1 to E-10, further including:
a first impurity region (7) of a first conductivity type formed in the chip (2);
a second impurity region (40) of a second conductivity type formed in a surface layer portion of the first impurity region (7) on the first principal surface (3) side; and
a third impurity region (55) of the first conductivity type formed in a surface layer portion of the second impurity region (40) on the first principal surface (3) side,
wherein the first conductive structure (11, 500) includes a gate structure (11, 500) that faces the second impurity region (40) and forms a channel in the second impurity region (40).

### [Clause E-12]

The semiconductor device (1) according to Clause E-11, wherein the gate structure (11, 500) is a trench gate structure (11), and the second conductive structure (16) is a gate wiring (16).

### [Clause E-13]

The semiconductor device (1) according to any one of Clauses E-1 to E-12, wherein the chip (2) is an SiC chip.

### [Clause E-14]

The semiconductor device (1) according to any one of Clauses E-1 to E-13, wherein the second conductive material is a metal containing aluminum.

### [Clause E-15]

The semiconductor device (1) according to Clause E-11, wherein the gate structure (11, 500) is a planar gate structure (500), and
the second conductive structure (16) is a gate wiring (16).

### [Clause E-16]

The semiconductor device (1) according to any one of Clauses E-11, E-12, and E-15, including a fourth impurity region (59A) of the second conductivity type formed in a surface layer portion of the first principal surface (3) of the chip (2) and facing the connection wiring structure (35) in a thickness direction (Z) of the chip (2).

### [Clause E-17]

The semiconductor device (1) according to Clause E-16, wherein the fourth impurity region (59A) has the same depth as the second impurity region (40).

### [Clause E-18]

The semiconductor device (1) according to Clause E-16 or E-17, wherein the fourth impurity region (59A) has the same impurity concentration as the second impurity region (40).

### [Clause E-19]

The semiconductor device (1) according to any one of Clauses E-11, E-12, and E-15 to E-18, wherein the chip (2) has a second principal surface (4) opposite to the first principal surface (3),
the semiconductor device (1) further including:
a drain region (6) of the first conductivity type formed on the second principal surface (4) side with respect to the first impurity region (7);
a body region (40) formed by the second impurity region (40); and
a source region (55) formed by the third impurity region (55).

### [Clause E-20]

The semiconductor device (1) according to any one of Clauses E-11, E-12, and E-15 to E-18, wherein the chip (2) further has a second principal surface (4) opposite to the first principal surface (3),
the semiconductor device (1) further including:
a collector region (400) of the second conductivity type formed on the second principal surface (4) side with respect to the first impurity region (7);
a base region (401) formed by the second impurity region (40); and
an emitter region (402) formed by the third impurity region (55).

### [Clause F-1]

A semiconductor device (1) including:
a chip (2) having a first principal surface (3) in which an element region (9) is formed;
a plurality of first conductive structures (11, 500) extending in a stripe shape in a first direction (X) in the element region (9) and formed of a first conductive material;
a base insulating film (42, 501) between the first conductive structure (11, 500) and the chip (2);
an insulating layer (13) formed on the first principal surface (3) such as to cover the first conductive structures (11, 500);
a second conductive structure (16) formed on the insulating layer (13) such as to surround the element region (9) in plan view and formed of a second conductive material having a lower resistance than the first conductive material; and
a plurality of connection wiring structures (35) formed on the first principal surface (3) such as to be covered with the insulating layer (13), extending in a line shape across the first conductive structures (11, 500) in a second direction (Y) intersecting the first direction (X) from the second conductive structure (16), and electrically connecting the first conductive structures (11, 500) and the second conductive structure (16),
wherein the base insulating film (42, 501) includes a thick film portion (154, 504) selectively formed thick at a connection portion (151) between the first conductive structure (11, 500) and the connection wiring structure (35).

According to this configuration, the base insulating film (42, 501) of the connection portion (151) between the first conductive structure (11, 500) and the connection wiring structure (35) is selectively made thick. Therefore, the reliability of the first conductive structure (11, 500) can be improved.

### [Clause F-2]

The semiconductor device (1) according to Clause F-1, wherein an upper surface of the base insulating film (42, 501) forms a convex toward the first principal surface (3) in a sectional view in the first direction (X).

### [Clause F-3]

The semiconductor device (1) according to Clause F-1 or F-2, wherein the thick film portion (154, 504) is formed below the connection portion (151) and below a lateral side region (152, 153) of the connection portion (151).

### [Clause F-4]

The semiconductor device (1) according to any one of Clauses F-1 to F-3, wherein the thick film portion (154, 504) has a thickness not less than 1.5 times a thickness of another region (E2) in which the thick film portion (154, 504) is not formed in the base insulating film (42, 501).

### [Clause F-5]

The semiconductor device (1) according to any one of Clauses F-1 to F-4, further including:
a first impurity region (7) of a first conductivity type formed in the chip (2);
a second impurity region (40) of a second conductivity type formed in a surface layer portion of the first impurity region (7) on the first principal surface (3) side; and
a third impurity region (55) of the first conductivity type formed in a surface layer portion of the second impurity region (40) on the first principal surface (3) side,
wherein the first conductive structure (11, 500) includes a gate structure (11, 500) that faces the second impurity region (40) and forms a channel in the second impurity region (40).

### [Clause F-6]

The semiconductor device (1) according to Clause F-5, wherein the gate structure (11, 500) is a trench gate structure (11), and the second conductive structure (16) is a gate wiring (16).

### [Clause F-7]

The semiconductor device (1) according to Clause F-6, wherein the trench gate structure (11) includes a trench (41) that reaches the first impurity region (7) from the first principal surface (3) through the third impurity region (55) and the second impurity region (40), and
the base insulating film (42, 501) includes a trench insulating film (42) formed on an inner surface of the trench (41).

### [Clause F-8]

The semiconductor device (1) according to Clause F-7, wherein the connection wiring structure (35) includes a connection wiring layer (130) formed on the first principal surface (3), and
the connection wiring layer (130) is in contact with an embedded body (43) embedded in the trench (41) via the trench insulating film (42).

### [Clause F-9]

The semiconductor device (1) according to Clause F-8, wherein an upper surface height of the embedded body (43) above the thick film portion (154, 504) is positioned higher than an upper surface height of the embedded body (43) above another region (E2) in which the thick film portion (154, 504) is not formed in the base insulating film (42, 501).

### [Clause F-10]

The semiconductor device (1) according to any one of Clauses F-1 to F-9, wherein the connection wiring structure (35) is formed of the first conductive material.

### [Clause F-11]

The semiconductor device (1) according to any one of Clauses F-1 to F-10, wherein the first conductive material is polysilicon.

### [Clause F-12]

The semiconductor device (1) according to any one of Clauses F-5 to F-9, further including a fourth impurity region (59A) of the second conductivity type formed in a surface layer portion of the first principal surface (3) of the chip (2) and facing the connection wiring structure (35) in a thickness direction (Z) of the chip (2).

### [Clause F-13]

The semiconductor device (1) according to Clause F-12, wherein the fourth impurity region (59A) has the same depth as the second impurity region (40).

### [Clause F-14]

The semiconductor device (1) according to any one of Clauses F-1 to F-13, wherein the chip (2) is an SiC chip.

### [Clause F-15]

The semiconductor device (1) according to any one of Clauses F-1 to F-14, wherein the second conductive material is a metal containing aluminum.

### [Clause F-16]

The semiconductor device (1) according to any one of Clauses F-5 to F-9, F-12, and F-13, wherein the gate structure (11, 500) is a planar gate structure (500), and
the second conductive structure (16) is a gate wiring (16).

### [Clause F-17]

The semiconductor device (1) according to Clause F-12 or F-13, wherein the fourth impurity region (59A) has the same impurity concentration as the second impurity region (40).

### [Clause F-18]

The semiconductor device (1) according to any one of Clauses F-5 to F-9, F-12, and F-13, wherein the chip (2) has a second principal surface (4) opposite to the first principal surface (3),
the semiconductor device (1) further including:
a drain region (6) of the first conductivity type formed on the second principal surface (4) side with respect to the first impurity region (7);
a body region (40) formed by the second impurity region (40); and
a source region (55) formed by the third impurity region (55).

### [Clause F-19]

The semiconductor device (1) according to any one of Clauses F-5 to F-9, F-12, and F-13, wherein the chip (2) further has a second principal surface (4) opposite to the first principal surface (3),
the semiconductor device (1) further including:
a collector region (400) of the second conductivity type formed on the second principal surface (4) side with respect to the first impurity region (7);
a base region (401) formed by the second impurity region (40); and
an emitter region (402) formed by the third impurity region (55).

### [Clause G-1]

A semiconductor device (1) including:
a chip (2) having a first principal surface (3) in which an element region (9) is formed;
a plurality of first trench structures (11) extending in a stripe shape in a first direction (X) in the element region (9) and formed of a first conductive material;
a first dummy trench structure (92) disposed outside the plurality of first trench structures (11) in the element region (9) and extending side by side in the first trench structures (11); and
a second dummy trench structure (93, 93A) extending side by side with the first trench structures (11) in the middle of the first dummy trench structure (92) and electrically separated from the first dummy trench structure (92).

According to this configuration, in the middle of the first dummy trench structure (92), the second dummy trench structure (93, 93A) extending side by side with the first trench structures (11) and electrically separated from the first dummy trench structure (92) is disposed.

If the first dummy trench structure (92) is divided in the middle of the first direction (X) and the second dummy trench structure (93, 93A) is not formed, it is not possible to suppress the electric field concentration around the middle of the first dummy trench structure (92), and there is a possibility that a region where the withstand voltage is considerably lowered is formed.

In a case in which the withstand voltage of the second dummy trench structure (93, 93A) is high, by forming the second dummy trench structure (93, 93A) in the middle of the first dummy trench structure 92, it is possible to suppress the electric field concentration at the periphery in the middle of the first dummy trench structure (92), and it is possible to reduce formation of a region where the withstand voltage is considerably lowered at the periphery. Thereby, it is possible to reduce the region where the withstand voltage is considerably lowered outside the plurality of first trench structures (11) in the element region (9).

### [Clause G-2]

The semiconductor device (1) according to Clause G-1, wherein the second dummy trench structure (93A) includes a plurality of second dummy trench structures (93A) formed at intervals in a second direction (Y) intersecting the first direction (X), and
terminal portions (106, 107) of the plurality of second dummy trench structures (93A) are aligned in regard to the first direction (X).

### [Clause G-3]

The semiconductor device (1) according to Clause G-2, wherein lengths of the plurality of second dummy trench structures (93A) are the same.

### [Clause G-4]

The semiconductor device (1) according to Clause G-2 or G-3, wherein an interval (I1) in the first direction (X) between the terminal portion (106, 107) of the second dummy trench structure (93A) and the first dummy trench structure (92) is narrower than an interval (PT3) in the second direction (Y) between the plurality of adjacent second dummy trench structures (93A).

### [Clause G-5]

The semiconductor device (1) according to any one of Clauses G-1 to G-4, wherein the first dummy trench structure (92) is a floating trench structure to which a potential is not applied.

### [Clause G-6]

The semiconductor device (1) according to any one of Clauses G-1 to G-5, including:
a first impurity region (7) of a first conductivity type formed in the chip (2);
a second impurity region (40) of a second conductivity type formed in a surface layer portion of the first impurity region (7) on the first principal surface (3) side;
a third impurity region (55) of the first conductivity type formed in a surface layer portion of the second impurity region (40) on the first principal surface (3) side; and
a fourth impurity region (84) of the second conductivity type formed in a surface layer portion of the first principal surface (3) of the chip (2),
wherein the second dummy trench structure (93A) includes a dummy trench (110) formed in the fourth impurity region (84), a dummy insulating film (111) formed on an inner surface of the dummy trench (110), and a dummy embedded body (112) embedded in the dummy trench (110) via the dummy insulating film (111), and
wherein the first trench structure (11) includes a trench gate structure (11) facing the second impurity region (40) and forming a channel in the second impurity region (40).

### [Clause G-7]

The semiconductor device (1) according to Clause G-6, further including an electric field relaxation layer (113) of the second conductivity type formed at a bottom portion of the dummy trench (110).

### [Clause G-8]

The semiconductor device (1) according to Clause G-6 or G-7, wherein the trench gate structure (11) includes a trench (41) that reaches the first impurity region (7) from the first principal surface (3) through the third impurity region (55) and the second impurity region (40), a trench insulating film (42) formed on an inner surface of the trench (41), and an embedded body (43) embedded in the trench (41) via the trench insulating film (42).

### [Clause G-9]

The semiconductor device (1) according to any one of Clauses G-1 to G-8, further including a connection wiring structure (35) extending such as to cross the plurality of the first trench structures (11) in a line shape in a second direction (Y) intersecting the first direction (X) and connected to the first trench structures (11),
wherein the second dummy trench structure (93A) is connected to the connection wiring structure (35).

### [Clause G-10]

The semiconductor device (1) according to Clause G-9, wherein the connection wiring structure (35) extends such as to cross the second dummy trench structure (93A).

### [Clause G-11]

The semiconductor device (1) according to Clause G-9 or G-10, wherein the connection wiring structure (35) includes a connection wiring layer (130) formed on the first principal surface (3).

### [Clause G-12]

The semiconductor device (1) according to any one of Clauses G-9 to G-11, wherein the connection wiring structure (35) is electrically connected to a gate wiring (16).

### [Clause G-13]

The semiconductor device (1) according to any one of Clauses G-9 to G-12, wherein the connection wiring structure (35) is formed of the first conductive material.

### [Clause G-14]

The semiconductor device (1) according to any one of Clauses G-1 to G-13, wherein the first conductive material is polysilicon.

### [Clause G-15]

The semiconductor device (1) according to any one of Clauses G-1 to G-14, wherein the chip (2) is an SiC chip.

### [Clause G-16]

The semiconductor device (1) according to any one of Clauses G-6 to G-8, wherein the fourth impurity region (84) has the same depth as the second impurity region (40).

### [Clause G-17]

The semiconductor device (1) according to any one of Clauses G-6 to G-8 and G-16, wherein the fourth impurity region (84) has the same impurity concentration as the second impurity region (40).

### [Clause G-18]

The semiconductor device (1) according to Clause G-12, wherein the gate wiring (16) is formed of a metal containing aluminum.

### [Clause G-19]

The semiconductor device (1) according to any one of Clauses G-6 to G-8, G-16, and G-17, wherein the chip (2) has a second principal surface (4) opposite to the first principal surface (3),
the semiconductor device (1) further including:
a drain region (6) of the first conductivity type formed on the second principal surface (4) side with respect to the first impurity region (7);
a body region (40) formed by the second impurity region (40); and
a source region (55) formed by the third impurity region (55).

### [Clause G-20]

The semiconductor device (1) according to any one of Clauses G-6 to G-8, G-16, and G-17, wherein the chip (2) further has a second principal surface opposite to the first principal surface (3),
the semiconductor device (1) further including:
a collector region (400) of the second conductivity type formed on the second principal surface (4) side with respect to the first impurity region (7);
a base region (401) formed by the second impurity region (40); and
an emitter region (402) formed by the third impurity region (55).

### [Clause H-1]

A semiconductor device (1) including:
a chip (2) having a first principal surface (3) in which an element region (9) is formed;
a plurality of first trench structures (11) extending in a stripe shape in a first direction (X) in the element region (9) and formed of a first conductive material;
a first dummy trench structure (92) disposed outside the plurality of first trench structures (11) in the element region (9) and extending side by side in the first trench structures (11); and
a plurality of second dummy trench structures (93A) extending side by side with the first trench structures (11) in the middle of the first dummy trench structures (92), and electrically separated from the first dummy trench structures (92), and formed at intervals in a second direction (Y) intersecting the first direction (X),
wherein terminal portions (243, 244, 245, 246) of the plurality of second dummy trench structures (93A) are disposed shifted in regard to the first direction (X).

According to this configuration, in the middle of the first dummy trench structure (92), the second dummy trench structure (93A) extending side by side with the first trench structure (11) and electrically separated from the first dummy trench structure (92) is disposed.

If the first dummy trench structure (92) is divided in the middle of the first direction (X) and the second dummy trench structure (93A) is not formed, it is not possible to suppress the electric field concentration around the middle of the first dummy trench structure (92), and there is a possibility that a region where the withstand voltage is considerably lowered is formed.

In a case in which the withstand voltage of the second dummy trench structure (93A) is high, by forming the second dummy trench structure (93A) in the middle of the first dummy trench structure 92, it is possible to suppress the electric field concentration at the periphery in the middle of the first dummy trench structure (92), and it is possible to reduce formation of a region where the withstand voltage is considerably lowered at the periphery. Thereby, it is possible to reduce the region where the withstand voltage is considerably lowered outside the plurality of first trench structures (11) in the element region (9).

Also, the end portions (243, 244, 245, 246) of the plurality of second dummy trench structures (93A) are disposed shifted in regard to the first direction (X). Therefore, a region where the withstand voltage is considerably lowered is not formed around the end portions (243, 244, 245, 246) of the second dummy trench structures (93A). Thereby, it is possible to more effectively reduce the region where the withstand voltage is considerably lowered outside the plurality of first trench structures (11) in the element region (9).

### [Clause H-2]

The semiconductor device (1) according to Clause H-1, wherein a length of the second dummy trench structure (93A) is different from a length of the second dummy trench structure (93A) adjacent in the first direction (X).

### [Clause H-3]

The semiconductor device (1) according to Clause H-1 or H-2, wherein terminal portions (243, 244) of the second dummy trench structures (93A) are shifted from terminal portions (245, 246) of the second dummy trench structure (242) adjacent in the second direction (Y) in regard to the first direction (X), and
terminal portions (245, 246) of two of the second dummy trench structure (242) facing each other in the second direction (Y) with one of the second dummy trench structures (241) interposed therebetween are aligned with each other in regard to the first direction (X).

### [Clause H-4]

The semiconductor device (1) according to any one of Clauses H-1 to H-3, wherein an interval (I3) in the first direction (X) between the terminal portion (243, 244, 245, 246) of the second dummy trench structure (93A) and the first dummy trench structure (92) is narrower than an interval (PT3) in the second direction (Y) between the plurality of adjacent second dummy trench structures (93A).

### [Clause H-5]

The semiconductor device (1) according to any one of Clauses H-1 to H-4, wherein the first dummy trench structure (92) is a floating trench structure to which a potential is not applied.

### [Clause H-6]

The semiconductor device (1) according to any one of Clauses H-1 to H-5, including:
a first impurity region (7) of a first conductivity type formed in the chip (2);
a second impurity region (40) of a second conductivity type formed in a surface layer portion of the first impurity region (7) on the first principal surface (3) side;
a third impurity region (55) of the first conductivity type formed in a surface layer portion of the second impurity region (40) on the first principal surface (3) side; and
a fourth impurity region (59A) of the second conductivity type formed in a surface layer portion of the first principal surface (3) of the chip (2),
wherein the second dummy trench structure (93A) includes a dummy trench (110) formed in the fourth impurity region (59A), a dummy insulating film (111) formed on an inner surface of the dummy trench (110), and a dummy embedded body (112) embedded in the dummy trench (110) via the dummy insulating film, and
wherein the first trench structure (11) includes a trench gate structure (11) facing the second impurity region (40) and forming a channel in the second impurity region (40).

### [Clause H-7]

The semiconductor device (1) according to Clause H-6, further including an electric field relaxation layer (113) of the second conductivity type formed at a bottom portion of the dummy trench (110).

### [Clause H-8]

The semiconductor device (1) according to Clause H-6 or H-7, wherein the trench gate structure (11) includes a trench (41) that reaches the first impurity region (7) from the first principal surface (3) through the third impurity region (55) and the second impurity region (40), a trench insulating film (42) formed on an inner surface of the trench (41), and an embedded body (43) embedded in the trench (41) via the trench insulating film (42).

### [Clause H-9]

The semiconductor device (1) according to any one of Clauses H-1 to H-8, further including a connection wiring structure (35) extending such as to cross the plurality of the first trench structures (11) in a line shape in the second direction (Y) and connected to the first trench structures (11),
wherein the second dummy trench structure (93A) is connected to the connection wiring structure (35).

### [Clause H-10]

The semiconductor device (1) according to Clause H-9, wherein the connection wiring structure (35) extends such as to cross the second dummy trench structure (93A).

### [Clause H-11]

The semiconductor device (1) according to Clause H-9 or H-10, wherein the connection wiring structure (35) includes a connection wiring layer (130) formed on the first principal surface (3).

### [Clause H-12]

The semiconductor device (1) according to any one of Clauses H-9 to H-11, wherein the connection wiring structure (35) is connected to a gate wiring (16).

### [Clause H-13]

The semiconductor device (1) according to any one of Clauses H-9 to H-12, wherein the connection wiring structure (35) is formed of the first conductive material.

### [Clause H-14]

The semiconductor device (1) according to any one of Clauses H-1 to H-13, wherein the first conductive material is polysilicon.

### [Clause H-15]

The semiconductor device (1) according to any one of Clauses H-1 to H-14, wherein the chip (2) is an SiC chip.

### [Clause H-16]

The semiconductor device (1) according to any one of Clauses H-6 to H-8, wherein the fourth impurity region (59A) has the same depth as the second impurity region (40).

### [Clause H-17]

The semiconductor device (1) according to any one of Clauses H-6 to H-8 and H-16, wherein the fourth impurity region (59A) has the same impurity concentration as the second impurity region (40).

### [Clause H-18]

The semiconductor device (1) according to Clause H-12, wherein the gate wiring (16) is formed of a metal containing aluminum.

### [Clause H-19]

The semiconductor device (1) according to any one of Clauses H-6 to H-8, H-16, and H-17, wherein the chip (2) has a second principal surface (4) opposite to the first principal surface (3),
the semiconductor device (1) further including:
a drain region (6) of the first conductivity type formed on the second principal surface (4) side with respect to the first impurity region (7);
a body region (40) formed by the second impurity region (40); and
a source region (55) formed by the third impurity region (55).

### [Clause H-20]

The semiconductor device (1) according to any one of Clauses H-6 to H-8, H-16, and H-17, wherein the chip (2) further has a second principal surface (4) opposite to the first principal surface (3),
the semiconductor device (1) further including:
a collector region (400) of the second conductivity type formed on the second principal surface (4) side with respect to the first impurity region (7);
a base region (401) formed by the second impurity region (40); and
an emitter region (402) formed by the third impurity region (55).

### Reference Signs List

- 1: : semiconductor device
- 2: : chip
- 3: : first principal surface
- 4: : second principal surface
- 5A: : first side surface
- 5B: : second side surface
- 5C: : third side surface
- 5D: : fourth side surface
- 6: : base layer
- 7: : semiconductor layer (first impurity region)
- 8: : drift region
- 9: : active region (element region)
- 10: : outer peripheral region
- 11: : trench gate structure (first conductive structure, first trench structure, gate structure)
- 11A: : terminal portion (portion at first position)
- 11M: : intermediate portion (portion at second position)
- 13: : insulating layer
- 15: : gate pad (pad)
- 15A: : first peripheral edge
- 15B: : second peripheral edge
- 15C: : third peripheral edge
- 15D: : fourth peripheral edge
- 16: : gate wiring (second conductive structure)
- 16A: : connection wiring
- 17: : first gate wiring
- 17A: : first portion
- 17B: : second portion
- 17C: : first connecting portion
- 17D: : terminal portion
- 17E: : first terminal portion
- 17F: : band-shaped portion
- 17G: : band-shaped portion
- 18: : second gate wiring
- 18A: : first portion
- 18B: : second portion
- 18C: : connection portion
- 18D: : terminal portion
- 18E: : second terminal portion
- 18F: : band-shaped portion
- 18G: : band-shaped portion
- 19: : third gate wiring
- 20: : source pad
- 21: : first source pad
- 22: : second source pad
- 23: : source wiring
- 24: : drain pad
- 25: : upper insulating film
- 26: : gate pad opening
- 27: : first source pad opening
- 28: : second source pad opening
- 33: : polysilicon wiring layer
- 34: : peripheral wiring structure
- 34A: : first structure (second structure portion, portions facing each other)
- 34B: : second structure (first wiring portion)
- 34C: : third structure (second wiring portion, portions facing each other)
- 34D: : fourth structure (first wiring portion)
- 34E: : fifth structure (second structure portion)
- 34F: : sixth structure (portions facing each other)
- 35: : connection wiring structure
- 35A: : first connection wiring structure
- 35B: : second connection wiring structure
- 35C: : third connection wiring structure
- 35D: : fourth connection wiring structure
- 35E: : fifth connection wiring structure
- 35F: : sixth connection wiring structure
- 35G: : seventh connection wiring structure
- 35H: : eighth connection wiring structure
- 36: : field region
- 38: : resistive wiring structure
- 39: : wiring structure
- 40: : body region (second impurity region)
- 41: : trench (first trench)
- 42: : trench insulating film (base insulating film)
- 42a: : bottom portion insulating film
- 43: : embedded body
- 43a: : upper surface
- 43b: : lower surface
- 44: : side surface
- 45: : bottom surface
- 45A: : arcuate corner portion
- 46: : mesa portion (cell portion)
- 47: : upper surface
- 48: : recess
- 51: : first electric field relaxation layer
- 52: : side surface
- 53: : first layer
- 54: : second layer
- 54a: : upper layer
- 54b: : lower layer
- 55: : source region (third impurity region)
- 56: : channel section
- 57: : first contact region
- 57A: : facing contact region
- 58: : first body portion
- 59: : second body portion
- 59A: : facing body portion (fourth impurity region)
- 60: : first boundary surface
- 61: : second boundary surface
- 62: : second contact region
- 63: : first interlayer insulating layer
- 64: : upper edge
- 65: : upper surface
- 66: : barrier layer
- 67: : main body layer
- 80: : dummy formation region
- 81: : first dummy formation region
- 82: : second dummy formation region
- 83: : first high concentration p-region
- 84: : third body portion (fourth impurity region)
- 86: : fourth contact region
- 90: : dummy structure
- 91: : first dummy structure
- 92: : first dummy trench structure
- 93: : second dummy trench structure
- 93A: : second dummy trench structure
- 94: : first dummy band-shaped structure
- 95: : peripheral wiring layer
- 96: : first mesa portion
- 100: : first dummy trench
- 101: : first dummy insulating film
- 102: : first dummy embedded body
- 103: : second electric field relaxation layer
- 104: : third layer
- 105: : fourth layer
- 105a: : upper layer
- 105b: : upper layer
- 106: : first terminal portion
- 107: : second terminal portion
- 108: : third mesa portion
- 109: : second mesa portion
- 110: : second dummy trench (dummy trench)
- 111: : second dummy insulating film (dummy insulating film)
- 112: : second dummy embedded body (dummy embedded body)
- 113: : third electric field relaxation layer (electric field relaxation layer)
- 114: : fifth layer
- 115: : sixth layer
- 115a: : upper layer
- 115b: : upper layer
- 121: : first dummy recess
- 122: : first dummy interlayer insulating layer
- 123: : second dummy recess
- 124: : second dummy interlayer insulating layer
- 130: : connection wiring layer
- 131: : first insulating film
- 132: : contact hole
- 133: : lower surface
- 134: : upper surface
- 135: : first side surface (side surface)
- 136: : second side surface (side surface)
- 137: : first contact
- 138: : lower region
- 138b: : second peripheral edge
- 139: : first lateral side region
- 140: : second lateral side region
- 140a: : outer edge
- 141: : first silicide layer
- 142: : first covering layer
- 143: : second covering layer
- 144: : third covering layer
- 145: : second interlayer insulating layer
- 146: : covering portion
- 147: : first protruding portion
- 148: : second protruding portion
- 151: : connecting portion
- 152: : first connection lateral side region (side region)
- 153: : second connection lateral side region (side region)
- 154: : thick film portion
- 154A: : first film
- 154B: : second film
- 155: : thin film portion
- 156: : first base insulating film
- 157: : hard mask
- 158: : second base insulating film
- 170: : outer body region
- 175: : terminal region
- 175A: : arcuate corner portion
- 176: : overlap region
- 177: : second high concentration p-region
- 178: : third high concentration p-region
- 179: : second insulating film
- 180: : third interlayer insulating layer
- 181: : upper wiring layer
- 182: : lower wiring layer
- 184: : second silicide layer
- 185: : thick film
- 186: : thin film
- 187A: : upper surface
- 187B: : inner side surface
- 188: : gate opening
- 190: : outer opening
- 191: : first connection electrode portion
- 192: : second connection electrode portion
- 193: : contact portion
- 194: : connection wiring portion
- 195: : peripheral wiring layer
- 196: : barrier layer
- 197: : main body layer
- 201: : second dummy structure
- 202: : third dummy trench structure
- 206: : seventh terminal portion
- 207: : eighth terminal portion
- 208: : sixth mesa portion
- 209: : seventh mesa portion
- 210: : resistive wiring layer
- 211: : third silicide layer
- 212: : upper surface
- 213: : outer side surface
- 215: : first structure portion
- 215A: : outer edge
- 216: : connection structure portion
- 217: : first contact opening
- 218: : third connection electrode portion
- 219: : first contact portion
- 220: : second contact opening
- 221: : fourth connection electrode portion
- 222: : second contact portion
- 223: : lower surface
- 224: : lower surface
- 225: : lower surface
- 230: : wiring structure
- 241: : long trench structure
- 242: : short trench structure
- 243: : third terminal portion (terminal portion)
- 244: : fourth terminal portion (terminal portion)
- 245: : fifth terminal portion (terminal portion)
- 246: : sixth terminal portion (terminal portion)
- 248: : fourth mesa portion
- 249: : fifth mesa portion
- 300: : trench wiring structure
- 301: : trench
- 302: : insulating film
- 303: : conductor
- 304: : trench type peripheral wiring
- 400: : collector region
- 401: : base region
- 402: : emitter region
- 500: : planar gate structure
- 501: : insulating film
- 502: : gate electrode
- 503: : cell portion
- 504: : thick film portion
- 505: : thin film portion
- 506: : connecting portion
- BD1: : first body depth
- BD2: : second body depth
- BT1: : first body thickness
- BT2: : second body thickness
- C: : corner portion
- DR1: : first relaxation depth
- DR2: : second relaxation depth
- DR3: : third relaxation depth
- DT1: : trench depth
- DT2: : trench depth
- DT3: : trench depth
- E1: : connection region
- E2: : other region
- I1: : interval (interval in first direction from first dummy trench structure)
- I2: : interval
- I3: : interval
- I10: : interval
- I11: : interval
- I12: : interval
- I13: : interval
- I14: : interval
- I15: : interval
- I16: : interval
- I17: : interval
- I18: : interval
- IA: : first interval
- IB: : second interval
- IC: : third interval
- IF1: : first facing width
- IF2: : second facing width
- L1: : first trench length
- L2: : second trench length
- L3: : third trench length
- L11: : resistance length
- LB: : length
- LC: : length
- P1: : first outer edge position (first position)
- P2: : second outer edge position (first position)
- P3: : gate pad position (third position)
- PM: : intermediate position (second position)
- PT1: : trench pitch
- PT2: : trench pitch
- PT3: : trench pitch (interval)
- PT4: : trench pitch
- R1: : region
- RT1: : first path
- RT2: : second path
- S1: : first level difference
- S2: : second level difference
- S3: : third level difference
- ST1: : source thickness
- T1: : thickness
- T2: : thickness
- T3: : connection thickness (thickness)
- T4: : thickness
- T5: : thickness
- T6: : thickness
- T11: : thickness
- T12: : thickness
- T21: : thickness
- T22: : thickness
- TA: : peripheral thickness
- TC: : connection thickness
- TR: : resistance thickness
- Tr: : transistor structure
- W1: : first width
- WF1: : first facing distance
- WF2: : second facing distance
- WR1: : first relaxation width
- WR2: : second relaxation width
- WR3: : third relaxation width
- WT1: : trench width
- WT2: : trench width
- WT3: : trench width
- WT4: : trench width
- WW1: : first wiring width
- WW2: : second wiring width (first width)
- WW3: : third wiring width (second width)
- WW4: : fourth wiring width (first width)
- X: : first direction
- Y: : second direction
- Z: : vertical direction

## Claims

1. A semiconductor device comprising:
a chip of a quadrangular shape in plan view and having a first principal surface in which an element region is formed;
a plurality of first conductive structures extending in a stripe shape in a first direction in the element region and formed of a first conductive material;
an insulating layer formed on the first principal surface such as to cover the first conductive structures;
a pad formed on the insulating layer;
a second conductive structure formed on the insulating layer such as to be electrically connected to the pad, having a first portion extending in the first direction along the first conductive structure toward a first end surface of the chip and a second portion extending from the first portion along the first end surface in a second direction intersecting the first direction and having a terminal portion at a corner portion of the chip, and constituted of a metal wiring; and
a peripheral wiring structure formed on the first principal surface such as to be covered with the insulating layer, extending from the terminal portion of the second portion of the second conductive structure along a second end surface intersecting the first end surface, and electrically connected to the first conductive structure.

2. The semiconductor device according to claim 1, wherein the peripheral wiring structure is formed of the first conductive material.

3. The semiconductor device according to claim 2, wherein the first conductive material is polysilicon.

4. The semiconductor device according to any one of claims 1 to 3, wherein a terminal region having an arcuate corner portion of an arcuate shape in plan view at a corner portion of the chip and surrounding the element region is formed in the first principal surface of the chip, and
the terminal portion of the second portion retreats to a side opposite to the second end surface such as not to face the arcuate corner portion in the first direction in plan view at the corner portion of the chip.

5. The semiconductor device according to any one of claims 1 to 4, further comprising a plurality of connection wiring structures connected to the peripheral wiring structure and extending in a line shape such as to cross the plurality of the first conductive structures.

6. The semiconductor device according to claim 5, wherein the peripheral wiring structure is formed in an annular shape surrounding the element region, and
the connection wiring structure is connected across portions of the peripheral wiring structure facing each other.

7. The semiconductor device according to claim 5 or 6, wherein the peripheral wiring structure includes
a first wiring portion formed below the second portion of the second conductive structure and
a second wiring portion connected to the first wiring portion and extending along the second end surface from the terminal portion of the second portion of the second conductive structure, and
wherein the connection wiring structure electrically connects the first wiring portion and the second wiring portion.

8. The semiconductor device according to any one of claims 5 to 7, wherein the connection wiring structure is formed of the first conductive material.

9. The semiconductor device according to any one of claims 5 to 8, wherein the connection wiring structure includes a connection wiring layer formed on the first principal surface.

10. The semiconductor device according to any one of claims 1 to 4, wherein the peripheral wiring structure includes
a first wiring portion formed below the second portion of the second conductive structure and
a second wiring portion connected to the first wiring portion and extending along the second end surface from the terminal portion of the second portion of the second conductive structure.

11. The semiconductor device according to claim 7 or 10, wherein the first wiring portion has a first width, and
the second wiring portion has a second width narrower than the first width.

12. The semiconductor device according to claim 11, wherein the second width is narrower than a width of the second portion of the second conductive structure.

13. The semiconductor device according to any one of claims 1 to 12, further comprising:
a first impurity region of a first conductivity type formed in the chip;
a second impurity region of a second conductivity type formed in a surface layer portion of the first impurity region on the first principal surface side; and
a third impurity region of the first conductivity type formed in a surface layer portion of the second impurity region on the first principal surface side,
wherein the first conductive structure includes a gate structure that faces the second impurity region and forms a channel in the second impurity region.

14. The semiconductor device according to claim 13, wherein the gate structure is a trench gate structure, and the second conductive structure is a gate wiring.

15. The semiconductor device according to any one of claims 1 to 14, wherein the chip is an SiC chip.
